(19) Europäisches Patentamt
European Patent Office
Office européen des brevets

(11) EP 4 269 122 B1

(12) **EUROPEAN PATENT SPECIFICATION**

(45) Date of publication and mention of the grant of the patent:
**04.03.2026 Bulletin 2026/10**

(21) Application number: **21911019.4**

(22) Date of filing: **23.12.2021**

(51) International Patent Classification (IPC):
***B41C 1/10*** *(2006.01)* ***B41N 1/08*** *(2006.01)*

(52) Cooperative Patent Classification (CPC):
**B41C 1/1016; B41N 1/083;** B41C 2210/04

(86) International application number:
**PCT/JP2021/048061**

(87) International publication number:
**WO 2022/138880 (30.06.2022 Gazette 2022/26)**

# (54) LAMINATE OF NEGATIVE TONE LITHOGRAPHIC PRINTING PLATE PRECURSORS AND METHOD OF PREPARING NEGATIVE TONE LITHOGRAPHIC PRINTING PLATE

LAMINAT NEGATIV ARBEITENDER FLACHDRUCKPLATTENVORLÄUFER UND VERFAHREN ZUR HERSTELLUNG EINER NEGATIV FLACHDRUCKPLATTE

STRATIFIÉ DE PRÉCURSEURS DE PLAQUE D’IMPRESSION LITHOGRAPHIQUE NÉGATIVE ET PROCÉDÉ DE FABRICATION DE PLAQUE D’IMPRESSION LITHOGRAPHIQUE NÉGATIVE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.12.2020 JP 2020218007**

(43) Date of publication of application:
**01.11.2023 Bulletin 2023/44**

(73) Proprietor: **FUJIFILM Corporation**
**Tokyo 106-8620 (JP)**

(72) Inventor: **WATANABE, Shumpei**
**Haibara-gun, Shizuoka 421-0396 (JP)**

(74) Representative: **HGF**
**HGF Limited**
**4th Floor, 1 City Square**
**Leeds LS1 2ES (GB)**

(56) References cited:
**EP-A1- 3 511 172**
**EP-A1- 3 513 983**
**EP-A1- 3 991 983**
**WO-A1-2018/181406**
**WO-A1-2018/181993**
**WO-A1-2019/013268**
**WO-A1-2019/188910**
**US-A1- 2002 098 447**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 269 122 B1

## Description

### BACKGROUND OF THE INVENTION

1. Field of the Invention

The present invention relates to a laminate of negative tone lithographic printing plate precursors and a method of preparing a negative tone lithographic printing plate.

2. Description of the Related Art

Generally, a lithographic printing plate consists of a lipophilic image area that receives ink in a printing process and a hydrophilic non-image area that receives dampening water. Lithographic printing is a method exploiting the mutual repulsion of water and oil-based ink, in which the lipophilic image area and the hydrophilic non-image area of a lithographic printing plate are used as an ink-receiving portion and a dampening water-receiving portion (non-ink-receiving portion) respectively, the adhesiveness of ink is varied within the surface of the lithographic printing plate such that only the image area receives the ink, and then printing is performed by the transfer of the ink to a printing substrate such as paper.

Today, in a plate making step of preparing a lithographic printing plate from a lithographic printing plate precursor, image exposure is performed by a computer-to-plate (CTP) technique. That is, the image exposure is carried out by performing scanning exposure or the like directly on a lithographic printing plate precursor by using a laser or a laser diode without the intervention of a lith film.

Incidentally, due to the increasing concern for the global environment, in regard to making a lithographic printing plate precursor, attention is paid to the environmental issues relating to the waste liquid involved in a wet treatment such as a development treatment. As a result, there is a trend towards simplification or elimination of the development treatment. As one of the simple development treatments, a method called "on-press development" has been proposed. The on-press development is a method of performing image exposure on a lithographic printing plate precursor, then directly mounting the lithographic printing plate precursor on a printer without performing the wet development treatment of the related art, and removing a non-image area of an image-recording layer at the initial state of the general printing step.

WO2019/013268A discloses a lithographic printing plate precursor having an image-recording layer on a hydrophilic support, in which the image-recording layer contains a polymerization initiator, an infrared absorber, a polymerizable compound, and an acid color developing agent, and the infrared absorber contains a specific compound. WO 2018/181406 discloses a lithographic printing plate precursor including: a hydrophilized aluminium support, and a water-soluble or water-dispersible negative type image recording layer provided on the aluminium support, in which an arithmetic average height Sa of a surface of an outermost layer on a side opposite to a side where the image recording layer is provided is in a range of 0.3 μm to 20 μm/
WO 2018/181993 discloses a lithographic printing plate precursor including a hydrophilized aluminium support, and a water-soluble or water-dispersible negative type image recording layer provided on the aluminium support, in which an arithmetic average height Sa of a surface of an outermost layer on a side where the image recording layer is provided is in a range of 0.3 μm to 20 μm or in which Expression (1) and Expression (2) are satisfied in a case where a Bekk smoothness of a surface of an outermost layer on a side where the image recording layer is provided is set as a seconds and a Bekk smoothness of a surface of an outermost layer on a side opposite to a side where the image recording layer is provided is set as b seconds.

### SUMMARY OF THE INVENTION

By the way, in recent years, lithographic printing plate precursors have been stored for a long time, and a printing plate obtained from the lithographic printing plate precursor has been required to exhibit further improved printing durability (also called "printing durability of the lithographic printing plate precursor after the passage of time" in the present specification).

Usually, the lithographic printing plate precursor is stored and transported as a laminate composed of a plurality of sheets of stacked lithographic printing plate precursors. In a case where such a laminate is accommodated in a plate feeding tray of a setter and one lithographic printing plate precursor is taken out from the laminate and is fed during exposure or the like, it is required that the lithographic printing plate precursor be more smoothly taken out from the laminate.

The present invention has been made in consideration of the above circumstances, and an object thereof is to achieve the following objects. That is, objects of the present invention are to provide a laminate that allows a negative tone lithographic printing plate precursor to exhibit excellent printing durability after the passage of time and allows the precursor to be excellently fed in a setter, and to provide a method of preparing a negative tone lithographic printing plate.

The means for achieving the above objects will be described below.

The invention is as defined in the appended claim set.

According to an embodiment of the present invention, it is possible to provide a laminate that allows a negative tone lithographic printing plate precursor to exhibit excellent printing durability after the passage of time and allows the precursor to be excellently fed in a setter, and to provide a method of preparing a negative tone lithographic printing plate.

## BRIEF DESCRIPTION OF THE DRAWINGS

Fig. 1 is an example of a waveform graph of alternating current used for an electrochemical roughening treatment.
Fig. 2 is a lateral view showing an example of a radial cell in an electrochemical roughening treatment using alternating current.
Fig. 3 is a schematic view showing a cross-sectional shape of an end part of a lithographic printing plate precursor.
Fig. 4 is a conceptual view showing an example of a cutting portion of a slitter device.
Fig. 5 is a lateral view conceptually showing a brush graining step used in a mechanical roughening treatment in preparing an aluminum support.
Fig. 6 is a schematic view of an anodization treatment device used for an anodization treatment.
Fig. 7 is a view illustrating a method of coating with an ink repellent.

## DESCRIPTION OF THE PREFERRED EMBODIMENTS

The following configuration requirements will be described on the basis of typical embodiments of the present invention, but the present invention is not limited to such embodiments.

In the present specification, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).

In the present specification, "(meth)acryl" is a term used to explain a concept including both the acryl and methacryl, and "(meth)acryloyl" is a term used to explain a concept including both the acryloyl and methacryloyl.

The term "step" in the present specification means not only an independent step but also a step that cannot be clearly differentiated from other steps as long as the intended goal of the step is achieved.

In the present invention, a combination of two or more preferred aspects is a more preferred aspect.

In addition, in the present specification, unless otherwise specified, each of the mass-average molecular weight (Mw) and number average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

Hereinafter, the present invention will be specifically described.

[Laminate of negative tone lithographic printing plate precursors]

The laminate according to an embodiment of the present invention is a laminate of negative tone lithographic printing plate precursors (hereinafter, also called "lithographic printing plate precursors" in some cases) each having at least one layer containing an infrared absorber with a HOMO of -5.47 eV or less on a hydrophilic support, in which in each of the negative tone lithographic printing plate precursors, at least one of an outermost layer surface on a side of the at least one layer containing an infrared absorber with reference to the support or an outermost layer surface on a side opposite to the side of the at least one layer containing an infrared absorber has an arithmetic mean height Sa of 0.3 μm or more and 20 μm or less.

As a result of conducting intensive studies, the inventors of the present invention have found that adopting the above configuration makes it possible to provide a laminate that allows lithographic printing plate precursors to exhibit excellent printing durability after the passage of time and to be excellently fed in a setter.

The detailed mechanism that brings about the aforementioned effect is unclear, but is assumed to be as below.

Regarding the printing durability of a lithographic printing plate precursor after the passage of time, the inventors of the present invention focused on an infrared absorber contained in a layer on a support in the lithographic printing plate precursor. As a result of further conducting studies, the inventors have found that the long-term storage (prolonged storage) in the air induces the decomposition of the infrared absorber, which deteriorates the printing durability of the lithographic printing plate precursor after the passage of time.

Therefore, focusing on the highest occupied molecular orbital (HOMO) of the infrared absorber, the inventors of the present invention selected an infrared absorber having a HOMO energy level of -5.47 eV or less and have found that the

printing durability of the lithographic printing plate precursor after the passage of time is surprisingly improved. Presumably, this is because the infrared absorber contained in the layer on the support is inhibited from decomposing during the prolonged storage, which allows an image area of a printing plate obtained through an exposure step and a development step to be formed in a state close to the state before the prolonged storage.

In a case where the laminate of lithographic printing plate precursors is installed in a plate feeding tray of a setter, and then a lithographic printing plate precursor is taken out, it is required that a lithographic printing plate precursor be smoothly peeled from an adjacent lithographic printing plate precursor. As a result of conducting intensive studies on the shape of the outermost layer surface of each lithographic printing plate precursor constituting the laminate, the inventors of the present invention focused on the shape of at least one of an outermost surface layer of the lithographic printing plate precursor on the side of the at least one layer containing an infrared absorber with reference to the support or an outermost surface layer of the lithographic printing plate precursor on the side opposite to the side of the at least one layer containing an infrared absorber. The inventors have found that making an arithmetic mean height Sa of either of the outermost surface layers 0.3 μm or more enables one lithographic printing plate precursor to be extremely smoothly taken out from the laminate. Presumably, this is because vacuum adhesion is suppressed due to an appropriate gap formed between the lithographic printing plate precursors.

Typically, the laminate is formed of a number of lithographic printing plate precursors (generally, 100 or more precursors) stacked together. Therefore, in a case where either of the outermost surface layers has an arithmetic mean height Sa more than 20 μm, and such lithographic printing plate precursors are formed into a laminate, the plurality of lithographic printing plate precursors configuring the laminate tends not to be easily fixed. Furthermore, there is a concern that the damages such as scratches may occur on a member coming into contact with the outermost layer surface in an exposure step, a development step, and a printing step. Therefore, in the specification of the present application, the upper limit of the arithmetic mean height Sa of the outermost layer surface is set to 20 μm.

It is assumed that for the above reason, the lithographic printing plate precursor may be fed better in a setter in a case where the lithographic printing plate precursor is taken out from the laminate.

The laminate of lithographic printing plate precursors according to an embodiment of the present invention is preferably a laminate composed of a plurality of lithographic printing plate precursors (generally, 2 to 500 precursors) directly stacked together without the intervention of interleaving paper.

[Lithographic printing plate precursor]

The lithographic printing plate precursor configuring the laminate according to an embodiment of the present invention is a lithographic printing plate precursor having at least one layer containing an infrared absorber with a HOMO of -5.47 eV or less on a hydrophilic support, in which at least one of an outermost layer surface of the lithographic printing plate precursor on a side of the at least one layer containing an infrared absorber with reference to the support or on outermost layer surface of the lithographic printing plate precursor on a side opposite to the side of the at least one layer containing an infrared absorber has an arithmetic mean height Sa of 0.3 μm or more and 20 μm or less.

Hereinafter, the lithographic printing plate precursor will be specifically described.

The hydrophilic support in the lithographic printing plate precursor (hereinafter, also simply called "support") configuring the laminate according to an embodiment of the present invention to be used can be appropriately selected from known hydrophilic supports for lithographic printing plate precursors. As the hydrophilic support, an aluminum support that has been roughened by a known method and has undergone an anodization treatment (specifically, an aluminum support having an anodic oxide film) is preferable.

[Aluminum support having anodic oxide film]

As one of the preferred aspects of the support configuring the lithographic printing plate precursor, an aluminum support having an anodic oxide film will be described.

The aluminum plate used in the aluminum support consists of a dimensionally stable metal containing aluminum as a main component, that is, aluminum or an aluminum alloy. It is preferable that the aluminum plate be selected from a pure aluminum plate and an alloy plate that contains aluminum as a main component and traces of foreign elements.

The foreign elements contained in the aluminum alloy include silicon, iron, manganese, copper, magnesium, chromium, zinc, bismuth, nickel, titanium, and the like. The content of the foreign elements in the alloy is 10% by mass or less. As the aluminum plate, a pure aluminum plate is suitable. However, the aluminum plate may be an alloy plate that contains traces of foreign elements, because it is difficult to manufacture perfectly pure aluminum by smelting technologies. The composition of the aluminum plate used for the aluminum support is not specified, and it is possible to appropriately use aluminum plates known in the related art, for example, JIS A 1050, JIS A 1100, JIS A 3103, and JIS A 3005, and the like.

The thickness of the aluminum plate is preferably about 0.1 to 0.6 mm.

(Anodic oxide film)

The anodic oxide film means an anodized aluminum film with supermicropores (also called micropores) formed on the surface of an aluminum plate by an anodization treatment. The micropores extend from the surface of the anodic oxide film on the side opposite to the aluminum plate along the thickness direction (aluminum plate side, depth direction).
From the viewpoint of tone reproducibility, printing durability, and brush contaminating properties, the average diameter (average opening diameter) of the micropores within the surface of the anodic oxide film is preferably 7 nm to 150 nm, more preferably 10 nm to 100 nm, even more preferably 10 nm to 60 nm, particularly preferably 15 nm to 60 nm, and most preferably 18 nm to 40 nm.
The depth of the micropores is preferably 10 nm to 3,000 nm, more preferably 10 nm to 2,000 nm, and even more preferably 10 nm to 1,000 nm.
Usually, the micropores have a substantially straight tubular shape (substantially cylindrical shape) in which the diameter of the micropores substantially does not change in the depth direction (thickness direction). The micropores may also have a conical shape that continues to taper in the depth direction (thickness direction). The micropores may have a shape that discontinuously tapers along the depth direction (thickness direction).
Examples of the micropores having a shape that discontinuously tapers in the depth direction (thickness direction) include micropores each configured with a large diameter portion that extends along the depth direction from the surface of the anodic oxide film and a small diameter portion that is in communication with the bottom portion of the large diameter portion and extends along the depth direction from the communicate position.
Specifically, the micropores are preferable which are each configured with a large diameter portion that extends 10 nm to 1,000 nm in the depth direction from the surface of the anodic oxide film and a small diameter portion that is in communication with the bottom portion of the large diameter portion and extends 20 nm to 2,000 nm in the depth direction from the communicate position.
Hereinafter, the large diameter portion and the small diameter portion will be specifically described.

-Large diameter portion-

From the viewpoint of tone reproducibility, printing durability, and brush contaminating properties, the average diameter (average opening diameter) of the large diameter portion within the surface of the anodic oxide film is preferably 7 nm to 150 nm, more preferably 10 nm to 100 nm, even more preferably 15 nm to 100 nm, particularly preferably 15 nm to 60 nm, and most preferably 18 nm to 40 nm.
The average diameter of the large diameter portion is calculated by a method of observing the surface of the anodic oxide film with a field emission scanning electron microscope (FE-SEM) at 150,000X magnification (N = 4), measuring the sizes (diameters) of micropores (large diameter portions) existing in a range of 400 nm $\times$ 600 nm in the obtained 4 images, and calculating the arithmetic mean of the diameters.
In a case where the shape of the large diameter portion is not circular, the equivalent circle diameter is used. "Equivalent circle diameter" is a diameter determined on an assumption that the opening portion is in the form of a circle having the same projected area as the projected area of the opening portion.
The bottom portion of the large diameter portion is preferably in a position at a depth of 70 nm to 1,000 nm (hereinafter, also called depth A) from the surface of the anodic oxide film. That is, the large diameter portion is preferably a pore portion extending to a position at a depth of 70 nm to 1,000 nm from the surface of the anodic oxide film in the depth direction (thickness direction). Particularly, from the viewpoint of further improving the effect of the manufacturing method of a lithographic printing plate precursor, the depth A is more preferably 90 nm to 850 nm, even more preferably 90 nm to 800 nm, and particularly preferably 90 nm to 600 nm.
The depth is a value obtained by taking an image (150,000X magnification) of a cross section of the anodic oxide film, measuring the depths of 25 or more large diameter portions, and calculating the arithmetic mean thereof.
The shape of the large diameter portion is not particularly limited. Examples of the shape of the large diameter portion include a substantially straight tubular shape (substantially cylindrical shape) and a conical shape that tapers along the depth direction (thickness direction). Among these, a substantially straight tubular shape is preferable. The shape of the bottom portion of the large diameter portion is not particularly limited, and may be a curved (convex) or planar shape.
The inner diameter of the large diameter portion is not particularly limited, but is preferably as large as the diameter of the opening portion or smaller than the diameter of the opening portion. Generally, there may be a difference of about 1 nm to 10 nm between the inner diameter of the large diameter portion and the diameter of the opening portion.

-Small diameter portion-

The small diameter portion is a pore portion that is in communication with the bottom portion of the large diameter portion and further extends from the communicate position in the depth direction (thickness direction). Generally, one

small diameter portion is in communication with one large diameter portion. However, two or more small diameter portions may be in communication with the bottom portion of one large diameter portion.

The average diameter of the small diameter portion at the communicate position is more preferably 13 nm or less, even more preferably 11 nm or less, and particularly preferably 10 nm or less. The lower limit thereof is not particularly limited, but is preferably 5 nm.

The average diameter of the small diameter portion is obtained by observing the surface of the anodic oxide film with FE-SEM at 150,000X magnification (N = 4), measuring the sizes (diameters) of the micropores (small diameter portion) existing in a range of 400 nm × 600 nm in the obtained 4 images, and calculating the arithmetic mean of the sizes. In a case where the large diameter portion is deep, as necessary, the upper portion of the anodic oxide film (region where the large diameter portion is located) may be cut (for example, by using argon gas), then the surface of the anodic oxide film may be observed with FE-SEM described above, and the average diameter of the small diameter portion may be determined.

In a case where the shape of the small diameter portion is not circular, the equivalent circle diameter is used. "Equivalent circle diameter" is a diameter determined on an assumption that the opening portion is in the form of a circle having the same projected area as the projected area of the opening portion.

The bottom portion of the small diameter portion is preferably in a position 20 nm to 2,000 nm distant from the communicate position (corresponding to the aforementioned depth A) with the large diameter portion in the depth direction. In other words, the small diameter portion is a pore portion that extends further from the communicate position with the large diameter portion in the depth direction (thickness direction), and the depth of the small diameter portion is preferably 20 nm to 2,000 nm, more preferably 100 nm to 1,500 nm, and particularly preferably 200 nm to 1,000 nm.

The depth is a value obtained by taking an image (150,000X magnification) of a cross section of the anodic oxide film, measuring the depths of 25 or more small diameter portions, and calculating the arithmetic mean thereof.

The shape of the small diameter portion is not particularly limited. Examples of the shape of the small diameter portion include a substantially straight tubular shape (substantially cylindrical shape) and a conical shape that tapers along the depth direction. Among these, a substantially straight tubular shape is preferable. The shape of the bottom portion of the small diameter portion is not particularly limited, and may be a curved (convex) or planar shape.

The inner diameter of the small diameter portion is not particularly limited, and may be the same as the diameter at the communicate position, or may be smaller or larger than the diameter at the communicate position. Generally, there may be a difference of about 1 nm to 10 nm between the inner diameter of the small diameter portion and the diameter of the opening portion.

The ratio of the average diameter of the large diameter portion within the surface of the anodic oxide film to the average diameter of the small diameter portion at the communicate position, (average diameter of large diameter portion within surface of anodic oxide film)/(average diameter of small diameter portion at communicate position) is preferably 1.1 to 13, and more preferably 2.5 to 6.5.

The ratio of the depth of the large diameter portion to the depth of the small diameter portion, (depth of large diameter portion)/(depth of small diameter portion) is preferably 0.005 to 50, and more preferably 0.025 to 40.

The micropores have a substantially straight tubular shape (substantially cylindrical shape) in which the diameter of the micropores substantially does not change in the depth direction (thickness direction). The micropores may also have a conical shape that continues to widen in the depth direction (thickness direction). The micropores may have a shape that discontinuously widens along the depth direction (thickness direction).

Examples of the micropores having a shape that discontinuously widens in the depth direction (thickness direction) include micropores each configured with a small diameter portion that extends along the depth direction from the surface of the anodic oxide film and a large diameter portion that is in communication with the bottom portion of the small diameter portion and extends along the depth direction from the communicate position.

Specifically, the micropores are preferable which are each configured with a small diameter portion that extends 10 nm to 1,000 nm in the depth direction from the surface of the anodic oxide film and a large diameter portion that is in communication with the bottom portion of the small diameter portion and further extends 20 nm to 2,000 nm in the depth direction from the communicate position.

-Small diameter portion-

The average diameter (average opening diameter) of the small diameter portion within the surface of the anodic oxide film is not particularly limited, but is preferably 35 nm or less, more preferably 25 nm or less, and particularly preferably 20 nm or less. The lower limit thereof is not particularly limited, but is preferably 15 nm.

The average diameter of the small diameter portion is calculated by a method of observing the surface of the anodic oxide film with a field emission scanning electron microscope (FE-SEM) at 150,000X magnification (N = 4), measuring the sizes (diameters) of micropores (large diameter portions) existing in a range of 400 nm × 600 nm in the obtained 4 images, and calculating the arithmetic mean of the sizes.

In a case where the shape of the small diameter portion is not circular, the equivalent circle diameter is used. "Equivalent circle diameter" is a diameter determined on an assumption that the opening portion is in the form of a circle having the same projected area as the projected area of the opening portion.
The bottom portion of the small diameter portion is preferably in a position at a depth of 70 nm to 1,000 nm (hereinafter, also called depth A') from the surface of the anodic oxide film. That is, the small diameter portion is preferably a pore portion extending to a position at a depth of 70 nm to 1,000 nm from the surface of the anodic oxide film in the depth direction (thickness direction).
The depth is a value obtained by taking an image (150,000X magnification) of a cross section of the anodic oxide film, measuring the depths of 25 or more large diameter portions, and calculating the arithmetic mean thereof.
The shape of the small diameter portion is not particularly limited. Examples of the shape of the large diameter portion include a substantially straight tubular shape (substantially cylindrical shape) and a conical shape that widens along the depth direction (thickness direction). Among these, a substantially straight tubular shape is preferable. The shape of the bottom portion of the small diameter portion is not particularly limited, and may be a curved (convex) or planar shape.
The inner diameter of the small diameter portion is not particularly limited, but is preferably as large as the diameter of the opening portion or smaller than the diameter of the opening portion. Generally, there may be a difference of about 1 nm to 10 nm between the inner diameter of the small diameter portion and the diameter of the opening portion.

-Large diameter portion-

The large diameter portion is a pore portion that is in communication with the bottom portion of the small diameter portion and further extends from the communicate position in the depth direction (thickness direction). Generally, the bottom portion of one large diameter portion may be in communication with two or more small diameter portions.
The average diameter of the large diameter portion at the communicate position is preferably 20 nm to 400 nm, more preferably 40 nm to 300 nm, even more preferably 50 nm to 200 nm, and particularly preferably 50 nm to 100 nm.
The average diameter of the large diameter portion is obtained by observing the surface of the anodic oxide film with FE-SEM at 150,000X magnification (N = 4), measuring the sizes (diameters) of the micropores (large diameter portion) existing in a range of 400 nm × 600 nm in the obtained 4 images, and calculating the arithmetic mean of the sizes. In a case where the small diameter portion is deep, as necessary, the upper portion of the anodic oxide film (region where the small diameter portion is located) may be cut (for example, by using argon gas), then the surface of the anodic oxide film may be observed with FE-SEM described above, and the average diameter of the large diameter portion may be determined.
In a case where the shape of the large diameter portion is not circular, the equivalent circle diameter is used. "Equivalent circle diameter" is a diameter determined on an assumption that the opening portion is in the form of a circle having the same projected area as the projected area of the opening portion.
The bottom portion of the large diameter portion is preferably in a position 20 nm to 2,000 nm distant from the communicate position (corresponding to the aforementioned depth A') with the small diameter portion in the depth direction. In other words, the large diameter portion is a pore portion that extends further from the communicate position with the small diameter portion in the depth direction (thickness direction), and the depth of the large diameter portion is preferably 20 nm to 2,000 nm, more preferably 100 nm to 1,500 nm, and particularly preferably 200 nm to 1,000 nm.
The depth is a value obtained by taking an image (150,000X magnification) of a cross section of the anodic oxide film, measuring the depths of 25 or more large diameter portions, and calculating the arithmetic mean thereof.
The shape of the large diameter portion is not particularly limited. Examples of the shape of the large diameter portion include a substantially straight tubular shape (substantially cylindrical shape) and a conical shape that tapers along the depth direction. Among these, a substantially straight tubular shape is preferable. The shape of the bottom portion of the large diameter portion is not particularly limited, and may be a curved (convex) or planar shape.
The inner diameter of the large diameter portion is not particularly limited, and may be the same as the diameter at the communicate position, or may be smaller or larger than the diameter at the communicate position. Generally, there may be a difference of about 1 nm to 10 nm between the inner diameter of the large diameter portion and the diameter of the opening portion.
In an on-press development type lithographic printing plate precursor, from the viewpoint of improving image visibility, an aluminum support is useful in which the surface of an anodic oxide film (surface on a side where the at least one layer containing an infrared absorber is to be formed) has high brightness.
Usually, in a printing step using a lithographic printing plate, before the printing plate is mounted on a printer, the plate is inspected to check whether an image is printed as intended. For the on-press development type lithographic printing plate precursor, it is required to check the image at the stage where the image is exposed. Therefore, a unit generating a so-called printed image in an image exposure portion is used.
As a method of quantitatively evaluating the visibility of an image area (image visibility) of the on-press

development type lithographic printing plate precursor having undergone exposure of an image, for example, there is a method of measuring the brightness of an image exposure portion and the brightness of a non-exposed portion and calculating the difference therebetween. As the lightness, a value of brightness L* in the CIEL*a*b* color system can be used. The brightness can be measured using a color difference meter (Spectro Eye, manufactured by X-Rite, Incorporated.). The larger the difference between the measured brightness of the image exposure portion and the measured brightness of the non-exposed portion, the higher the visibility of the image area.

It has been revealed that the larger the value of brightness L* of the surface of the anodic oxide film in the CIEL*a*b* color system, the more effective it is to increase the difference between the brightness of the image exposure portion and the brightness of the non-exposed portion. That is, the value of the brightness L* is preferably 60 to 100, and more preferably 70 to 100.

As necessary, the aluminum support having an anodic oxide film may have a backcoat layer containing the organic polymer compound described in JP1993-45885A (JP-H5-45885A), the alkoxy compound of silicon described in JP1994-35174A (JP-H6-35174A), or the like, on a surface opposite to the side where the at least one layer containing an infrared absorber is formed.

(Manufacturing of aluminum support having anodic oxide film)

The aluminum support having an anodic oxide film can be manufactured using known methods. The manufacturing method of the aluminum support having an anodic oxide film is not particularly limited. Examples of preferred aspects of the manufacturing method of the aluminum support having an anodic oxide film include a method including a step of performing a roughening treatment on an aluminum plate (roughening treatment step), a step of anodizing the aluminum plate having undergone the roughening treatment (anodization treatment step), and a step of bringing the aluminum plate having an anodic oxide film obtained by the anodization treatment step into contact with an aqueous acid solution or an aqueous alkali solution such that the diameter of micropores in the anodic oxide film increases (pore widening treatment step).

Hereinafter, each step will be described in detail.

<Roughening treatment step>

The roughening treatment step is a step of performing a roughening treatment including an electrochemical roughening treatment on the surface of the aluminum plate. The roughening treatment step is preferably performed before the anodization treatment step which will be described later. However, in a case where the surface of the aluminum plate already has a preferable shape, the roughening treatment step may not be performed.

As the roughening treatment, only an electrochemical roughening treatment may be performed, or an electrochemical roughening treatment may be performed in combination with at least either a mechanical roughening treatment or a chemical roughening treatment.

In a case where the mechanical roughening treatment and the electrochemical roughening treatment are combined, it is preferable to perform the electrochemical roughening treatment after the mechanical roughening treatment.

The electrochemical roughening treatment is preferably performed in an aqueous solution of nitric acid or hydrochloric acid.

Generally, the mechanical roughening treatment is performed such that the aluminum plate has a surface roughness Ra: 0.35 to 1.0 μm.

The conditions of the mechanical roughening treatment are not particularly limited. For example, the mechanical roughening treatment can be performed according to the method described in JP1975-40047B (JP-S50-40047B). The mechanical roughening treatment can be performed by a brush graining treatment using a pumice stone suspension or by a transfer method.

The chemical roughening treatment is also not particularly limited, and can be performed according to known methods.

After the mechanical roughening treatment, it is preferable to perform the following chemical etching treatment.

By the chemical etching treatment performed after the mechanical roughening treatment, the edge portion of surface irregularities of the aluminum plate smoothed, such that ink clotting that may occur during printing is prevented, the antifouling properties of the lithographic printing plate are improved, and unnecessary substances such as abrasive particles remaining on the surface are removed.

As the chemical etching treatment, etching with an acid and etching with an alkali are known. One of the examples of particularly efficient etching methods is a chemical etching treatment using an alkaline solution (hereinafter, also called "alkaline etching treatment").

The alkaline agent used in the alkaline solution is not particularly limited. Suitable examples thereof include

caustic soda, caustic potash, sodium metasilicate, sodium carbonate, sodium aluminate, sodium gluconate, and the like.

The alkaline solution may contain aluminum ions. The concentration of the alkaline agent in the alkaline solution is preferably 0.01% by mass or more, and more preferably 3% by mass or more. Furthermore, the concentration is preferably 30% by mass or less, and more preferably 25% by mass or less.

The temperature of the alkaline solution is preferably equal to or higher than room temperature, and more preferably 30°C or higher. Furthermore, the temperature is preferably 80°C or lower, and more preferably 75°C or lower.

The etching amount is preferably 0.01 $g/m^2$ or more, and more preferably 0.05 $g/m^2$ or more. Furthermore, the etching amount is preferably 30 $g/m^2$ or less, and more preferably 20 $g/m^2$ or less.

The treatment time preferably is in a range of 2 seconds to 5 minutes depending on the etching amount. In view of improving productivity, the treatment time is more preferably 2 to 10 seconds.

In a case where the alkaline etching treatment is performed after the mechanical roughening treatment, in order to remove products generated by the alkaline etching treatment, it is preferable to perform the chemical etching treatment by using a low-temperature acidic solution (hereinafter, also called "desmutting treatment").

The acid used in the acidic solution is not particularly limited, and examples thereof include sulfuric acid, nitric acid, and hydrochloric acid. The concentration of the acidic solution is preferably 1% to 50% by mass. The temperature of the acidic solution is preferably 20°C to 80°C. In a case where the concentration and temperature of the acidic solution are in this range, the lithographic printing plate using an aluminum support becomes more resistant to speck-like stain.

Examples of preferred aspects of the roughening treatment step are as below.

-Aspect SA-

An aspect in which the following treatments (1) to (8) are performed in this order.

(1) Chemical etching treatment using aqueous alkali solution (first alkaline etching treatment)
(2) Chemical etching treatment using aqueous acidic solution (first desmutting treatment)
(3) Electrochemical roughening treatment using aqueous solution containing nitric acid as main component (first electrochemical roughening treatment)
(4) Chemical etching treatment using aqueous alkali solution (second alkaline etching treatment)
(5) Chemical etching treatment using aqueous acidic solution (second desmutting treatment)
(6) Electrochemical roughening treatment using aqueous solution containing hydrochloric acid as main component (second electrochemical roughening treatment)
(7) Chemical etching treatment using aqueous alkali solution (third alkaline etching treatment)
(8) Chemical etching treatment using aqueous acidic solution (third desmutting treatment)

-Aspect SB-

An aspect in which the following treatments (11) to (15) are performed in this order.

(11) Chemical etching treatment using aqueous alkali solution (fourth alkaline etching treatment)
(12) Chemical etching treatment using aqueous acidic solution (fourth desmutting treatment)
(13) Electrochemical roughening treatment using aqueous solution containing hydrochloric acid as main component (third electrochemical roughening treatment)
(14) Chemical etching treatment using aqueous alkali solution (fifth alkaline etching treatment)
(15) Chemical etching treatment using aqueous acidic solution (fifth desmutting treatment)

As necessary, a mechanical roughening treatment may be performed before the treatment (1) of the aspect SA or before the treatment (11) of the aspect SB.

The amount of the aluminum plate dissolved by the first alkaline etching treatment and the fourth alkaline etching treatment is preferably 0.5 $g/m^2$ to 30 $g/m^2$, and more preferably 1.0 $g/m^2$ to 20 $g/m^2$.

Examples of the aqueous solution containing nitric acid as a main component used in the first electrochemical roughening treatment of the aspect SA include aqueous solutions used in the electrochemical roughening treatment using direct current or alternating current. Examples thereof include an aqueous solution obtained by adding aluminum nitrate, sodium nitrate, ammonium nitrate, or the like to a 1 g/L to 100 g/L aqueous nitric acid solution.

Examples of the aqueous solution containing hydrochloric acid as a main component used in the second electrochemical roughening treatment of the aspect SA and in the third electrochemical roughening treatment of the aspect SB include aqueous solutions used in the electrochemical roughening treatment using direct current or alternating current. Examples thereof include an aqueous solution obtained by adding 0 g/L to 30 g/L of sulfuric acid to a 1 g/L to 100 g/L aqueous hydrochloric acid solution. Nitrate ions such as aluminum nitrate, sodium nitrate, or ammonium nitrate;

hydrochloric acid ions such as aluminum chloride, sodium chloride, or ammonium chloride may be further added to the aqueous solution.

As the waveform of an alternating current power source for the electrochemical roughening treatment, a sine wave, a square wave, a trapezoidal wave, a triangular wave, or the like can be used. The frequency is preferably 0.1 Hz to 250 Hz.

Fig. 1 is an example of a waveform graph of alternating current used for an electrochemical roughening treatment.

In Fig. 1, ta represents an anodic reaction time, tc represents a cathodic reaction time, tp represents the time taken for current to reach a peak from 0, Ia represents the peak current on the anodic cycle side, and Ic represents the peak current on the cathodic cycle side. For a trapezoidal wave, the time tp taken for current to reach a peak from 0 is preferably 1 msec to 10 msec. Regarding the conditions of one cycle of alternating current used for the electrochemical roughening treatment, a ratio tc/ta of the cathodic reaction time tc to the anodic reaction time ta of the aluminum plate is preferably within a range of 1 to 20, a ratio Qc/Qa of an electricity quantity Qc during the cathodic reaction to an electricity quantity Qa during the anodic reaction of the aluminum plate is preferably within a range of 0.3 to 20, and the anodic reaction time ta is preferably within a range of 5 msec to 1,000 msec. The peak current density of the trapezoidal wave is preferably 10 to 200 $A/dm^2$ at both the anodic cycle side Ia and the cathodic cycle side Ic of the current. Ic/Ia is preferably 0.3 to 20. At a point in time when the electrochemical roughening treatment has ended, the total quantity of electricity that participates in the anodic reaction of the aluminum plate is preferably 25 $C/dm^2$ to 1,000 $C/dm^2$.

The electrochemical roughening treatment using alternating current can be performed using the device shown in Fig. 2.

Fig. 2 is a lateral view showing an example of a radial cell in an electrochemical roughening treatment using alternating current.

In Fig. 2, 50 represents a main electrolytic cell, 51 represents an alternating current power source, 52 represents a radial drum roller, 53a and 53b represent main poles, 54 represents an electrolytic solution supply port, 55 represents an electrolytic solution, 56 represents a slit, 57 represents an electrolytic solution path, 58 represents an auxiliary anode, 60 represents an auxiliary anode tank, and W represents an aluminum plate. In a case where two or more electrolytic cells are used, the electrolysis conditions may be the same as or different from each other.

The aluminum plate W is wound around the radial drum roller 52 immersed and disposed in the main electrolytic cell 50. While being transported, the aluminum plate W is electrolyzed by the main poles 53a and 53b connected to the alternating current power source 51. From the electrolytic solution supply port 54, the electrolytic solution 55 is supplied to the electrolytic solution path 57 between the radial drum roller 52 and the main poles 53a and 53b through the slit 56. The aluminum plate W treated in the main electrolytic cell 50 is then electrolyzed in the auxiliary anode tank 60. In the auxiliary anode tank 60, the auxiliary anode 58 is disposed to face the aluminum plate W. The electrolytic solution 55 is supplied to flow in the space between the auxiliary anode 58 and the aluminum plate W.

In view of easily manufacturing a predetermined lithographic printing plate precursor, the amount of the aluminum plate dissolved by the second alkaline etching treatment is preferably 1.0 $g/m^2$ to 20 $g/m^2$, and more preferably 2.0 $g/m^2$ to 10 $g/m^2$.

In view of easily manufacturing a predetermined lithographic printing plate precursor, the amount of the aluminum plate dissolved by the third alkaline etching treatment and the fifth alkaline etching treatment is preferably 0.01 $g/m^2$ to 0.8 $g/m^2$, and more preferably 0.05 $g/m^2$ to 0.3 $g/m^2$.

In the chemical etching treatment (first to fifth desmutting treatments) using an aqueous acidic solution, an aqueous acidic solution containing phosphoric acid, nitric acid, sulfuric acid, chromic acid, hydrochloric acid, or a mixed acid consisting of two or more of these acids is suitably used.

The concentration of the acid in the aqueous acidic solution is preferably 0.5% by mass to 60% by mass.

<Anodization treatment step>

The anodization treatment step is a step of performing an anodization treatment on the aluminum plate having undergone the roughening treatment such that an aluminum oxide film is formed on the surface of the aluminum plate. By the anodization treatment, an anodic oxide film of aluminum having micropores is formed on the surface of the aluminum plate.

The anodization treatment can be performed according to the method known in the field of related art, by appropriately setting manufacturing conditions in consideration of the desired micropore shape.

In the anodization treatment step, an aqueous solution of sulfuric acid, phosphoric acid, oxalic acid, or the like can be mainly used as an electrolytic solution. In some cases, an aqueous solution or a non-aqueous solution of chromic acid, sulfamic acid, benzenesulfonic acid, or the like or an aqueous solution or a non-aqueous solution containing two or more acids among the above acids can also be used. In a case where direct current or alternating current is applied to the aluminum plate in the electrolytic solution, an anodic oxide film can be formed on the surface of the aluminum plate. The electrolytic solution may contain aluminum ions. The content of the aluminum ions is not particularly limited, and is

preferably 1 to 10 g/L.

The conditions of the anodization treatment are appropriately set depending on the electrolytic solution used. Generally, the concentration of the electrolytic solution of 1% to 80% by mass (preferably 5% to 20% by mass), the liquid temperature of 5°C to 70°C (preferably 10°C to 60°C), the current density of 0.5 to 60 A/$dm^2$ (preferably 5 to 50 A/$dm^2$), the voltage of 1 to 100 V (preferably 5 to 50 V), and the electrolysis time of 1 to 100 seconds (preferably 5 to 60 seconds) are appropriate.

One of the preferred examples of the anodization treatment is the anodization method described in British Patent 1,412,768, which is performed in a sulfuric acid at a high current density.

The anodization treatment can also be performed multiple times. It is possible to change one or more of conditions, such as the type, concentration, and liquid temperature of the electrolytic solution used in each anodization treatment, the current density, the voltage, and the electrolysis time. In a case where the anodization treatment is performed twice, sometime the firstly performed anodization treatment is called first anodization treatment, and the secondly performed anodization treatment is called second anodization treatment. Performing the first anodization treatment and the second anodization treatment makes it possible to form anodic oxide films having different shapes and to provide a lithographic printing plate precursor having excellent printing performance.

It is also possible to perform the following pore widening treatment after the anodization treatment and then perform the anodization treatment again. In this case, the first anodization treatment, the pore widening treatment, and the second anodization treatment are performed.

Using the method of performing the first anodization treatment, the pore widening treatment, and the second anodization treatment makes it possible to form micropores each configured with a large diameter portion that extends from the surface of the anodic oxide film along the depth direction and a small diameter portion that is in communication with the bottom portion of the large diameter portion and extends from the communicate position along the depth direction.

<Pore widening treatment step>

The pore widening treatment step is a treatment of enlarging the diameter of micropores (pore diameter) present in the anodic oxide film formed by the aforementioned anodization treatment step (pore diameter enlarging treatment). By the pore widening treatment, the diameter of the micropores is enlarged, and an anodic oxide film having micropores having a larger average diameter is formed.

The pore widening treatment can be carried out by bringing the aluminum plate obtained by the anodization treatment step into contact with an aqueous acid solution or an aqueous alkali solution. The contact method is not particularly limited, and examples thereof include a dipping method and a spraying method. Among these, a dipping method is preferable.

In a case where an aqueous alkali solution is used in the pore widening treatment step, it is preferable to use at least one aqueous alkali solution selected from the group consisting of sodium hydroxide, potassium hydroxide, and lithium hydroxide. The concentration of the aqueous alkali solution is preferably 0.1% to 5% by mass. As a proper treatment method, the pH of the aqueous alkali solution is adjusted to 11 to 13, and the aluminum plate is brought into contact with the aqueous alkali solution for 1 to 300 seconds (preferably 1 to 50 seconds) under the condition of 10°C to 70°C (preferably 20°C to 50°C). At this time, the alkaline treatment solution may contain a metal salt of a polyvalent weak acid such as carbonate, borate, or phosphate.

In a case where an aqueous acid solution is used in the pore widening treatment step, it is preferable to use an aqueous solution of an inorganic acid such as sulfuric acid, phosphoric acid, nitric acid, or hydrochloric acid, or a mixture of these. The concentration of the aqueous acid solution is preferably 1% to 80% by mass, and more preferably 5% to 50% by mass. As a proper treatment method, the aluminum plate is brought into contact with the aqueous acid solution for 1 to 300 seconds (preferably 1 to 150 seconds) under the condition of a liquid temperature of the aqueous acid solution of 5°C to 70°C (preferably 10°C to 60°C).

The aqueous alkali solution or the aqueous acid solution may contain aluminum ions. The content of the aluminum ions is not particularly limited, and is preferably 1 to 10 g/L.

The manufacturing method of the aluminum support having an anodic oxide film may include a hydrophilic treatment step of performing a hydrophilic treatment after the pore widening treatment step described above. As the hydrophilic treatment, it is possible to use the known method described in paragraphs "0109" to "0114" of JP2005-254638A.

The hydrophilic treatment is preferably performed by a method of immersing the aluminum plate in an aqueous solution of an alkali metal silicate such as sodium silicate or potassium silicate, a method of coating the aluminum plate with a hydrophilic vinyl polymer or a hydrophilic compound to form a hydrophilic undercoat layer, or the like.

The hydrophilic treatment using an aqueous solution of an alkali metal silicate such as sodium silicate or potassium silicate can be performed according to the method and procedure described in US2714066A and US3181461A.

[At least one layer containing infrared absorber with HOMO of -5.43 eV or less]

At least one layer containing an infrared absorber with a HOMO of -5.43 eV or less (hereinafter, also called "specific constitutional layer") that constitutes the lithographic printing plate precursor will be described.

The specific constitutional layer contains an infrared absorber with a HOMO of -5.43 eV or less.

(Infrared absorber with HOMO of -5.43 eV or less)

The specific constitutional layer contains an infrared absorber with a HOMO of -5.43 eV or less (hereinafter, also called "specific infrared absorber").

The infrared absorber has a function of inducing electron migration and/or energy transfer to a polymerization initiator or the like by being excited by infrared rays. The infrared absorber also has a function of converting absorbed infrared rays into heat. It is preferable that the infrared absorber have maximal absorption in a wavelength range of 750 to 1,400 nm. Examples of the specific infrared absorber include a dye or pigment with a HOMO of -5.43 eV or less. A dye is preferably used as the specific infrared absorber.

As the dye, it is possible to use commercially available dyes and known dyes described in publications such as "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among dyes, a cyanine dye, a squarylium colorant, or a pyrylium salt is preferable, a cyanine dye is more preferable, and an indolenine cyanine dye is particularly preferable.

The HOMO of a compound in the present invention is calculated by the following method. First, the counteranion in the compound as a calculation object is ignored. Structural optimization is carried out by DFT (B3LYP/6-31G(d)) using quantum chemical calculation software Gaussian 16.

The molecular orbital (MO) energy is calculated by DFT (B3LYP/6-31+G(d,p)/CPCM (solvent = methanol)) with the structure obtained by the aforementioned structural optimization. By the following formula, the MO energy Ebare (unit: hartree) obtained by the above MO energy calculation is converted into Eaft (unit: eV) used as the value of HOMO in the present disclosure.

$$\mathrm{Eaft} = 0.823161 \times 27.2114 \times \mathrm{Epre} - 1.07634$$

27.2114 is simply a coefficient for converting hartree into eV, and 0.823161 and -1.07634 are adjustment coefficients. These were determined such that the calculated value of HOMO of the compound as a calculation object match the measured value.

The specific infrared absorber is preferably a compound represented by the following Formula (1).

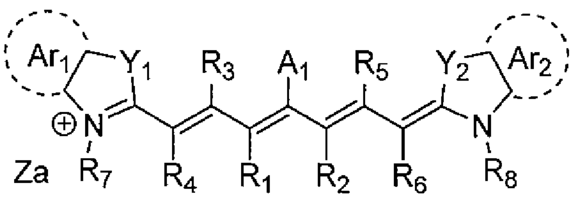

(1)

$R_1$ and $R_2$ each independently represent a hydrogen atom or an alkyl group, $R_1$ and $R_2$ may be linked to each other to form a ring, $R_3$ to $R_6$ each independently represent a hydrogen atom or an alkyl group, $R_7$ and $R_8$ each independently represent an alkyl group or an aryl group, $Y_1$ and $Y_2$ each independently represent an oxygen atom, a sulfur atom, $-NR_0-$, or a dialkyl methylene group, $R_0$ represents a hydrogen atom, an alkyl group, or an aryl group, $Ar_1$ and $Ar_2$ each independently represent a group forming a benzene ring or a naphthalene ring that may have a group represented by Formula 2 which will be described later, $A_1$ represents $-NR_9R_{10}$, $-X_1-X_{11}-L_1$, or a group represented by Formula 2 which will be described later,

$R_9$ and $R_{10}$ each independently represent an alkyl group, an aryl group, an alkoxycarbonyl group, an arylsulfonyl group, or a trihaloalkylsulfonyl group, $X_1$ represents an oxygen atom or a sulfur atom, $X_{11}$ represents a single bond or an alkylene group, $L_1$ represents a hydrocarbon group, a heteroaryl group, or a group that undergoes bond cleavage from $X_1$ by heat or exposure to infrared, and Za represents a counterion that neutralizes charge.

-X Formula 2

X represents a halogen atom, -C(=O)-$X_2$-$R_{11}$, -C(=O)-$NR_{12}R_{13}$, -O-C(=O)-$R_{14}$, -CN, -$SO_2NR_{15}R_{16}$, or a perfluoroalkyl group, $X_2$ represents a single bond or an oxygen atom, $R_{11}$ represents a hydrogen atom, an alkyl group, or an aryl group, $R_{14}$ represents an alkyl group or an aryl group, and $R_{12}$, $R_{13}$, $R_{15}$, and $R_{16}$ each independently represent a hydrogen atom, an alkyl group, or an aryl group.

$Ar_1$ and $Ar_2$ each independently represent a group forming a benzene ring or a naphthalene ring. The benzene ring and the naphthalene ring may have a substituent other than -X. Examples of the substituent include an alkyl group, an alkoxy group, an aryloxy group, an amino group, an alkylthio group, an arylthio group, a carboxylate group, a sulfo group, a sulfonate group, groups obtained by combining these, and the like. Among these, an alkyl group is preferable.

$Ar_1$ and $Ar_2$ may each independently have a group represented by Formula 2.

In addition, in Formula (1), as a preferred aspect, at least one of $Ar_1$ or $Ar_2$ has a group represented by Formula 2. As a preferred aspect, from the viewpoint of printing durability and lowering the value of HOMO, it is preferable that $Ar_1$ and $Ar_2$ both have a group represented by Formula 2.

At least one of $Ar_1$ or $Ar_2$ may have a plurality of groups represented by Formula 2.

X in Formula 2 represents a halogen atom, -C(=O)-$X_2$-$R_{11}$, -C(=O)-$NR_{12}R_{13}$, -O-C(=O)-$R_{14}$, -CN, -$SO_2NR_{15}R_{16}$, or a perfluoroalkyl group. From the viewpoint of lowering the HOMO of the specific infrared absorber such that the specific infrared absorber is inhibited from decomposing with the passage of time, X is preferably a halogen atom, -C(=O)-$X_2$-$R_{11}$, -C(=O)-$NR_{12}R_{13}$, -O-C(=O)-$R_{14}$, CN, or -$SO_2NR_{15}R_{16}$, more preferably a halogen atom, -C(=O)-O-$R_{11}$, -C(=O)-$NR_{12}R_{13}$, or -O-C(=O)-$R_{14}$, even more preferably a halogen atom, -C(=O)-O-$R_{11}$ or -O-C(=O)-$R_{14}$, and particularly preferably a fluorine atom, a chlorine atom, a bromine atom, or -C(=O)$OR_{20}$.

Examples of the halogen atom include a fluorine atom, a chlorine atom, a bromine atom, and the like. Among these, a chlorine atom is preferable.

$X_2$ represents a single bond or an oxygen atom, and is preferably an oxygen atom.

$R_{11}$ represents a hydrogen atom, an alkyl group, or an aryl group, preferably represents a hydrogen atom, an alkyl group having 1 to 12 carbon atoms, or an aryl group having 6 to 12 carbon atoms, and more preferably represents an alkyl group having 1 to 12 carbon atoms.

$R_{14}$ represents an alkyl group or an aryl group, preferably represents an alkyl group having 1 to 12 carbon atoms or an aryl group having 6 to 12 carbon atoms, and more preferably represents an alkyl group having 1 to 12 carbon atoms.

$R_{12}$, $R_{13}$, $R_{15}$, and $R_{16}$ each independently represent a hydrogen atom, an alkyl group, or an aryl group, preferably each independently represent a hydrogen atom, an alkyl group having 1 to 12 carbon atoms, or an aryl group having 6 to 12 carbon atoms, more preferably each independently represent a hydrogen atom or an alkyl group having 1 to 12 carbon atoms, and even more preferably each independently represent an alkyl group having 1 to 12 carbon atoms.

$R_{20}$ represents a hydrogen atom, an alkyl group, or an aryl group, preferably represents a hydrogen atom, an alkyl group having 1 to 12 carbon atoms, or an aryl group having 6 to 12 carbon atoms, and more preferably represents an alkyl group having 1 to 12 carbon atoms.

The alkyl group or aryl group described above may have a substituent. Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and groups obtained by combining these, and the like.

$A_1$ represents -$NR_9R_{10}$, -Xi-$X_{11}$-$L_1$, or -X. From the viewpoint of inhibiting the specific infrared absorber from decomposing with the passage of time, $A_1$ is preferably -$NR_9R_{10}$ or -$X_1$-$X_{11}$-$L_1$, and more preferably -$NR_{17}R_{18}$ or -S-$X_{12}$-$R_{19}$.

$R_9$ and $R_{10}$ each independently represent an alkyl group, an aryl group, an alkoxycarbonyl group, an arylsulfonyl group, or a trihaloalkylsulfonyl group.

Examples of the alkyl group in the alkoxycarbonyl group include the same alkyl group as the alkyl group represented by $R_9$ and $R_{10}$.

Examples of the aryl group in the arylsulfonyl group include the same aryl group as the aryl group represented by $R_9$ and $R_{10}$.

Examples of the alkyl group in the trihaloalkylsulfonyl group include the same alkyl group as the alkyl group represented by $R_9$ and $R_{10}$.

Examples of the trihaloalkylsulfonyl group include a trifluoromethylsulfonyl group.

$R_9$ and $R_{10}$ preferably each independently represent an alkyl group, an aryl group, or a trihaloalkylsulfonyl group, more preferably each independently represent an alkyl group having 1 to 12 carbon atoms or an aryl group having 6 to 12 carbon atoms, and even more preferably each independently represent an alkyl group having 1 to 12 carbon atoms.

$X_1$ represents an oxygen atom or a sulfur atom. In a case where $L_1$ is a hydrocarbon group or a heteroaryl group, $X_1$ is preferably a sulfur atom. $L_1$ is preferably a group that undergoes bond cleavage from $X_1$ by heat or exposure to infrared. In a case where $L_1$ represents a group that undergoes bond cleavage from $X_1$ by heat or exposure to infrared, $X_{11}$

is a single bond.

$X_{11}$ and $X_{12}$ each independently represent a single bond or an alkylene group, preferably each independently represent a single bond or an alkylene group having 1 to 5 carbon atoms, and more preferably each independently represent a single bond or an alkylene group having 1 to 3 carbon atoms.

$L_1$ represents a hydrocarbon group, a heteroaryl group, or a group that undergoes bond cleavage from $X_1$ by heat or exposure to infrared. From the viewpoint of printing durability, $L_1$ is preferably a hydrocarbon group or a heteroaryl group, more preferably an aryl group or a heteroaryl group, and even more preferably a heteroaryl group.

From the viewpoint of expressing image contrast by exposure to infrared, $L_1$ is preferably a group that undergoes bond cleavage from $X_1$ by heat or exposure to infrared.

The group that undergoes bond cleavage from $X_1$ by heat or exposure to infrared will be described later.

$R_{17}$ and $R_{18}$ each independently represent an aryl group, preferably each independently represent an aryl group having 6 to 20 carbon atoms, and more preferably each independently represent a phenyl group.

$R_{19}$ represents a hydrocarbon group or a heteroaryl group, preferably represents an aryl group or a heteroaryl group, and more preferably represents a heteroaryl group.

The heteroaryl group represented by $L_1$ and $R_{19}$ is not particularly limited, and preferred examples thereof include the following groups.

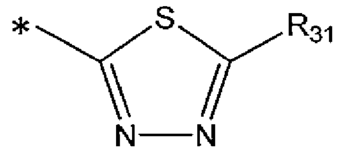

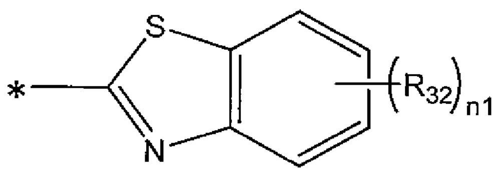

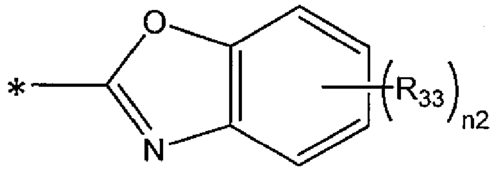

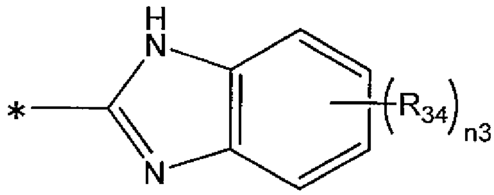

$R_{31}$ represents a hydrogen atom, an alkyl group, an aryl group, or an alkenyl group.

$R_{32}$ to $R_{34}$ each independently represent a hydrogen atom, an alkyl group, an aryl group, or an alkenyl group.

n1 to n3 each independently represent an integer of 1 to 4. In a case where n1 to n3 are integers of 2 to 4, the plurality of $R_{32}$'s may be the same as or different from each other, the plurality of $R_{33}$'s may be the same as or different from each other, and the plurality of $R_{34}$'s may be the same as or different from each other.

**[0181]** * represents a bonding position.

The alkyl group represented by $R_1$ to $R_{10}$, $R_0$, and $R_{31}$ to $R_{34}$ is preferably an alkyl group having 1 to 30 carbon atoms, more preferably an alkyl group having 1 to 15 carbon atoms, even more preferably an alkyl group having 1 to 12 carbon atoms, and particularly preferably an alkyl group having 1 to 10 carbon atoms. The alkyl group may be linear or branched, or may have a ring structure.

Specific examples of the alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group.

Among these alkyl groups, a methyl group, an ethyl group, a propyl group, or a butyl group is particularly preferable.

The above alkyl group may have a substituent. Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and groups obtained by combining these, and the like.

The aryl group represented by $R_7$, $R_8$, $R_9$, $R_{10}$, $R_{18}$, $R_{19}$, $R_0$, and $R_{31}$ to $R_{34}$ is preferably an aryl group having 6 to 30 carbon atoms, more preferably an aryl group having 6 to 20 carbon atoms, and even more preferably an aryl group having 6 to 12 carbon atoms.

The aryl group may have a substituent. Examples of the substituent include an alkyl group, an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and groups obtained by

combining these, and the like.

Specific examples of the aryl group include a phenyl group, a naphthyl group, a p-tolyl group, a p-chlorophenyl group, a p-fluorophenyl group, a p-methoxyphenyl group, a p-dimethylaminophenyl group, a p-methylthiophenyl group, a p-phenylthiophenyl group, and the like.

Among these aryl groups, a phenyl group, a p-methoxyphenyl group, a p-dimethylaminophenyl group, or a naphthyl group is preferable.

The alkenyl group represented by $R_{31}$ to $R_{34}$ is preferably an alkenyl group having 2 to 30 carbon atoms, more preferably an alkenyl group having 2 to 15 carbon atoms, and even more preferably an alkenyl group having 2 to 10 carbon atoms. The alkenyl group may be linear or branched, or may have a ring structure.

In addition, the alkenyl group may have a substituent. Examples of the substituent include an alkoxy group, an aryloxy group, an amino group, an alkylthio group, an arylthio group, a halogen atom, a carboxy group, a carboxylate group, a sulfo group, a sulfonate group, an alkyloxycarbonyl group, an aryloxycarbonyl group, and groups obtained by combining these, and the like.

Specific examples of the alkenyl group include a vinyl group, a propenyl group, a butenyl group, a pentenyl group, a hexenyl group, a cyclohexenyl group, and the like.

Among these alkenyl groups, a vinyl group and a propenyl group are preferable.

It is preferable that $R_1$ and $R_2$ be linked to each other to form a ring.

In a case where $R_1$ and $R_2$ are linked to each other to form a ring, the formed ring is preferably a 5- or a 6-membered ring and more preferably a 6-membered ring. Furthermore, the ring formed of $R_1$ and $R_2$ linked to each other is preferably a hydrocarbon ring which may have an ethylenically unsaturated bond.

$Y_1$, and $Y_2$ each independently represent an oxygen atom, a sulfur atom, $-NR_0-$, or a dialkylmethylene group. Among these, $-NR_0-$ or a dialkylmethylene group is preferable, and a dialkylmethylene group is more preferable.

$R_0$ represents a hydrogen atom, an alkyl group, or an aryl group. $R_0$ is preferably an alkyl group.

It is preferable that $R_7$ and $R_8$ be the same group.

$R_7$ and $R_8$ preferably each independently represent a linear alkyl group or an alkyl group having a sulfonate group on a terminal, and more preferably each independently represent a methyl group, an ethyl group, or a butyl group having a sulfonate group on a terminal.

The countercation of the aforementioned sulfonate group may be a cation on a nitrogen atom in Formula (1) or may be an alkali metal cation or an alkaline earth metal cation.

From the viewpoint of improving water solubility of the compound represented by Formula (1), $R_7$ and $R_8$ preferably each independently represent an alkyl group having an anion structure, more preferably each independently represent an alkyl group having a carboxylate group or a sulfonate group, and even more preferably each independently represent an alkyl group having a sulfonate group on a terminal.

$R_3$ to $R_6$ each independently represent a hydrogen atom or an alkyl group, and preferably each independently represent a hydrogen atom.

Za represents a counterion that neutralizes charge. In a case where Za represents anionic species, examples thereof include a sulfonate ion, a carboxylate ion, a tetrafluoroborate ion, a tetraphenylborate ion, a hexafluorophosphate ion, a perchlorate ion, a sulfonamide anion, a sulfonimide anion, and the like. In a case where Za represents cationic species, an alkali metal ion, an alkaline earth metal ion, an ammonium ion, a pyridinium ion, or a sulfonium ion is preferable, a sodium ion, a potassium ion, an ammonium ion, a pyridinium ion, or a sulfonium ion is more preferable, a sodium ion, a potassium ion, or an ammonium ion is even more preferable, and a sodium ion, a potassium ion, or a trialkylammonium ion is particularly preferable.

As Za, among the above, an organic anion having a carbon atom is preferable, a sulfonate ion, a carboxylate ion, a sulfonamide anion, or a sulfonimide anion is more preferable, a sulfonamide anion or a sulfonimide anion is even more preferable, and a sulfonimide anion is particularly preferable.

$R_1$ to $R_8$, $R_0$, $A_1$, $Ar_1$, $Ar_2$, $Y_1$, and $Y_2$ may have an anion structure or a cation structure. In a case where all of $R_1$ to $R_8$, $R_0$, $A_1$, $Ar_1$, $Ar_2$, $Y_1$, and $Y_2$ represent a group having neutral charge, Za represents a monovalent counteranion. However, for example, in a case where two or more among $R_1$ to $R_8$, $R_0$, $A_1$, $Ar_1$, $Ar_2$, $Y_1$, and $Y_2$ have an anion structure, Za can be a countercation.

In Formula (1), in a case where portions other than Za have neutral charge, Formula (1) may not have Za.

As the sulfonamide anion, an aryl sulfonamide anion is preferable.

As the sulfonimide anion, a bisaryl sulfonimide anion is preferable.

Specific examples of the sulfonamide anion or the sulfonimide anion will be shown below, but the present invention is not limited thereto. In the following specific examples, Ph represents a phenyl group, Me represents a methyl group, and Et represents an ethyl group.

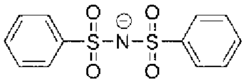
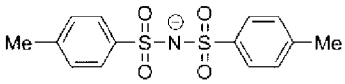
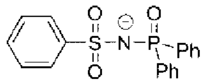

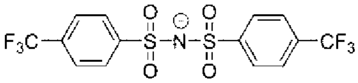
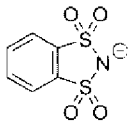
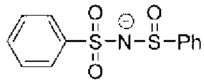

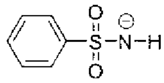

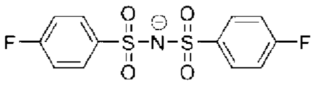
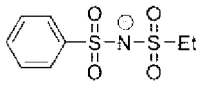

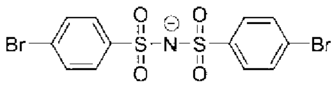
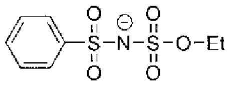
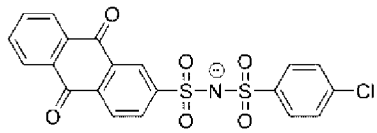

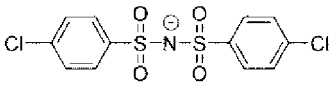
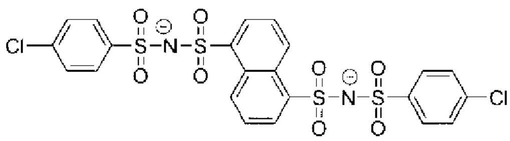

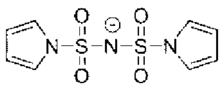
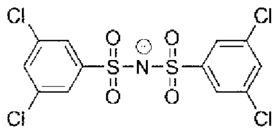

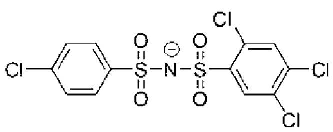
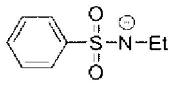

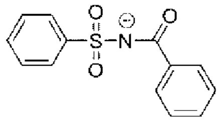
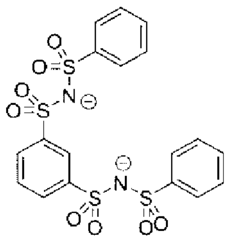
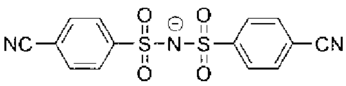

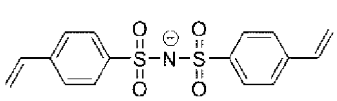

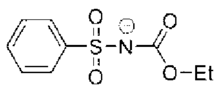
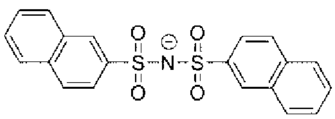

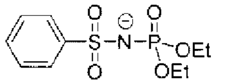
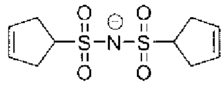

From the viewpoint of image forming properties and color developability, the group that undergoes bond cleavage from $X_1$ by heat or exposure to infrared is preferably a group represented by any of Formulas 1-1 to 1-7, and more preferably a group represented by any of Formulas 1-1 to 1-3.

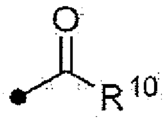
(1-1)

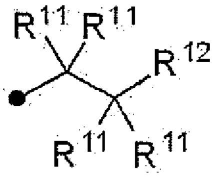
(1-2)

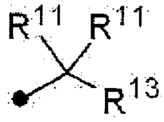
(1-3)

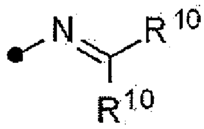
(1-4)

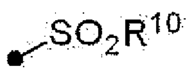
(1-5)

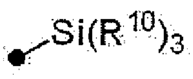
(1-6)

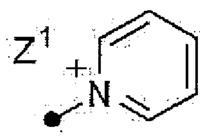
(1-7)

In Formulas 1-1 to 1-7, • represents a bonding site with $X_1$ in Formula (1), $R^{10}$ each independently represent a hydrogen atom, an alkyl group, an alkenyl group, an aryl group, $-OR^{14}$, $-NR^{15}R^{16}$, or $-SR^{17}$, $R^{11}$ each independently represent a hydrogen atom, an alkyl group, or an aryl group, $R^{12}$ represents an aryl group, $-OR^{14}$, $-NR^{15}R^{16}$, $-SR^{17}$, $-C(=O)R^{18}$, $-OC(=O)R^{18}$, or a halogen atom, $R^{13}$ represents an aryl group, an alkenyl group, an alkoxy group, or an onium group, $R^{14}$ to $R^{17}$ each independently represent a hydrogen atom, an alkyl group, or an aryl group, each independently represent an alkyl group, an aryl group, $-OR^{14}$, $-NR^{15}R^{16}$, or $-SR^{17}$, and $Z^1$ represents a counterion that neutralizes charge.

In a case where $R^{10}$, $R^{11}$, and $R^{14}$ to $R^{18}$ each represent an alkyl group, preferred aspects of the alkyl group are the same as preferred aspects of the alkyl group represented by $R_1$ to $R_{10}$ and $R_0$.

The number of carbon atoms in the alkenyl group represented by $R^{10}$ and $R^{13}$ is preferably 1 to 30, more preferably 1 to 15, and even more preferably 1 to 10.

In a case where $R^{10}$ to each represent an aryl group, preferred aspects of the aryl group are the same as preferred aspects of the aryl group represented by $R_0$.

From the viewpoint of image forming properties and color developability, $R^{10}$ in Formula 1-1 is preferably an alkyl group, an alkenyl group, an aryl group, $-OR^{14}$, $-NR^{15}R^{16}$, or $-SR^{17}$, more preferably an alkyl group, $-OR^{14}$, $-NR^{15}R^{16}$, or $-SR^{17}$, even more preferably an alkyl group or $-OR^{14}$, and particularly preferably $-OR^{14}$.

In a case where $R^{10}$ in Formula 1-1 is an alkyl group, the alkyl group is preferably an alkyl group having an arylthio group or an alkyloxycarbonyl group at the $\alpha$-position.

In a case where $R^{10}$ in Formula 1-1 represents $-OR^{14}$, $R^{14}$ is preferably an alkyl group, more preferably an alkyl group having 1 to 8 carbon atoms, even more preferably an isopropyl group or a t-butyl group, and particularly preferably a t-butyl group.

From the viewpoint of image forming properties and color developability, $R^{11}$ in Formula 1-2 is preferably a hydrogen atom.

Furthermore, from the viewpoint of image forming properties and color developability, $R^{12}$ in Formula 1-2 is preferably $-C(=O)OR^{14}$, $-OC(=O)OR^{14}$, or a halogen atom, and more preferably $-C(=O)OR^{14}$ or $-OC(=O)OR^{14}$. In a case where $R^{12}$ in Formula 1-2 is $-C(=O)OR^{14}$ or $-OC(=O)OR^{14}$, $R^{14}$ is preferably an alkyl group.

From the viewpoint of image forming properties and color developability, $R^{11}$'s in Formula 1-3 preferably each independently represent a hydrogen atom or an alkyl group. It is more preferable that at least one of $R^{11}$'s in Formula 1-3 be an alkyl group.

The alkyl group represented by $R^{11}$ is preferably an alkyl group having 1 to 10 carbon atoms, and more preferably an alkyl group having 3 to 10 carbon atoms.

Furthermore, the alkyl group represented by $R^{11}$ is preferably an alkyl group having a branch or a cycloalkyl group, more preferably a secondary or tertiary alkyl group or a cycloalkyl group, and even more preferably an isopropyl group, a cyclopentyl group, a cyclohexyl group, or a t-butyl group.

From the viewpoint of image forming properties and color developability, $R^{13}$ in Formula 1-3 is preferably an aryl group, an alkoxy group, or an onium group, more preferably a p-dimethylaminophenyl group or a pyridinium group, and even more preferably a pyridinium group.

Examples of the onium group represented by $R^{13}$ include a pyridinium group, an ammonium group, a sulfonium group, and the like. The onium group may have a substituent. Examples of the substituent include an alkyl group, an alkoxy group, an aryloxy group, an amino group, an alkylthio group, an arylthio group, a halogen atom, a carboxy group, a sulfo group, an alkyloxycarbonyl group, an aryloxycarbonyl group, groups obtained by combining these, and the like. Among these, an alkyl group, an aryl group, and groups obtained by combining these are preferable.

Among these, a pyridinium group is preferable, an N-alkyl-3-pyridinium group, an N-benzyl-3-pyridinium group, an N-(alkoxypolyalkyleneoxyalkyl)-3-pyridinium group, an N-alkoxycarbonylmethyl-3-pyridinium group, an N-alkyl-4-pyridinium group, an N-benzyl-4-pyridinium group, an N-(alkoxypolyalkyleneoxyalkyl)-4-pyridinium group, an N-alkoxycarbonylmethyl-4-pyridinium group, or an N-alkyl-3,5-dimethyl-4-pyridinium group is more preferable, an N-alkyl-3-pyridinium group or an N-alkyl-4-pyridinium group is even more preferable, an N-methyl-3-pyridinium group, an N-octyl-3-pyridinium group, an N-methyl-4-pyridinium group, or an N-octyl-4-pyridinium group is particularly preferable, and an N-octyl-3-pyridinium group or an N-octyl-4-pyridinium group is most preferable.

In a case where $R^{13}$ is a pyridinium group, examples of the counteranion include a sulfonate ion, a carboxylate ion, a tetrafluoroborate ion, a hexafluorophosphate ion, a p-toluenesulfonate ion, a perchlorate ion, and the like. Among these, a p-toluenesulfonate ion or a hexafluorophosphate ion is preferable.

From the viewpoint of image forming properties and color developability, $R^{10}$ in Formula 1-4 is preferably an alkyl group or an aryl group. It is more preferable that one of two $R^{10}$'s be an alkyl group and the other be an aryl group.

From the viewpoint of image forming properties and color developability, $R^{10}$ in Formula 1-5 is preferably an alkyl group or an aryl group, more preferably an aryl group, and even more preferably a p-methylphenyl group.

From the viewpoint of image forming properties and color developability, $R^{10}$'s in Formula 1-6 preferably each independently represent an alkyl group or an aryl group, and more preferably each independently represent a methyl group or a phenyl group.

From the viewpoint of image forming properties and color developability, $Z^1$ in Formula 1-7 has no limitations as long as it is a counterion for neutralizing charge, and may be included in Za in the entirety of the compound.

$Z^1$ is preferably a sulfonate ion, a carboxylate ion, a tetrafluoroborate ion, a hexafluorophosphate ion, a p-toluenesulfonate ion, or a perchlorate ion, and more preferably a p-toluenesulfonate ion or a hexafluorophosphate ion.

The group that undergoes bond cleavage from $X_1$ by heat or exposure to infrared is particularly preferably a group represented by Formula 1-8.

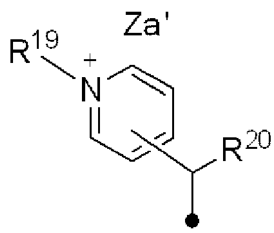

(1 - 8)

In Formula 1-8, • represents a bonding site with $X_1$ in Formula (1), $R^{19}$ and $R^{20}$ each independently represent an alkyl group, and Za' represents a counterion that neutralizes charge.

In Formula 1-8, the bonding position of a pyridinium ring and a hydrocarbon group having $R^{20}$ is preferably the 3-position or 4-position of the pyridinium ring, and more preferably the 4-position of the pyridinium ring.

The alkyl group represented by $R^{19}$ and $R^{20}$ may be linear or branched, or may have a ring structure.

Furthermore, the above alkyl group may have a substituent, and preferred examples of the substituent include an alkoxy group and a terminal alkoxypolyalkyleneoxy group.

$R^{19}$ is preferably an alkyl group having 1 to 12 carbon atoms, more preferably a linear alkyl group having 1 to 12 carbon atoms, even more preferably a linear alkyl group having 1 to 8 carbon atoms, and particularly preferably a methyl group or an n-octyl group.

$R^{20}$ is preferably an alkyl group having 1 to 8 carbon atoms, more preferably a branched alkyl group having 3 to 8 carbon atoms, even more preferably an isopropyl group or a t-butyl group, and particularly preferably an isopropyl group.

Za' may be a counterion that neutralizes charge, and may be included in Za in the entirety of the compound.

Za' is preferably a sulfonate ion, a carboxylate ion, a tetrafluoroborate ion, a hexafluorophosphate ion, a p-toluenesulfonate ion, or a perchlorate ion, and more preferably a p-toluenesulfonate ion or a hexafluorophosphate ion.

Preferred specific examples of the specific infrared absorbers include the following mother nucleus structures IR-1 to IR-17, IR-20 to IR-37, the following counteranions A-1 to A-4, and the following countercations C-1 to C-3. However, the present invention is not limited thereto.

The value of HOMO is also shown for the mother nucleus structure.

Specific examples of the specific infrared absorber are compounds that are obtained by combining one of the mother nucleus structures IR-1 to IR-15 and IR-24 to IR-37 with one of the counteranions A-1 to A-4 and compounds that are obtained by combining one of the mother nucleus structures IR-20 to IR-23 with one of the countercations C-1 to C-3.

The mother nucleus structures IR-16 and IR-17 do not have a counteranion.

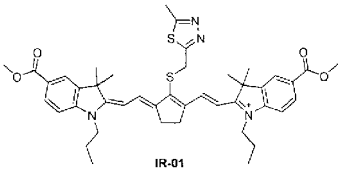

IR-01
HOMO=-5.46eV

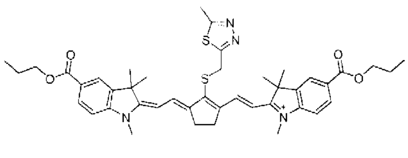

IR-02
HOMO=-5.48eV

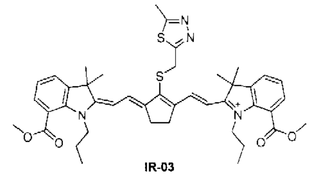

IR-03
HOMO=-5.46eV

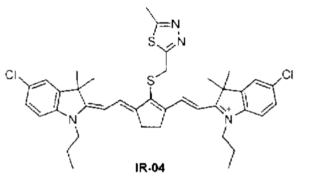

IR-04
HOMO=-5.44eV

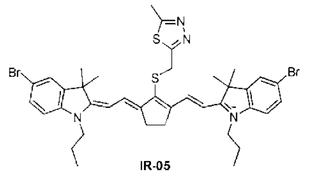

IR-05
HOMO=-5.43eV

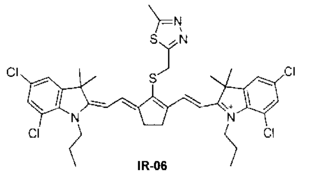

IR-06
HOMO=-5.46eV

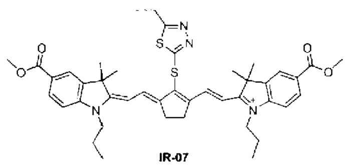

IR-07
HOMO=-5.50eV

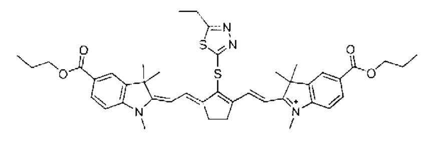

IR-08
HOMO=-5.50eV

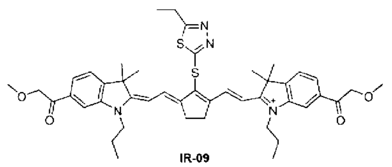

IR-09
HOMO=-5.45eV

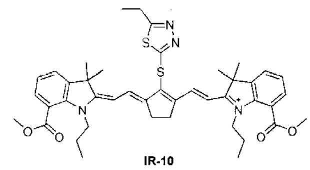

IR-10
HOMO=-5.45eV

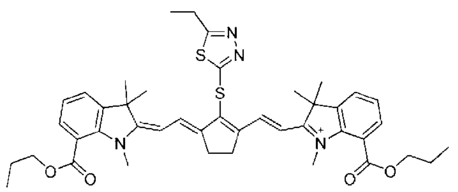

IR-11
HOMO=-5.50eV

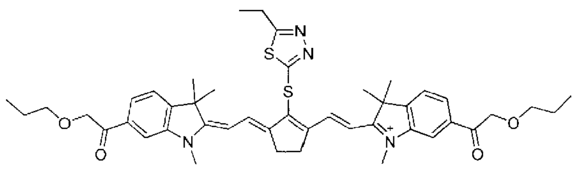

IR-12
HOMO=-5.46eV

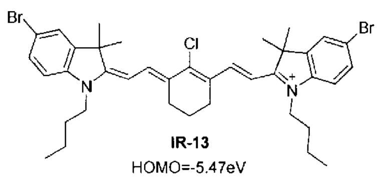

IR-13
HOMO=-5.47eV

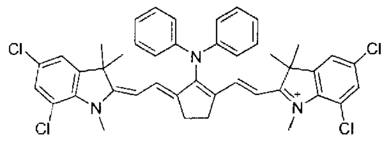

IR-14
HOMO=-5.45eV

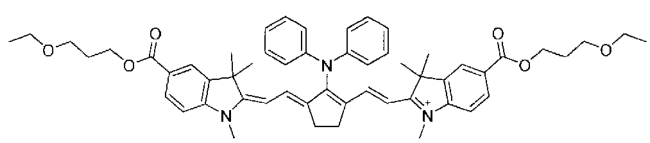

IR-15
HOMO=-5.45eV

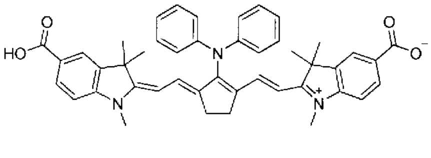

IR-16
HOMO=-5.45eV

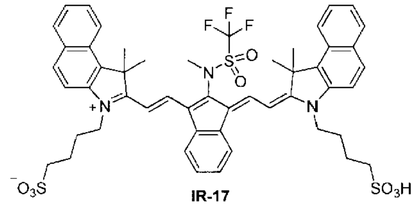

IR-17
HOMO=-5.56eV

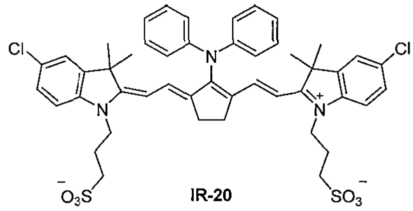

IR-20
HOMO=-5.46eV

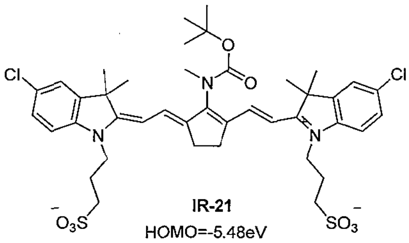

IR-21
HOMO=-5.48eV

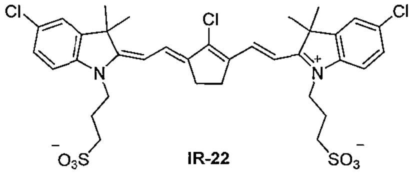

IR-22
HOMO=-5.52eV

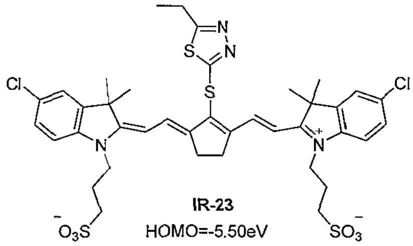

IR-23
HOMO=-5.50eV

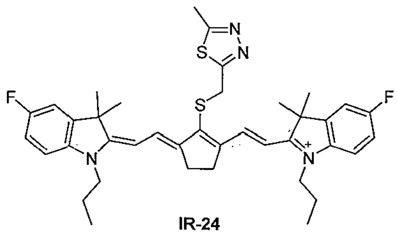

IR-24
HOMO=-5.45eV

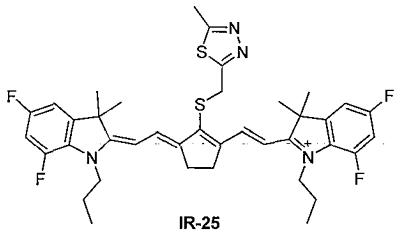

IR-25
HOMO=-5.47eV

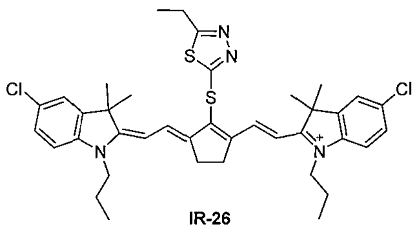

IR-26
HOMO=-5.48eV

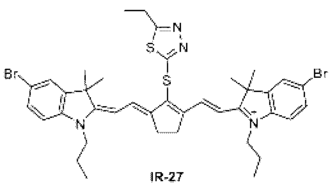

IR-27
HOMO=-5.47eV

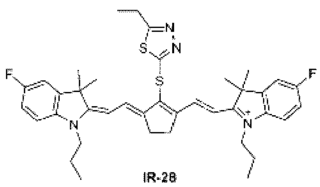

IR-28
HOMO=-5.50eV

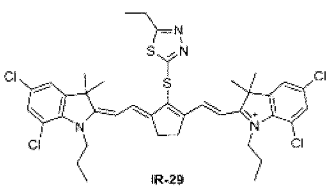

IR-29
HOMO=-5.50eV

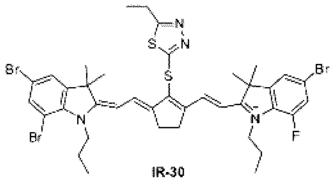

IR-30
HOMO=-5.49eV

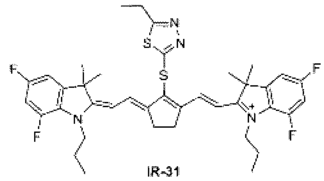

IR-31
HOMO=-5.52eV

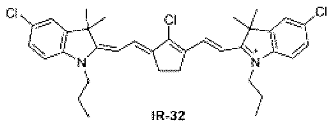

IR-32
HOMO=-5.52eV

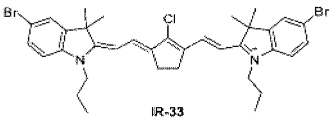

IR-33
HOMO=-5.50eV

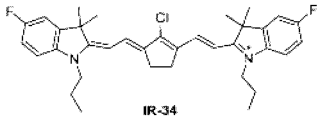

IR-34
HOMO=-5.54eV

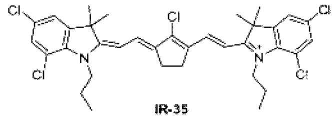

IR-35
HOMO=-5.54eV

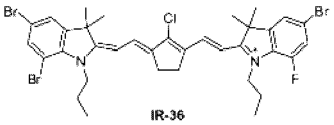

IR-36
HOMO=-5.52eV

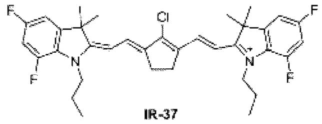

IR-37
HOMO=-5.56eV

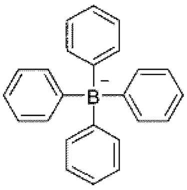

A-1

$PF_6^-$

A-2

$BF_4^-$

A-3

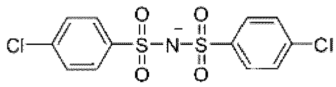

A-4

$Na^+$ C - 1

$K^+$ C - 2

$(CH_3CH_2)_3NH^+$ C - 3

The HOMO of the specific infrared absorber may be -5.43 eV or less. From the viewpoint of inhibiting the specific infrared absorber from decomposing with the passage of time, it is preferable that the specific infrared absorber have a lower HOMO energy level.

The HOMO of the specific infrared absorber is more preferably -5.45 eV or less, and is -5.47 eV or less.

The lower limit of the HOMO of the specific infrared absorber is not particularly limited, but is usually -5.60 eV.

The specific infrared absorber may be a commercially available product, and can be created with reference to a known production method. For example, in a case where the specific infrared absorber is a compound represented by Formula (1), the production method thereof is not particularly limited, and the specific infrared absorber can be produced with reference to a known cyanine dye production method. In addition, the method described in WO2016/027886A can also be suitably used.

One specific infrared absorber may be used alone, or two or more specific infrared absorbers may be used in combination.

In the specific constitutional layer, the content of the specific infrared absorber in the total solid content of the specific constitutional layer is preferably 0.05% to 30% by mass, more preferably 0.1% to 20% by mass, and even more preferably 0.2% to 10% by mass.

The specific constitutional layer is at least one layer containing the specific infrared absorber. Therefore, in a case where a layer constituting the lithographic printing plate precursor, such as an image-recording layer, an undercoat layer, or a protective layer, contains the specific infrared absorber, such a layer corresponds to the specific constitutional layer.

In a preferred aspect, at least one layer containing the specific infrared absorber is an image-recording layer.

In a preferred aspect, at least one layer containing the specific infrared absorber is a protective layer.

The at least one layer containing the specific infrared absorber may be one layer or two or more layers.

In the lithographic printing plate precursor constituting the laminate according to an embodiment of the present invention, at least one of the outermost layer surface on the side of the at least one layer containing an infrared absorber

with reference to the support or the outermost layer surface on the side opposite to the side of the at least one layer containing an infrared absorber has an arithmetic mean height Sa of 0.3 μm or more and 20 μm or less.

The at least one layer containing an infrared absorber is the aforementioned specific constitutional layer.

As an aspect, in the lithographic printing plate precursor constituting the laminate according to an embodiment of the present invention, the outermost layer surface on the side of the at least one layer containing an infrared absorber with reference to the support (hereinafter, called "surface A") has an arithmetic mean height Sa of 0.3 μm or more and 20 μm or less.

As another aspect, in the lithographic printing plate precursor constituting the laminate according to an embodiment of the present invention, the outermost layer surface on the side opposite to the side of the at least one layer containing an infrared absorber with reference to the support (hereinafter, called "surface B") has an arithmetic mean height Sa of 0.3 μm or more and 20 μm or less.

In another aspect, in the lithographic printing plate precursor constituting the laminate according to an embodiment of the present invention, the outermost layer surface on the side of the at least one layer containing an infrared absorber with reference to the support has an arithmetic mean height Sa of 0.3 μm or more and 20 μm or less, and the outermost layer surface on the side opposite to the side of the at least one layer containing an infrared absorber with reference to the support has an arithmetic mean height Sa of 0.3 μm or more and 20 μm or less.

In a case where the outermost layer surface on the side opposite to the specific constitutional layer with reference to the support has a backcoat layer on the opposite side, the outermost layer surface is the surface of the backcoat layer. In a case where the outermost layer surface has no layer on the opposite side, the outermost layer surface is the support surface.

For example, in a case where protrusions that will be described later are formed, the backcoat layer may be the outermost layer of the lithographic printing plate precursor, and a plurality of protrusions containing a polymer compound may be on the backcoat layer. Alternatively, the support may be the outermost layer, and a plurality of protrusions containing a polymer compound may be on the support.

In a case where an image-recording layer or a protective layer is the outermost layer, the outermost layer surface on the side of the specific constitutional layer with reference to the support is the surface of the image-recording layer or the surface of the protective layer.

For example, in a case where protrusions that will be described later are formed, the image-recording layer or the protective layer may be the outermost layer of the lithographic printing plate precursor, and a plurality of protrusions containing a polymer compound may be on the image-recording layer or the protective layer.

The arithmetic mean height Sa of the outermost layer surface on the side opposite to the specific constitutional layer with reference to the support is more preferably 0.5 to 10 μm, and even more preferably 0.5 to 7 μm.

The arithmetic mean height Sa of the outermost layer surface on the side of the specific constitutional layer with reference to the support is more preferably 0.5 to 10 μm, and even more preferably 0.5 to 7 μm.

The arithmetic mean height Sa of the outermost layer surface is measured according to the method described in ISO 25178. That is, the heights of three or more sites selected in the same sample are measured using a MICROMAP MM3200-M100 manufactured by Mitsubishi Chemical Systems. Inc., and the average thereof is adopted as the arithmetic mean height Sa. Regarding the measurement range, a range of 1 cm × 1 cm randomly selected from the sample surface is measured.

In order that the condition where the arithmetic mean height Sa of the outermost layer surface is 0.3 to 20 μm is satisfied, it is preferable that the outermost layer be in the form having irregularities.

Specifically, examples of aspects thereof include an aspect in which the outermost layer contains particles having an average particle diameter of 0.5 to 20 μm (aspect 1), and an aspect in which a plurality of protrusions containing a polymer compound as a main component is on the outermost layer (aspect 2). The main component means a component having the highest content (% by mass).

The aspect 1 may be an aspect in which an underlayer adjacent to the outermost layer contains particles having an average particle diameter of 0.5 to 20 μm.

In the aspect 1, the particles having an average particle diameter of 0.5 to 20 μm are not particularly limited, but are preferably at least one kind of particles selected from organic resin particles and inorganic particles.

Preferred examples of the organic resin particles include particles consisting of synthetic resins such as poly(meth)acrylic acid esters, polystyrene and derivatives thereof, polyamides, polyimides, polyolefins including low-density polyethylene, high-density polyethylene, polypropylene, and the like, polyurethanes, polyureas, and polyesters, particles consisting of natural polymers such as chitin, chitosan, cellulose, crosslinked starch, and crosslinked cellulose, and the like.

Among these, the synthetic resin particles have advantages such as ease of particle size control and ease of control of surface characteristics as desired by surface reforming.

Regarding the manufacturing method of the organic resin particles, although a relatively hard resin such as polymethylmethacrylate (PMMA) can be made into fine particles by a crushing method, a particle synthesis method by an

emulsification suspension polymerization method is preferably adopted in view of ease of particle diameter control and accuracy.

Details of the manufacturing method of the organic resin particles are described in "Ultrafine particles and materials" edited by The Materials Science Society of Japan, published in 1993, "Preparation and application of fine particles/powders", supervised by Haruma Kawaguchi, CMC Publishing CO., LTD., published in 2005, and the like.

The organic resin particles are also available as commercially available products. Examples thereof include cross-linked acrylic resins MX-40T, MX-80H3wT, MX-150, MX-180TA, MX-300, MX-500, MX-1000, MX-1500H, MR-2HG, MR-7HG, MR-10HG, MR-3GSN, MR-5GSN, MR-7G, MR-10G, MR-5C, and MR-7GC as well as styryl resin-based SX-350H and SX-500H manufactured by Soken Chemical & Engineering Co., Ltd., acrylic resin MBX-5, MBX-8, MBX-12, MBX-15, MBX-20, MB20X-5, MB30X-5, MB30X-8, MB30X-20, SBX-6, SBX-8, SBX-12, SBX-17, SSX-101, SSX-102, SSX-104, and SSX-105 manufactured by Sekisui Kasei Co., Ltd., polyolefin resins CHEMIPEARL W100, W200, W300, W308, W310, W400, W401, W405, W410, W500, WF640, W700, W800, W900, W950, and WP100 manufactured by Mitsui Chemicals, Inc., ART PEARL J-6PE and J-7PS manufactured by Negami Chemical Industrial Co., Ltd., and the like.

Examples of the inorganic particles include silica, alumina, zirconia, titania, carbon black, graphite, $BaSO_4$, ZnS, $MgCO_3$, $CaCO_3$, ZnO, CaO, $WS_2$, $MoS_2$, MgO, $SnO_2$, $\alpha$-$Fe_2O_3$, $\alpha$-FeOOH, SiC, $CeO_2$, BN, SiN, MoC, BC, WC, titanium carbide, corundum, artificial diamond, garnet, silicastone, tripoli, diatomaceous earth, dolomite, and the like.

The aforementioned particles are preferably particles having a hydrophilic surface. The particles having a hydrophilic surface include organic resin particles having a hydrophilic surface and inorganic particles having a hydrophilic surface.

The organic resin particles having a hydrophilic surface are preferably organic resin particles coated with at least one inorganic compound selected from the group consisting of silica, alumina, titania, and zirconia, and particularly preferably organic resin particles coated with silica.

The organic resin constituting the organic resin particles having a hydrophilic surface is preferably at least one resin selected from the group consisting of a polyacrylic resin, a polyurethane-based resin, a polystyrene-based resin, a polyester-based resin, an epoxy-based resin, a phenol-based resin, and a melamine resin.

Hereinafter, as an example of the organic resin particles having a hydrophilic surface, organic resin particles coated with silica (hereinafter, also called "silica-coated organic resin particles") will be specifically described. However, the organic resin particles having a hydrophilic surface are not limited thereto.

The silica-coated organic resin particles are particles obtained by coating the surface of particles consisting of an organic resin with silica. It is preferable that the organic resin particles constituting a core do not soften or turn sticky by the moisture in the air or temperature.

Examples of the organic resin constituting the organic resin particles in the silica-coated organic resin particles include a polyacrylic resin, a polyurethane-based resin, a polystyrene-based resin, a polyester-based resin, an epoxy-based resin, a phenol resin, a melamine resin, and the like.

Examples of materials forming the silica layer that coats the surface of the silica-coated organic resin particles include an alkoxysilyl group-containing compound such as a condensate of alkoxysilyl-based compound, particularly, a siloxane-based material. Specifically, for example, silica particles such as silica sol, colloidal silica, and silica nanoparticles, and the like are preferable.

The silica-coated organic resin particles may have a constitution in which silica particles have adhered to the surface of organic resin particles as a solid component or may have a constitution in which a siloxane-based compound layer is formed on the surface of organic resin particles by a condensation reaction with an alkoxysiloxane-based compound.

It is not necessary for the surface of the organic resin particles to be fully coated with silica. It is preferable that the surface of the organic silica particles be coated such that the amount of silica is at least 0.5% by mass or more with respect to the total mass of the organic resin particles. That is, in a case where silica is present on at least a part of the surface of the organic resin particles, the affinity with a water-soluble polymer, for example, polyvinylalcohol (PVA), that also exists on the surface of the organic particles is improved. As a result, even though the particles are exposed to external stress, detachment of the particles is suppressed, which makes it possible to maintain excellent scratch resistance and ease of peeling during laminating without interleaving paper. Therefore, "silica-coated" includes a state where silica is present on at least a part of the surface of the organic resin particles.

The surface coating state of silica can be checked by morphological observation using a scanning electron microscope (SEM) or the like. In addition, the coating amount of silica can be checked by detecting Si atoms by elemental analysis such as X-ray fluorescence analysis and calculating the amount of silica present therein.

The manufacturing method of the silica-coated organic resin particles is not particularly limited, and may be a method of allowing silica particles or a silica precursor compound to coexist with a monomer component which is a raw material of organic resin particles to form organic resin particles and form a silica surface coating layer at the same time or a method of forming organic resin particles, then physically attaching silica particles, and then immobilizing the particles.

Hereinafter, an example of the manufacturing method of the silica-coated organic resin particles will be

described. First, silica and a raw material resin (more specifically, a raw material resin such as a suspension-polymerizable monomer, a suspension-crosslinkable prepolymer, or a resin liquid constituting the organic resin) are added to water containing a water-soluble polymer such as polyvinyl alcohol, methyl cellulose, or polyacrylic acid or suspension stabilizer appropriately selected from inorganic suspension agents such as calcium phosphate, calcium carbonate, and the like, followed by stirring and mixing to disperse silica and the raw material resin, thereby preparing a suspension. At this time, adjusting the type and concentration of suspension stabilizer, rotation speed for stirring, and the like makes it possible to form a suspension having a desired particle diameter. Thereafter, the suspension is heated such that a reaction is initiated and the resin raw material undergoes suspension polymerization or suspension crosslinking, thereby generating resin particles. At this time, the coexisting silica is immobilized on the resin particles that are cured by the polymerization or crosslinking reaction, particularly, in the vicinity of the surface of the resin particles due to the physical properties thereof. Then, the suspension is subjected to solid-liquid separation and washed to remove the suspension stabilizer having adhered to the particles, followed by drying. In this way, substantially spherical silica-coated organic resin particles with a desired particle diameter having immobilized silica are obtained.

As described above, by controlling the conditions during the suspension polymerization or the suspension crosslinking, it is possible to obtain silica-coated organic resin particles having a desired particle diameter. Alternatively, by generating silica-coated organic resin particles without strictly controlling such conditions and then filtering the particles through a mesh, it is possible to obtain silica-coated organic resin particles having a desired size.

Regarding the amount of raw materials added in the mixture used in manufacturing the silica-coated organic resin particles by the above method, for example, in a case where the total amount of the raw material resin and silica is 100 parts by mass, for example, an aspect is preferable in which 0.1 to 20 parts by mass of a suspension stabilizer is added first to 200 to 800 parts by mass of water which is a dispersion medium, thoroughly dissolving or dispersing the raw material resin and silica, 100 parts by mass of the aforementioned mixture of the raw material resin and silica is added to the obtained liquid, the liquid is stirred in a state where the stirring speed is being adjusted such that the dispersed particles have a predetermined particle size, the liquid temperature is raised to 30°C to 90°C after the particle size is adjusted, and the liquid is allowed have a reaction for 1 to 8 hours.

The above method is an example of the manufacturing method of the silica-coated organic resin particles. For example, silica-coated organic resin particles obtained, for example, by the methods specifically described in JP2002-327036A, JP2002-173410A, JP2004-307837A, JP2006-38246A, and the like can also be suitably used in the present invention.

The silica-coated organic resin particles are also available as a commercially available product. Specific examples of the silica/melamine composite particles include OPTBEADS 2000M, OPTBEADS 3500M, OPTBEADS 6500M, OPTBEADS 10500M, OPTBEADS 3500S, and OPTBEADS 6500S manufactured by Nissan Chemical Corporation. Examples of the silica/acryl composite particles include ART PEARL G-200 transparent, ART PEARL G-400 transparent, ART PEARL G-800 transparent, ART PEARL GR-400 transparent, ART PEARL GR-600 transparent, ART PEARLGR-800 transparent, and ART PEARL J-7P manufactured by Negami Chemical Industrial Co., Ltd. Examples of the silica/urethane composite particles include ART PEARL C-400 transparent, C-800 transparent, P-800T, U-600T, U-800T, CF-600T, and CF800T manufactured by Negami Chemical Industrial Co., Ltd., DYNAMIC BEADS CN5070D, and DANPLACOAT THU manufactured by Dainichiseika Color & Chemicals Mfg.Co., Ltd.

Organic resin particles were described as an example of the silica-coated organic resin particles. Organic resin particles coated with alumina, titania, or zirconia can be manufactured by the same method by using alumina, titania, or zirconia instead of silica.

It is preferable that the aforementioned particles have a perfectly spherical shape. The aforementioned particles may have a flat plate shape or so-called spindle shape that looks like an ellipse in a projection view.

In the aspect 1, the average particle diameter of the particles is preferably 0.5 to 10 μm, more preferably 1.0 to 10 μm, and even more preferably 2.0 to 7.0 μm.

The average particle diameter of particles means a volume average particle diameter. The volume average particle diameter is measured with a laser diffraction/scattering-type particle size distribution analyzer. Specifically, a particle size distribution analyzer "MICROTRAC MT-3300II" (manufactured by Nikkiso Co., Ltd.) is used for measurement, and a median diameter (D50) obtained by the measurement is adopted as an average particle diameter.

For other particles, unless otherwise specified, the average particle diameter is measured by the above measuring method.

In the aspect 1, an in-plane density of particles having an average particle diameter of 0.5 to 20 μm is preferably 10,000 particles/$mm^2$ or less. The in-plane density is more preferably 100 to 5,000 particles/$mm^2$, and even more preferably 100 to 3,000 particles/$mm^2$.

The in-plane density can be checked by observing the surface of the lithographic printing plate precursor with a scanning electron microscope (SEM). Specifically, five sites within the surface of the lithographic printing plate precursor re observed with a scanning electron microscope (SEM), the number of particles is counted and converted into the number of particles per area ($mm^2$) of the visual field of observation, and the average thereof is calculated. In this way, the in-plane

density can be determined.

The particles having an average particle diameter of 0.5 to 20 μm include the aforementioned particles as well as particles having an average particle diameter of 0.5 to 20 μm in the polymer particles as a binder that will be described later.

It is preferable that the outermost layer on the side opposite to the side where the specific constitutional layer is provided contain a binder, in addition to the particles having an average particle diameter of 0.5 to 20 μm.

The binder preferably contains at least one compound selected from the group consisting of a novolac or resol resin such as a phenolformaldehyde resin, an m-cresol formaldehyde resin, a p-cresol formaldehyde resin, an m-/p-mixed cresol formaldehyde resin, or a phenol/cresol (which may be any of m-, p-, or m-/p-mixed) mixed formaldehyde resin, pyrogallol, an acetone resin, an epoxy resin, a saturated copolymerized polyester resin, a phenoxy resin, a polyvinyl acetal resin, a vinylidene chloride copolymer resin, polybutene, polybutadiene, polyamide, an unsaturated copolymerized polyester resin, polyurethane, polyurea, polyimide, polysiloxane, polycarbonate, an epoxy resin, chlorinated polyethylene, an aldehyde condensation resin of alkylphenol, polyvinyl chloride, polyvinylidene chloride, polystyrene, polyacrylate, a carboxyvinyl polymer, an acrylic resin copolymer resin, hydroxycellulose, hydroxymethylcellulose, polyvinyl alcohol, polyvinylpyrrolidone, cellulose acetate, methylcellulose, and carboxymethylcellulose. In order to prevent concerns on dissolution in dampening water during on-press development, a water-insoluble resin is preferable.

In addition, the binder preferably contains at least one compound selected from the group consisting of polyurethane, an acrylic resin, polystyrene, and polyethylene.

Furthermore, in the aspect 1, it is preferable that the aforementioned particles and the binder each independently contain at least one compound selected from the group consisting of polyurethane, an acrylic resin, polystyrene, and polyethylene.

The outermost layer on the side opposite to the side where the specific constitutional layer is provided may contain other components in addition to the particles and the binder. Examples of those other components include known additives, such as a surfactant.

The thickness of the outermost layer on the side opposite to the side where the specific constitutional layer is provided is preferably 0.5 to 10 μm, more preferably 0.5 to 5 μm, and even more preferably 0.5 to 3 μm.

The polymer compound configuring the plurality of protrusions containing a polymer compound as a main component in the aspect 2 preferably contains at least one polymer compound selected from the group consisting of a novolac or resol resin such as a phenolformaldehyde resin, an m-cresol formaldehyde resin, a p-cresol formaldehyde resin, an m-/p-mixed cresol formaldehyde resin, or a phenol/cresol (which may be any of m-, p-, or m-/p-mixed) mixed formaldehyde resin, pyrogallol, an acetone resin, an epoxy resin, a saturated copolymerized polyester resin, a phenoxy resin, a polyvinyl acetal resin, a vinylidene chloride copolymer resin, polybutene, polybutadiene, polyamide, an unsaturated copolymerized polyester resin, polyurethane, polyurea, polyimide, polysiloxane, polycarbonate, an epoxy resin, chlorinated polyethylene, an aldehyde condensation resin of alkylphenol, polyvinyl chloride, polyvinylidene chloride, polystyrene, polyacrylate, a carboxyvinyl polymer, an acrylic resin copolymer resin, hydroxycellulose, hydroxymethylcellulose, polyvinyl alcohol, polyvinylpyrrolidone, cellulose acetate, methylcellulose, and carboxymethylcellulose.

Among these, from the viewpoint of causing excellent developability to be exhibited even in a case where the detached protrusions move to the image-recording layer, a water-soluble polymer is more preferable. Specific examples thereof include polyacrylate, a carboxyvinyl polymer, an acrylic resin copolymer resin, hydroxycellulose, hydroxymethyl cellulose, polyvinyl alcohol, modified polyvinyl alcohol, polyvinylpyrrolidone, cellulose acetate, methylcellulose, carboxymethyl cellulose, and the like.

As the modified polyvinyl alcohol, acid-modified polyvinyl alcohol having a carboxy group or a sulfo group is preferably used. Specifically, the modified polyvinyl alcohols described in JP2005-250216A and JP2006-259137A are suitable.

The shape and height of the protrusions are not particularly limited, but the arithmetic mean height Sa is preferably 0.3 to 20 μm.

The method of forming protrusions in a stripe pattern (stripe coating film) is not particularly limited. It is possible to easily form such protrusions by performing coating with a composition containing at least one component selected from the group consisting of particles and a polymer compound, by at least one method selected from the group consisting of a bar coating method, an ink jet printing method, a gravure printing method, a screen printing method, a spray coating method, and a slot die coating method.

The method of forming protrusions in a dot pattern (dot coating film) is not particularly limited. It is possible to easily form such protrusions by performing coating with a composition containing at least one component selected from the group consisting of particles and a polymer compound, by at least one method selected from the group consisting of a spray coating method, an ink jet printing method, and a screen printing method.

The method of forming protrusions in a broken line pattern (broken line coating film) is not particularly limited. It is possible to easily form such protrusions by performing coating with a composition containing at least one component selected from the group consisting of particles and a polymer compound, by at least one method selected from the group consisting of an ink jet printing method and a screen printing method.

Examples of the binder contained in the outermost layer in the aspect 2 include the same polymer compound as the polymer compound contained in the protrusions, and preferred aspects thereof are also identical.
In the aspect 2, from the viewpoint of preventing the detachment of the protrusions, it is preferable that the binder contained in the outermost layer and the polymer compound contained in the protrusions contain the same type of resin. The "same type of resin" means that the types of resins, such as polyurethane, an acrylic resin, polystyrene, and polyethylene, are identical, and it is not necessary for all the constitutional units in the resins to be the same as each other.
In one aspect, it is preferable that the image-recording layer contain at least one kind of particles having an average particle diameter of 0.5 μm or more and 20 μm or less.
In addition, it is preferable that the image-recording layer contain at least two kinds of particles having an average particle diameter of 0.5 μm or more and 20 μm or less and having different average particle diameters.
In another aspect, it is preferable that the protective layer contain at least one kind of particles having an average particle diameter of 0.5 μm or more and 20 μm or less.
In still another aspect, it is preferable that the outermost layer on the side opposite to the side provided with the at least one layer containing an infrared absorber with reference to the support contain at least one kind of particles having an average particle diameter of 0.5 μm or more and 20 μm or less.

[Lithographic printing plate precursor]

Hereinafter, one aspect of the lithographic printing plate precursor constituting the laminate of lithographic printing plate precursors according to an embodiment of the present invention will be described.
The lithographic printing plate precursor has an image-recording layer on the aforementioned hydrophilic support.

[Image-recording layer]

According to a preferred form of the image-recording layer in the lithographic printing plate precursor, the image-recording layer contains a polymerization initiator, a polymerizable compound, and a polymer compound. It is preferable that the image-recording layer further contain an infrared absorber and a chain transfer agent.
According to another preferred form of the image-recording layer, the image-recording layer contains thermally fusible particles and a binder polymer. It is preferable that the image-recording layer further contain an infrared absorber.

(Polymerization initiator)

The polymerization initiator is a compound that generates a polymerization initiation species such as a radical or a cation by either or both of light energy and heat energy. The polymerization initiator to be used can be appropriately selected from known thermal polymerization initiators, compounds having a bond that requires low bond dissociation energy, photopolymerization initiators, and the like.
As the photopolymerization initiator, an infrared-sensitive photopolymerization initiator is preferable. In addition, as the polymerization initiator, a radical polymerization initiator is preferable. Two or more radical polymerization initiators may be used in combination.
The radical polymerization initiator may be either an electron-accepting polymerization initiator or an electron-donating polymerization initiator.

<Electronic-accepting polymerization initiator>

Examples of the electron-accepting polymerization initiator include an organic halide, a carbonyl compound, an azo compound, an organic peroxide, a metallocene compound, an azide compound, a hexaarylbiimidazole compound, a disulfone compound, an oxime ester compound, and an onium salt compound.
As the organic halide, for example, the compounds described in paragraphs "0022" and" 0023" of JP2008-195018A are preferable.
As the carbonyl compound, for example, the compounds described in paragraph "0024" of JP2008-195018A are preferable.
Examples of the azo compound include the azo compounds described in JP1996-108621A (JP-H08-108621A), and the like.
As the organic peroxide, for example, the compounds described in paragraph "0025" of JP2008-195018A are preferable.
As the metallocene compound, for example, the compounds described in paragraph "0026" of JP2008-195018A are preferable.

Examples of the azide compound include compounds such as 2,6-bis(4-azidobenzylidene)-4-methylcyclohexanone.

As the hexaarylbiimidazole compound, for example, the compounds described in paragraph "0027" of JP2008-195018A are preferable.

Examples of the disulfone compound include the compounds described in JP1986-166544A (JP-S61-166544A) and JP2002-328465A.

As the oxime ester compound, for example, the compounds described in paragraphs "0028" to "0030" of JP2008-195018A are preferable.

Among the electron-accepting polymerization initiators, for example, an include onium such as an iodonium salt, a sulfonium salt, or an azinium salt is preferable. Among these, an iodonium salt and a sulfonium salt are particularly preferable. Specific examples of the iodonium salt and the sulfonium salt will be shown below, but the present invention is not limited thereto.

As the iodonium salt, for example, a diphenyliodonium salt is preferable. Particularly, a diphenyl iodonium salt having an electron-donating group, for example, a diphenyl iodonium salt substituted with an alkyl group or an alkoxyl group is preferable, and an asymmetric diphenyl iodonium salt is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=-hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

As the sulfonium salt, for example, a triarylsulfonium salt is preferable. Particularly, a triarylsulfonium salt having an electron withdrawing group as a substituent, for example, a triarylsulfonium salt is preferable in which at least some of the groups on an aromatic ring are substituted with halogen atoms, and a triarylsulfonium salt is more preferable in which the total number of halogen atoms as substituents on an aromatic ring is 4 or more. Specific examples thereof include triphenylsulfonium=hexafluorophosphate, triphenylsulfonium=benzoyl formate, bis(4-chlorophenyl)phenylsulfonium=-benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, and tris(2,4-dichlorophenyl)sulfonium=hexafluorophosphate.

One electron-accepting polymerization initiator may be used alone, or two or more electron-accepting polymerization initiators may be used in combination.

The content of the electron-accepting polymerization initiator with respect to the total solid content of the image-recording layer is preferably 0.1% to 50% by mass, more preferably 0.5% to 30% by mass, and even more preferably 0.8% to 20% by mass.

<Electron-donating polymerization initiator>

The electron-donating polymerization initiator contributes to the improvement of printing durability of a lithographic printing plate prepared from the lithographic printing plate precursor. Examples of the electron-donating polymerization initiator include the following five initiators. (i) Alkyl or arylate complex: considered to generate active radicals by oxidative cleavage of carbon-hetero bond. Specific examples thereof include a borate compound and the like. (ii) Amino acetate compound: considered to generate active radicals by oxidation-induced cleavage of C-X bond on carbon adjacent to nitrogen. X is preferably a hydrogen atom, a carboxy group, a trimethylsilyl group, or a benzyl group. Specific examples thereof include N-phenylglycines (which may have a substituent in a phenyl group), N-phenyl iminodiacetic acid (which may have a substituent in a phenyl group), and the like. (iii) Sulfur-containing compound: compound obtained by substituting nitrogen atoms of the aforementioned amino acetate compound with sulfur atoms and capable of generating active radicals by the same action as that of the amino acetate compound. Specific examples thereof include phenylthioacetic acid (which may have a substituent on a phenyl group) and the like. (iv) Sulfur-containing compound: compound obtained by substituting nitrogen atoms of the aforementioned amino acetate compound with tin atoms and capable of generating active radicals by the same action as that of the amino acetate compound. (v) Sulfinates: capable of generating active radicals by oxidation. Specific examples thereof include sodium aryl sulfinate and the like.

Among the electron-donating polymerization initiators, a borate compound is preferable. As the borate compound, a tetraaryl borate compound or a monoalkyltriaryl borate compound is preferable. From the viewpoint of compound stability, a tetraaryl borate compound is more preferable.

A countercation that the borate compound has is preferably an alkali metal ion or a tetraalkyl ammonium ion, and more preferably a sodium ion, a potassium ion, or a tetrabutylammonium ion.

Specific examples of the borate compound include the following compounds. In the following compounds, $X_c^+$ represents a monovalent cation, which is preferably alkali metal ion or a tetraalkylammonium ion, and more preferably an alkali metal ion or a tetrabutylammonium ion. Bu represents an n-butyl group.

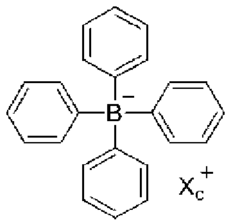
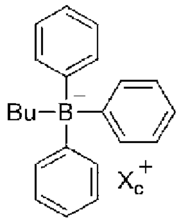
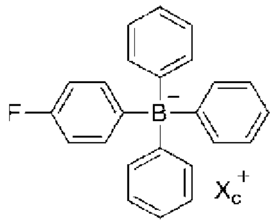
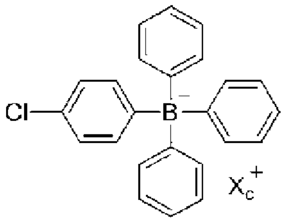

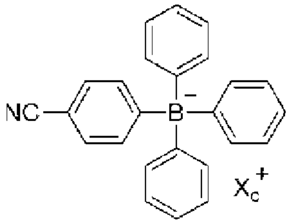
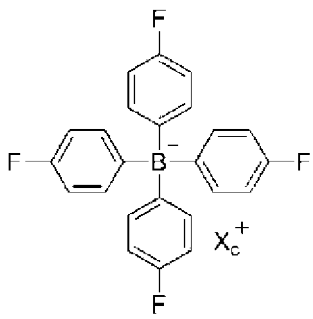
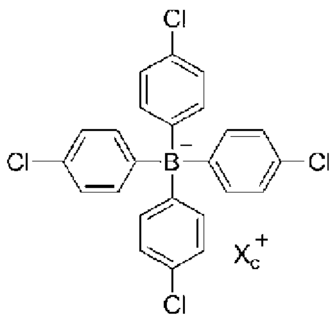

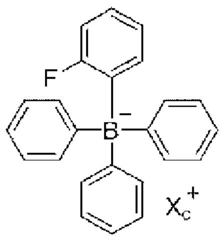
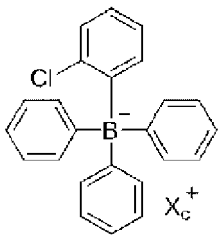
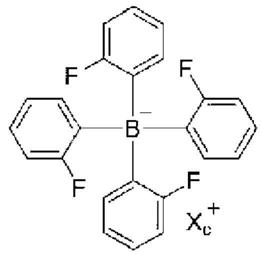

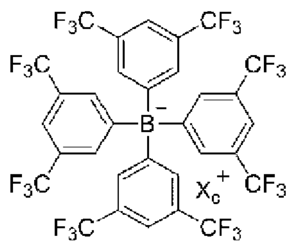

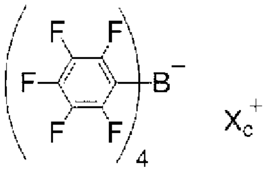
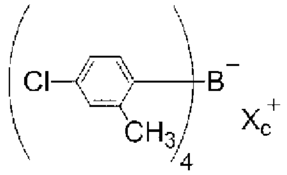
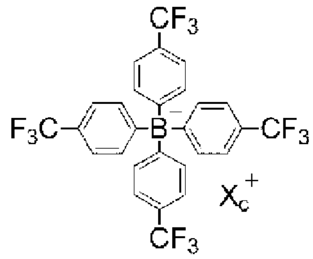
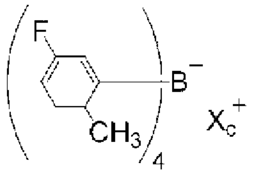
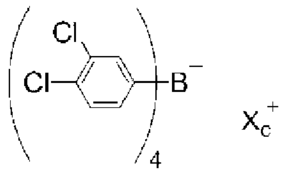
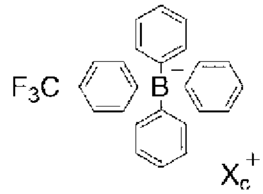
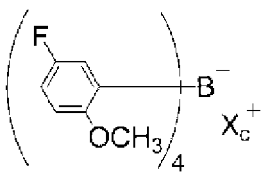
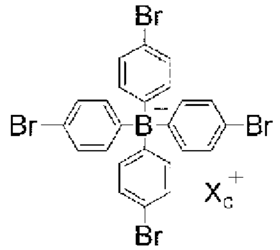
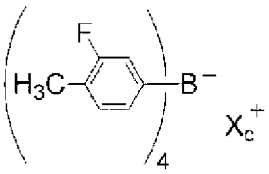
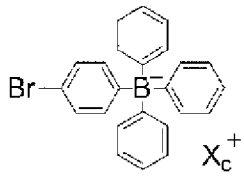
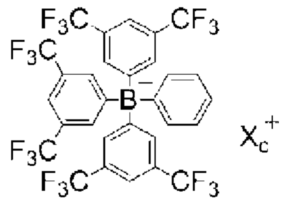
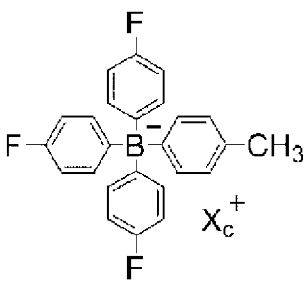
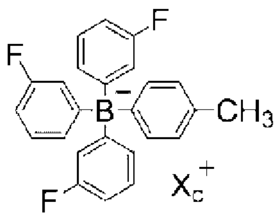
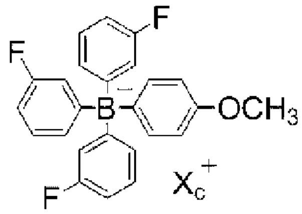
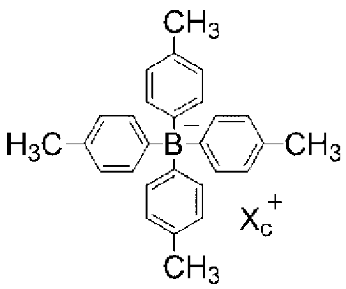
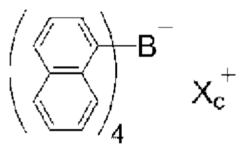
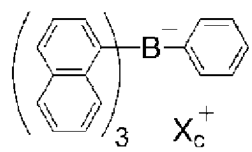

One electron-donating polymerization initiator may be used alone, or two or more electron-donating polymerization initiators may be used in combination.

The content of the electron-donating polymerization initiator with respect to the total solid content of the image-recording layer is preferably 0.01% to 30% by mass, more preferably 0.05% to 25% by mass, and even more preferably 0.1% to 20% by mass.

(Polymerizable compound)

The polymerizable compound may be, for example, a radically polymerizable compound or a cationically

polymerizable compound. As the polymerizable compound, an addition polymerizable compound having at least one ethylenically unsaturated bond (ethylenically unsaturated compound) is preferable. The ethylenically unsaturated compound is preferably a compound having at least one ethylenically unsaturated bond on a terminal, and more preferably a compound having two or more ethylenically unsaturated bonds on a terminal. The polymerizable compound can have a chemical form such as a monomer or a prepolymer, that is, a dimer, a trimer, an oligomer, a mixture of these, or the like.

Examples of the monomer include unsaturated carboxylic acids (for example, acrylic acid, methacrylic acid, itaconic acid, crotonic acid, isocrotonic acid, and maleic acid), and esters and amides thereof. It is preferable to use esters of an unsaturated carboxylic acid and a polyhydric alcohol compound, or amides of an unsaturated carboxylic acid and a polyvalent amine compound. In addition, products of an addition reactant of unsaturated carboxylic acid esters or amides having a nucleophilic substituent such as a hydroxy group, an amino group, or a mercapto group and monofunctional or polyfunctional isocyanates or epoxies, a dehydrocondensation reactant of the aforementioned unsaturated carboxylic acid esters or amides and a monofunctional or polyfunctional carboxylic acid, and the like are also suitably used. Furthermore, an addition reactant of unsaturated carboxylic acid esters or amides having an electrophilic substituent such as an isocyanate group or an epoxy group and monofunctional or polyfunctional alcohols, amines, or thiols, and a substitution reactant of unsaturated carboxylic acid esters or amides having a dissociable substituent such as a halogen atom or a tosyloxy group and monofunctional or polyfunctional alcohols, amines, or thiols are also suitable. Moreover, for example, it is also possible to use a group of compounds obtained by substituting the unsaturated carboxylic acid with an unsaturated phosphonic acid, styrene, vinyl ether, or the like. These compounds are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-64130A, JP2003-280187A, JP1998-333321A (JP-H10-333321A), and the like.

Specific examples of monomers of esters of polyhydric alcohol compounds and unsaturated carboxylic acids include acrylic acid esters such as ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, and polyester acrylate oligomers, and methacrylic acid esters such as tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl] dimethyl methane, and bis[p-(methacryloxyethoxy)phenyl] dimethyl methane. In addition, specific examples of monomers of amides of polyvalent amine compounds and unsaturated carboxylic acids include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, xylylene bismethacrylamide, and the like.

In addition, urethane-based addition polymerizable compounds manufactured using an addition reaction between an isocyanate and a hydroxy group are also suitable, and specific examples thereof include vinyl urethane compounds having two or more polymerizable vinyl groups in one molecule obtained by adding vinyl monomers containing a hydroxy group represented by the following Formula (M) to a polyisocyanate compound having two or more isocyanate groups in one molecule which is described in, for example, JP1973-41708B (JP-S48-41708B).

$$CH_2=C(RM^4)COOCH_2CH(R^{M5})OH \qquad (M)$$

In Formula (M), $R^{M4}$ and $R^{M5}$ each independently represent a hydrogen atom or a methyl group.

Furthermore, urethane acrylates described in JP1976-37193A (JP-S51-37193A), JP1990-32293B (JP-H02-32293B), JP1990-16765B (JP-H02-16765B), JP2003-344997A, and JP2006-65210A; urethane compounds having an ethylene oxide-based skeleton described in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-94138A; and urethane compounds having a hydrophilic group described in US7153632B, JP1996-505958A (JP-H08-505958A), JP2007-293221A, and JP2007-293223A are also suitable.

Details of how to use the polymerizable compound, such as the structure of the compound, whether the compound is used alone or used in combination with other compounds, and the amount of the compound to be added, can be randomly set in consideration of the final use of the lithographic printing plate precursor or the like.

The content of the polymerizable compound with respect to the total solid content of the image-recording layer is preferably 1% to 50% by mass, more preferably 3% to 30% by mass, and even more preferably 5% to 20% by mass.

(Polymer compound)

The polymer compound may function as a binder polymer of the image-recording layer, or may be present in the image-recording layer as a particle-shaped polymer compound (polymer particles).

<Binder polymer>

As the binder polymer, a polymer having film forming properties is preferable, and preferred examples thereof include a (meth)acrylic resin, a polyvinyl acetal resin, a polyurethane resin, and the like.

As the binder polymer used in the image-recording layer, a binder polymer having an alkylene oxide chain is preferable. The binder polymer having an alkylene oxide chain may have a poly(alkylene oxide) moiety on a main chain or side chain. In addition, the binder polymer may be a graft polymer having poly(alkylene oxide) moiety on a side chain or a block copolymer of a block configured with a poly(alkylene oxide) moiety-containing repeating unit and a block configured with an (alkylene oxide) moiety-free repeating unit.

As a binder polymer having a poly(alkylene oxide) moiety on a main chain, a polyurethane resin is preferable. In a case where the binder polymer has a poly(alkylene oxide) moiety on a side chain, examples of polymers as the main chain include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber. Among these, a (meth)acrylic resin is particularly preferable.

As the alkylene oxide, an alkylene oxide having 2 to 6 carbon atoms is preferable, and ethylene oxide or propylene oxide is particularly preferable.

The number of repetitions of alkylene oxide in the poly(alkylene oxide) moiety is preferably 2 to 120, more preferably 2 to 70, and even more preferably 2 to 50.

It is preferable that the number of repetitions of alkylene oxide be 120 or less, because then printing durability deterioration resulting from abrasion and printing durability deterioration resulting from deterioration of ink receiving properties are suppressed.

The poly(alkylene oxide) moiety is preferably contained in the binder polymer as a side chain of the binder polymer in the form of a structure represented by Formula (AO), and more preferably contained in the binder polymer as a side chain of a (meth)acrylic resin in the form of a structure represented by Formula (AO).

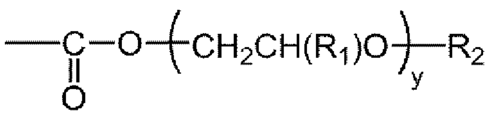

( AO )

In Formula (AO), y represents 2 to 120, $R_1$ represents a hydrogen atom or an alkyl group, and $R_2$ represents a hydrogen atom or a monovalent organic group.

As the monovalent organic group, an alkyl group having 1 to 6 carbon atoms is preferable. Specifically, examples thereof include a methyl group, an ethyl group, an n-propyl group, an isopropyl group, an n-butyl group, a sec-butyl group, an isobutyl group, a tert-butyl group, an n-pentyl group, an isopentyl group, a neopentyl group, an n-hexyl group, an isohexyl group, a 1,1-dimethylbutyl group, a 2,2-dimethylbutyl group, a cyclopentyl group, and a cyclohexyl group.

In Formula (AO), y is preferably 2 to 70, and more preferably 2 to 50. $R_1$ is preferably a hydrogen atom or a methyl group, and particularly preferably a hydrogen atom. $R_2$ is particularly preferably a hydrogen atom or a methyl group.

In order to enhance the film hardness of an image area, the binder polymer may have crosslinking properties. In order to impart crosslinking properties to the polymer, a crosslinking functional group such as an ethylenically unsaturated bond may be introduced into a main chain or a side chain of the polymer. The crosslinking functional group may be introduced by either copolymerization or a polymer reaction.

Examples of the polymer having an ethylenically unsaturated bond on a main chain of the molecule include poly-1,4-butadiene, poly-1,4-isoprene, and the like.

Examples of the polymer having an ethylenically unsaturated bond on a side chain of the molecule include a polymer of an ester or amide of an acrylic or methacrylic acid in which a residue of the ester or amide (R of -COOR or -CONHR) has an ethylenically unsaturated bond.

Examples of the residue (R described above) having an ethylenically unsaturated bond include-$(CH_2)_nCR^{1A}=CR^{2A}R^{3A}$,-$(CH_2O)_nCH_2CR^{1A}=CR^{2A}R^{3A}$,-$(CH_2CH_2O)_nCH_2CR^{1A}=CR^{2A}R^{3A}$ -$(CH_2)_nNH$-CO-O-$CH_2CR^{1A}$-$CR^{2A}R^{3A}$,-$(CH_2)_n$-O-CO-$CR^{1A}$-- $CR^{2A}R^{3A}$, and -$(CH_2CH_2O)_2$-$X^A$ (in the formulas, $R^{A1}$ to $R^{A3}$ each independently represent a hydrogen atom, a halogen atom, an alkyl group having 1 to 20 carbon atoms, an aryl group, an alkoxy group, or an aryloxy group, $R^{A1}$ and $R^{A2}$ or $R^{A3}$ may be bonded to each other to form a ring, n represents an integer of 1 to 10, and $X^A$ represents a dicyclopentadienyl residue).

Specific examples of the ester residue include -$CH_2CH=CH_2$, -$CH_2CH_2O$-$CH_2CH=CH_2$, -$CH_2C(CH_3)=CH_2$, -$CH_2CH$=CH-C6H5, -CH2CH2OCOCH=CH-$C_6H_5$, -$CH_2CH_2$-NHCOO-$CH_2CH=CH_2$, and -$CH_2CH_2O$-X (in the formula, X represents a cyclopentadienyl residue). Specific examples of the amide residue include -$CH_2CH=CH_2$, -$CH_2CH_2$-Y (in the formula, Y represents a cyclohexene residue), and -$CH_2CH_2$-OCO-CH=$CH_2$.

For example, free radicals (polymerization initiating radicals or growing radicals in a polymerization process of a

polymerizable compound) are added to crosslinking functional groups of the binder polymer having crosslinking properties, the polymers are addition-polymerized directly or via polymerization chains of polymerizable compounds, and crosslinks are formed between the polymer molecules, which cures the binder polymer. Alternatively, atoms in the polymer (for example, hydrogen atoms on carbon atoms adjacent to a functional crosslinking group) are abstracted by free radicals to generate polymer radicals, and the polymer radicals are bonded to each other, which forms crosslinks between the polymer molecules and cure the binder polymer.

From the viewpoint of excellent sensitivity and excellent storage stability, the content of the crosslinking group (content of the unsaturated double bond capable of being radically polymerized by iodine titration) in the binder polymer per 1 g of the binder polymer is preferably 0.1 to 10.0 mmol, more preferably 1.0 to 7.0 mmol, and even more preferably 2.0 to 5.5 mmol.

Specific examples 1 to 11 of the binder polymer will be shown below, but the present invention is not limited thereto. In the following exemplary compounds, the numerical value written together with each repeating unit (the numerical value written together with the main chain repeating unit) represents the molar percentage of the repeating unit. The numerical value written together with the repeating unit of the side chain means the number of repetitions of the repeating moiety. In addition, Me represents a methyl group, Et represents an ethyl group, and Ph represents a phenyl group.

(1) 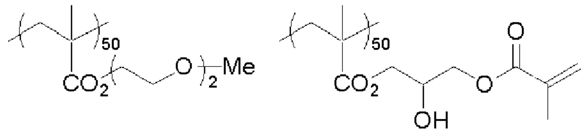

(2) 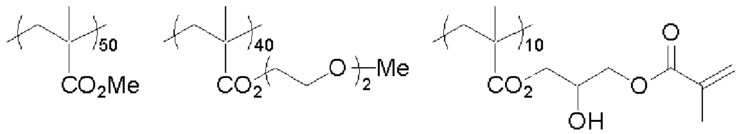

(3) 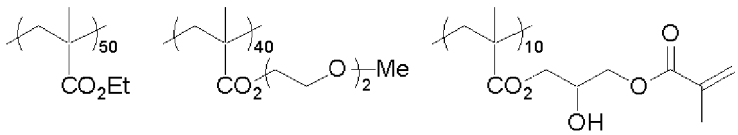

(4) 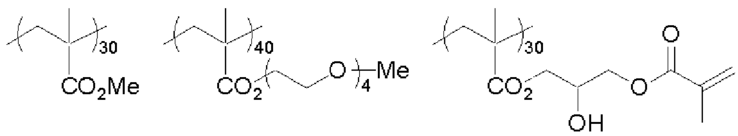

(5) 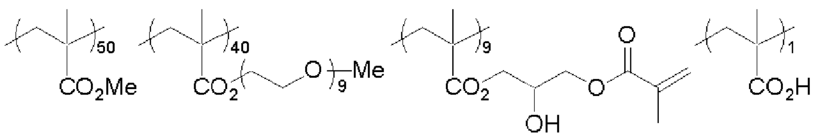

(6) 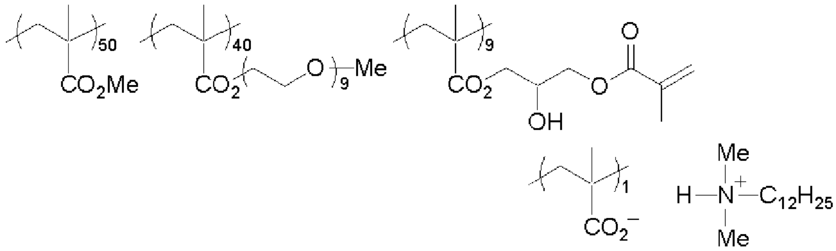

(7) 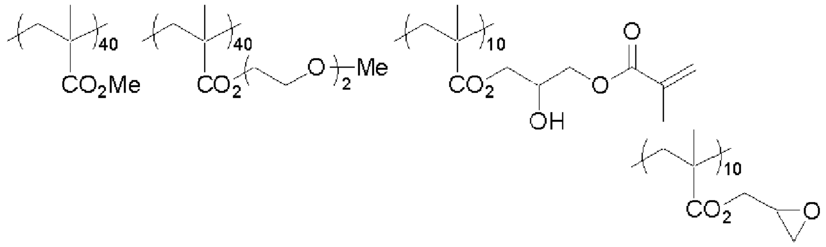

(8) 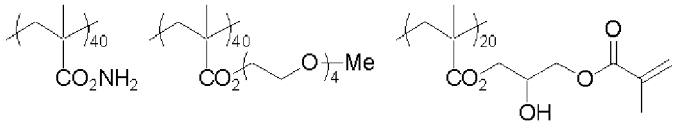

(9) 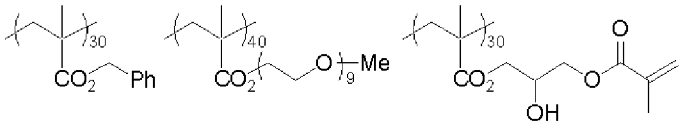

(10) 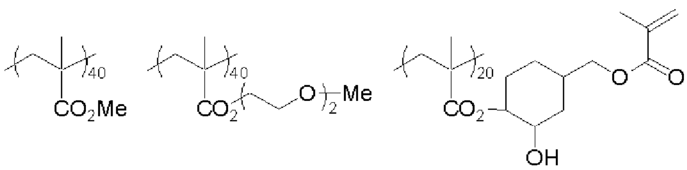

(11) 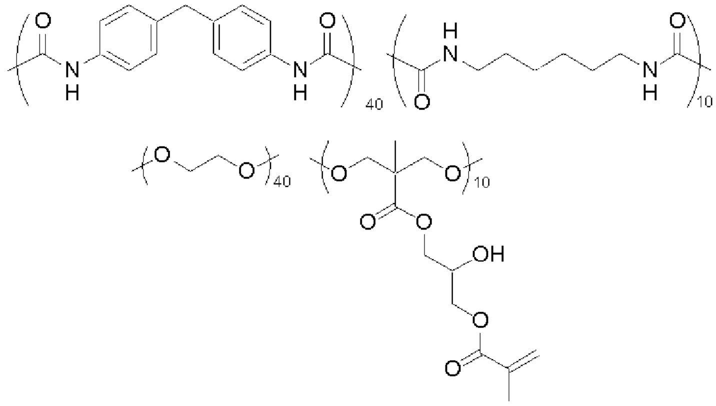

The molecular weight of the binder polymer that is a polystyrene-equivalent mass-average molecular weight (Mw) determined by GPC is preferably 2,000 or more, more preferably 5,000 or more, and even more preferably 10,000 to 300,000.

As necessary, a hydrophilic polymer such as polyacrylic acid or polyvinyl alcohol described in JP2008-195018A can be used in combination. In addition, a lipophilic polymer and a hydrophilic polymer can be used in combination.

One binder polymer may be used alone, or two or more binder polymers may be used in combination.

The content of the binder polymer in the total solid content of the image-recording layer is preferably 1% to 90% by mass, and more preferably 5% to 80% by mass.

<Polymer particles>

It is preferable that the image-recording layer contain polymer particles. The polymer particles contribute to the improvement of on-press developability. The polymer particles are preferably polymer particles that can convert the image-recording layer into hydrophobic when heat is applied thereto. The polymer particles are preferably at least one kind of particles selected from hydrophobic thermoplastic polymer particles, thermal reactive polymer particles, polymer particles having a polymerizable group, microcapsules encapsulating a hydrophobic compound, and a microgel (cross-linked polymer particles).

Suitable examples of the hydrophobic thermoplastic polymer particles include the hydrophobic thermoplastic polymer particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), EP931647B, and the like.

Specific examples of polymers constituting the hydrophobic thermoplastic polymer particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and mixtures of these. For example, copolymers having polystyrene, styrene, and acrylonitrile or polymethyl methacrylate are preferable. The average particle diameter of the hydrophobic thermoplastic polymer particles is preferably 0.01 to 2.0 μm.

Examples of the thermal reactive polymer particles include polymer particles having a thermal reactive group. The polymer particles having a thermal reactive group form a hydrophobic region through crosslinking by a thermal reaction and the accompanying change in functional groups.

As the thermal reactive group in the polymer particles having a thermal reactive group, any functional group performing any reaction may be used as long as a chemical bond is formed. As the thermal reactive group, a polymerizable group is preferable. Suitable examples of the thermal reactive group include an ethylenically unsaturated group that causes a radical polymerization reaction (for example, an acryloyl group, a methacryloyl group, a vinyl group, an allyl groups, and the like), a cationically polymerizable group (for example, a vinyl group, a vinyloxy group, an epoxy group, an oxetanyl group, and the like), an isocyanate group or a blocked isocyanate group that causes an addition reaction, an epoxy group, a vinyloxy group, an active hydrogen atom-containing functional group that is a reaction partner thereof (for example, an amino group, a hydroxy group, a carboxy group, and the like), a carboxy group that causes a condensation reaction, a hydroxy group or an amino group that is a reaction partner of the carboxy group, an acid anhydride that causes a ring-opening addition reaction, an amino group or a hydroxy group which is a reaction partner of the acid anhydride, and the like.

Examples of the microcapsules include microcapsules encapsulating all or some of the constituent components of the image-recording layer as described in JP2001-277740A and JP2001-277742A. The constituent components of the image-recording layer can also be incorporated into the exterior of the microcapsules. In a preferred aspect of the image-recording layer containing microcapsules, hydrophobic constituent components are encapsulated in the microcapsules and hydrophilic constituent components are incorporated into the exterior of the microcapsules.

The microgel (crosslinked polymer particles) can contain some of the constituent components of the image-recording layer, in at least one of the interior or the surface of the microgel. Particularly, from the viewpoint of sensitivity in image formation and printing durability, an aspect is preferable in which a radically polymerizable group is incorporated into the surface thereof to form a reactive microgel.

In order to encapsulate the constituent components of the image-recording layer in microcapsules or microgel, known methods can be used.

The average particle diameter of the microcapsules or microgel is preferably 0.01 to 3.0 μm, more preferably 0.05 to 2.0 μm, and particularly preferably 0.10 to 1.0 μm. In a case where the average particle diameter is in this range, excellent resolution and temporal stability are obtained.

One kind of polymer particles may be used alone, or two or more kinds of polymer particles may be used in combination.

The content of the polymer particles in the total solid content of the image-recording layer is preferably 5% to 90% by mass, more preferably 5% to 80% by mass, and even more preferably 10% to 75% by mass.

As the polymer compound contained in the image-recording layer, a polymer compound containing at least either a constitutional unit derived from a styrene compound or a constitutional unit derived from an acrylonitrile compound is also preferable. From the viewpoint of contribution to on-press developability, this polymer compound can be suitably used as a binder polymer or as polymer particles.

Examples of the styrene compound include styrene, p-methylstyrene, p-methoxystyrene, β-methylstyrene, p-methyl-β-methylstyrene, α-methylstyrene, p-methoxy-β-methylstyrene, and the like. Among these, styrene is preferable.

Examples of the acrylonitrile compound include acrylonitrile, methacrylonitrile, and the like. Among these, acrylonitrile is preferable.

In the polymer compound containing a styrene compound and an acrylonitrile compound as constitutional units, a compositional ratio between the constitutional unit derived from the styrene compound and the constitutional unit derived from the acrylonitrile compound is preferably 4:1 to 1:4.
In addition, the polymer compound preferably contains at least a polyvinyl butyral resin.
The image-recording layer can contain an infrared absorber.

(Infrared absorber)

The aforementioned infrared absorber is the aforementioned specific infrared absorber or an infrared absorber other than the specific infrared absorber (also called "another infrared absorber").
In a case where at least one layer containing the specific infrared absorber is an image forming layer, the infrared absorber is the specific infrared absorber. Unless the effects of the present invention are impaired, the image forming layer may have another infrared absorber.

<Another infrared absorber>

The aforementioned another infrared absorber is an infrared absorber other than the specific infrared absorber, which is a compound having a HOMO more than -5.43 eV.
As the dye, it is possible to use commercially available dyes and known dyes described in publications such as "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.
Among dyes, a cyanine dye, a squarylium colorant, or a pyrylium salt is preferable, a cyanine dye is more preferable, and an indolenine cyanine dye is particularly preferable.
Specific examples of the cyanine dye include the compounds described in paragraphs "0017" to "0019" of JP2001-133969A and the compounds described in paragraphs "0016" to "0021" of JP2002-023360A and paragraphs "0012" to "0037" of JP2002-040638A. As the cyanine dye, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A are particularly preferable.
Furthermore, the compounds described in paragraphs "0008" and "0009" of JP1993-5005A (JP-H05-5005A) and paragraphs "0022" to "0025" of JP2001-222101A can also be preferably used.
As pigments, the compounds described in paragraphs "0072" and" 0076" of JP2008-195018A are preferable.
In a case where the image forming layer does not contain the specific infrared absorber and contains another infrared absorber, one infrared absorber may be used alone as such another infrared absorber, or two or more infrared absorbers may be used in combination as such another infrared absorber.
The content of the aforementioned another infrared absorber in the total solid content of the image-recording layer is preferably 0.05% to 30% by mass, more preferably 0.1% to 20% by mass, and even more preferably 0.2% to 10% by mass.
In a case where the image forming layer contains the specific infrared absorber, the image forming layer may or may not have another infrared absorber. It is preferable that the image forming layer do not have another infrared absorber.
The image-recording layer can contain a chain transfer agent, a low-molecular-weight hydrophilic compound, an oil sensitizing agent, and other components.

(Chain transfer agent)

The chain transfer agent contributes to the improvement of printing durability of the lithographic printing plate prepared from the lithographic printing plate precursor.
As the chain transfer agent, a thiol compound is preferable, a thiol having 7 or more carbon atoms is more preferable from the viewpoint of boiling point (low volatility), and a compound having a mercapto group on an aromatic ring (aromatic thiol compound) is even more preferable. The thiol compound is preferably a monofunctional thiol compound.
Specific examples of the chain transfer agent include the following compounds.

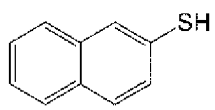

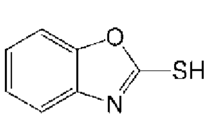 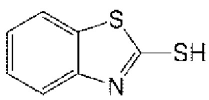 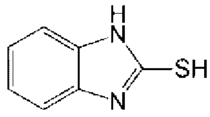

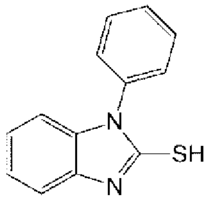 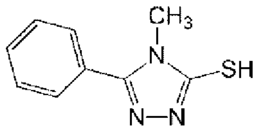 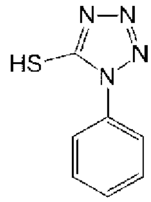

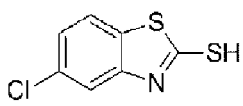 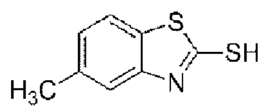 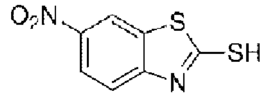 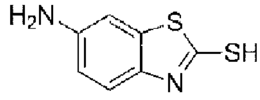

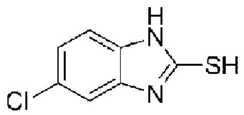 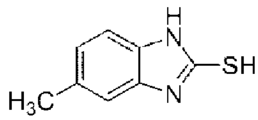 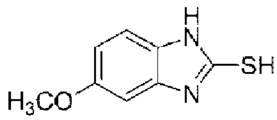 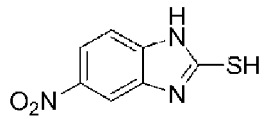

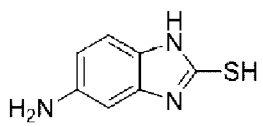 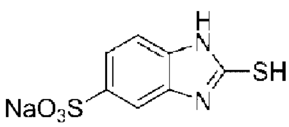 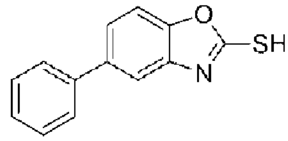

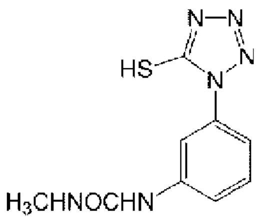 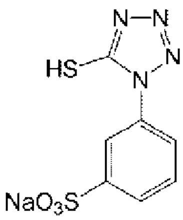

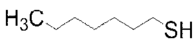 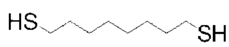

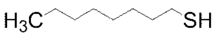 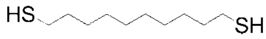
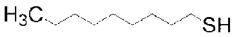 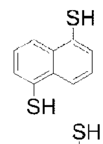 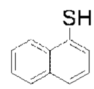
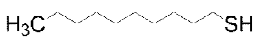
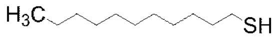
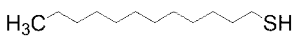 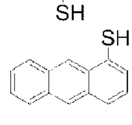 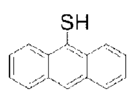
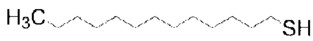

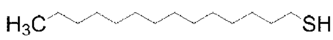 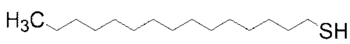 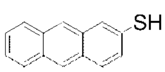
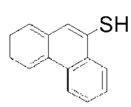
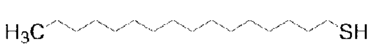

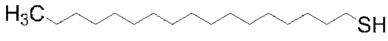
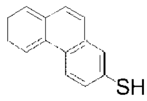
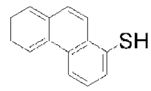
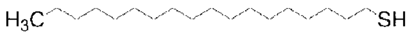
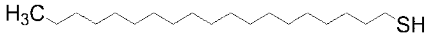
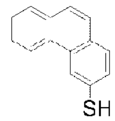
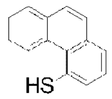
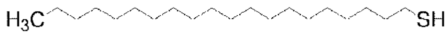
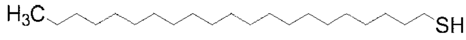
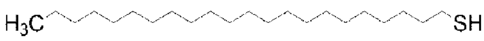

One chain transfer agent may be used alone, or two or more chain transfer agents may be used in combination.
The content of the chain transfer agent in the total solid content of the image-recording layer is preferably 0.01% to 50% by mass, more preferably 0.05% to 40% by mass, and even more preferably 0.1% to 30% by mass.

(Low-molecular-weight hydrophilic compound)

The low-molecular-weight hydrophilic compound contributes to the improvement of on-press developability of the lithographic printing plate precursor without deteriorating printing durability of the lithographic printing plate prepared from the lithographic printing plate precursor. The low-molecular-weight hydrophilic compound is preferably a compound having a molecular weight less than 1,000, more preferably a compound having a molecular weight less than 800, and even more preferably a compound having a molecular weight less than 500.
Examples of the low-molecular-weight hydrophilic compound include water-soluble organic compounds including glycols such as ethylene glycol, diethylene glycol, triethylene glycol, propylene glycol, dipropylene glycol, and tripropylene glycol, ether or ester derivatives of these glycols, polyols such as glycerin, pentaerythritol, and tris(2-hydroxyethyl)isocyanurate, organic amines and salts thereof such as triethanolamine, diethanolamine, and monoethanolamine, organic sulfonic acids and salts thereof such as alkyl sulfonate, toluene sulfonate, and benzene sulfonate, organic sulfamic acids and salts thereof such as alkylsulfamate, organic sulfuric acids and salts thereof such as alkyl sulfate and alkyl ether sulfate, organic phosphonic acids and salts thereof such as phenyl phosphate, organic carboxylic acids and salts thereof such as tartaric acid, oxalic acid, citric acid, malic acid, lactic acid, gluconic acid, and amino acid, betaines, and the like.
As the low-molecular-weight hydrophilic compound, at least one compound selected from polyols, organic sulfates, organic sulfonates, and betaines is preferable.
Specific examples of the organic sulfonates include alkyl sulfonates such as sodium n-butyl sulfonate, sodium n-hexyl sulfonate, sodium 2-ethylhexyl sulfonate, sodium cyclohexyl sulfonate, and sodium n-octyl sulfonate; alkyl sulfonates having an ethylene oxide chain such as sodium 5,8,11-trioxapentadecane-1-sulfonate, sodium 5,8,11-trioxaheptadecane-1-sulfonate, sodium 13-ethyl-5,8,11-trioxaheptadecane-1-sulfonate, and sodium 5,8,11,14-tetraoxatetracosane-1-sulfonate; aryl sulfonates such as sodium benzenesulfonate, sodium p-toluenesulfonate, sodium p-hydroxybenzene sulfonate, sodium p-styrene sulfonate, sodium dimethyl isophthalate-5-sulfonate, sodium 1-naphthyl sulfonate, sodium 4-hydroxynaphthyl sulfonate, disodium 1,5-naphthalene disulfonate, and trisodium 1,3,6-naphthalene trisulfonate, the compounds described in paragraphs "0026" to "0031" of JP2007-276454A and paragraphs "0020" to "0047" of JP2009-154525A, and the like. The salt may be a potassium salt or a lithium salt.
Examples of the organic sulfates include sulfates of alkyl, alkenyl, alkynyl, aryl, or heterocyclic monoether of polyethylene oxide. The number of ethylene oxide units is preferably 1 to 4, and the salt is preferably a sodium salt, a potassium salt, or a lithium salt. Specific examples thereof include the compounds described in paragraphs "0034" to "0038" of JP2007-276454A, and the like.
As the betaines, compounds in which a nitrogen atom is substituted with a hydrocarbon substituent having 1 to 5 carbon atoms are preferable. Specifically, examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-propanesulfonate, 3-(1-pyridinio)-1-propanesulfonate, and the like.
The low-molecular-weight hydrophilic compound has a hydrophobic portion with a small structure and substantially does not have a surface activation action. Therefore, this compound prevents dampening water from permeating the exposed portion of the image-recording layer (image area) and deteriorating hydrophobicity or film hardness of the image area. Accordingly, the image-recording layer can maintain excellent ink receiving properties and printing durability.
One low-molecular-weight hydrophilic compound may be used alone, or two or more low-molecular-weight hydrophilic compounds may be used in combination.
The content of the low-molecular-weight hydrophilic compound in the total solid content of the image-recording

layer is preferably 0.5% to 20% by mass, more preferably 1% to 15% by mass, and even more preferably 2% to 10% by mass.

(Oil sensitizing agent)

The oil sensitizing agent contributes to the improvement of ink receptivity (hereinafter, also simply called "receptivity") of the lithographic printing plate prepared from the lithographic printing plate precursor. Examples of the oil sensitizing agent include a phosphonium compound, a nitrogen-containing low-molecular-weight compound, an ammonium group-containing polymer, and the like. Particularly, in a case where the lithographic printing plate precursor has a protective layer containing an inorganic lamellar compound, these compounds function as a surface coating agent for the inorganic lamellar compound and can inhibit the receptivity deterioration caused in the middle of printing by the inorganic lamellar compound.

As the oil sensitizing agent, it is preferable to use a phosphonium compound, a nitrogen-containing low-molecular-weight compound, and an ammonium group-containing polymer in combination, and it is more preferable to use a phosphonium compound, quaternary ammonium salts, and an ammonium group-containing polymer in combination.

Examples of the phosphonium compound include the phosphonium compounds described in JP2006-297907A and JP2007-50660A. Specific examples thereof include tetrabutylphosphonium iodide, butyltriphenylphosphonium bromide, tetraphenylphosphonium bromide, 1,4-bis(triphenylphosphonio)butane=di(hexafluorophosphate), 1,7-bis(triphenylphosphonio)heptane=sulfate, 1,9-bis(triphenylphosphonio)nonane=naphthalene-2,7-disulfonate, and the like.

Examples of the nitrogen-containing low-molecular-weight compound include amine salts and quaternary ammonium salts. In addition, examples thereof also include imidazolinium salts, benzimidazolinium salts, pyridinium salts, and quinolinium salts. Among these, quaternary ammonium salts and pyridinium salts are preferable. Specific examples thereof include tetramethylammonium=hexafluorophosphate, tetrabutylammonium=hexafluorophosphate, dodecyltrimethylammonium=p-toluenesulfonate, benzyltriethylammonium=hexafluorophosphate, benzyldimethyloctylammonium=hexafluorophosphate, benzyldimethyldodecylammonium=hexafluorophosphate, compounds described in paragraphs "0021" to "0037" of JP2008-284858A and paragraphs "0030" to "0057" of JP2009-90645A, and the like.

The ammonium group-containing polymer may have an ammonium group in the structure. As such a polymer, a polymer is preferable in which the content of (meth)acrylate having an ammonium group on a side chain as a copolymerization component is 5 to 80 mol%. Specific examples thereof include the polymers described in paragraphs "0089" to "0105" of JP2009-208458A.

The reduced specific viscosity (unit: ml/g) of an ammonium group-containing polymer determined according to the measurement method described in JP2009-208458A is preferably in a range of 5 to 120, more preferably in a range of 10 to 110, and particularly preferably in a range of 15 to 100. In a case where the reduced specific viscosity is converted into a weight-average molecular weight (Mw), the weight-average molecular weight is preferably 10,000 to 150,000, more preferably 17,000 to 140,000, and particularly preferably 20,000 to 130,000.

Specific examples of the ammonium group-containing polymer will be shown below.

(1) 2-(Trimethylammonio)ethylmethacrylate=p-toluenesulfonate/3,6-dioxaheptylmethacrylate copolymer (molar ratio: 10/90, Mw: 45,000)

(2) 2-(Trimethylammonio)ethylmethacrylate=hexafluorophosphate/3,6-dioxaheptylmethacrylate copolymer (molar ratio: 20/80, Mw: 60,000)

(3) 2-(Ethyldimethylammonio)ethylmethacrylate=p-toluenesulfonate/hexylmethacrylate copolymer (molar ratio: 30/70, Mw: 45,000)

(4) 2-(Trimethylammonio)ethylmethacrylate=hexafluorophosphate/2-ethylhexylmethacrylate copolymer (molar ratio: 20/80, Mw: 60,000)

(5) 2-(Trimethylammonio)ethylmethacrylate=methylsulfate/hexylmethacrylate copolymer (molar ratio: 40/60, Mw: 70,000)

(6) 2-(Butyldimethylammonio)ethylmethacrylate=hexafluorophosphate/3,6-dioxaheptylmethacryl ate copolymer (molar ratio: 25/75, Mw: 65,000)

(7) 2-(Butyldimethylammonio)ethylacrylate=hexafluorophosphate/3,6-dioxaheptylmethacrylate copolymer (molar ratio: 20/80, Mw: 65,000)

(8) 2-(Butyldimethylammonio)ethylmethacrylate=13-ethyl-5,8,11-trioxa-1-heptadecanesulfonate/ 3,6-dioxaheptylmethacrylate copolymer (molar ratio: 20/80, Mw: 75,000)

(9) 2-(Butyldimethylammonio)ethylmethacrylate=hexafluorophosphate/3,6-dioxaheptylmethacryl ate/2-hydroxy-3-methacryloyloxypropylmethacrylate copolymer (molar ratio: 15/80/5, Mw: 65,000)

The content of the oil sensitizing agent in the total solid content of the image-recording layer is preferably 0.01% to

30% by mass, more preferably 0.1% to 15% by mass, and even more preferably 1% to 10% by mass.

(Other components)

The image-recording layer can contain, as other components, a surfactant, a bakeout agent, a polymerization inhibitor, a higher fatty acid derivative, a plasticizer, inorganic particles, an inorganic lamellar compound, an acid color developing agent, a hydrophilic compound, and the like. Specifically, the above components described in paragraphs "0114" to "0159" of JP2008-284817A can be used.

The image-recording layer may contain the specific infrared absorber. In this case, the image-recording layer corresponds to the specific constitutional layer.

(Formation of image-recording layer)

The image-recording layer can be formed, for example, by preparing a coating liquid by appropriately dispersing or dissolving the necessary components described above in a known solvent, performing coating with the coating liquid by a known method such as bar coating, and drying the coating liquid, as described in paragraphs "0142" and "0143" of JP2008-195018A. The coating amount (solid content) of the image-recording layer after coating and drying varies with uses. However, from the viewpoint of obtaining excellent sensitivity and excellent film characteristics of the image-recording layer, the coating amount is preferably about 0.3 to 3.0 $g/m^2$.

The lithographic printing plate precursor can have an undercoat layer (sometimes called an interlayer) between the image-recording layer and the support and a protective layer (sometimes called an overcoat layer) on the image-recording layer.

[Undercoat layer]

The undercoat layer enhances the adhesion between the support and the image-recording layer in an exposed portion, and enables the image-recording layer to be easily peeled from the support in a non-exposed portion. Therefore, the undercoat layer contributes to the improvement of developability without deteriorating printing durability. Furthermore, in the case of exposure to an infrared laser, the undercoat layer functions as a heat insulating layer and thus brings about an effect of preventing sensitivity reduction resulting from the diffusion of heat generated by exposure to the support.

Examples of compounds that are used in the undercoat layer include polymers having adsorbent groups that can be adsorbed onto the surface of the support and hydrophilic groups. In order to improve adhesiveness to the image-recording layer, polymers having adsorbent groups and hydrophilic groups plus crosslinking groups are preferable. The compounds that are used in the undercoat layer may be low-molecular-weight compounds or polymers. As necessary, as the compounds that are used in the undercoat layer, two or more compounds may be used by being mixed together.

In a case where the compound used in the undercoat layer is a polymer, a copolymer of a monomer having an adsorbent group, a monomer having a hydrophilic group, and a monomer having a crosslinking group is preferable.

As the adsorbent group that can be adsorbed onto the surface of the support, a phenolic hydroxyl group, a carboxy group, $-PO_3H_2$, $-OPO_3H_2$, $-CONHSO_2-$, $-SO_2NHSO_2-$, and $-COCH_2COCH_3$ are preferable. As the hydrophilic groups, a sulfo group or salts thereof and salts of a carboxy group are preferable. As the crosslinking groups, an acryloyl group, a methacryloyl group, an acrylamide group, a methacrylamide group, an allyl group, and the like are preferable.

The polymer may have a crosslinking group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated bond groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the surface of the support, hydrophilic groups, and crosslinking groups described in JP2005-125749A and JP2006-188038A are more preferable.

The content of ethylenically unsaturated bond group in the polymer used in the undercoat layer is preferably 0.1 to 10.0 mmol per gram of the polymer, and more preferably 0.2 to 5.5 mmol per gram of the polymer.

The mass-average molecular weight (Mw) of the polymer used in the undercoat layer is preferably 5,000 or more, and more preferably 10,000 to 300,000.

In order to prevent contamination with the passage of time, the undercoat layer may contain, in addition to the compounds for the undercoat layer described above, a chelating agent, a secondary or tertiary amine, a polymerization inhibitor, a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, hydroxyethyl ethylenediaminetriacetic acid, dihydroxyethyl ethylenediaminediacetic acid, hydroxyethyl iminodiacetic acid, and the like), and the like.

The undercoat layer can contain the specific infrared absorber. In this case, the undercoat layer corresponds to the specific constitutional layer.

The undercoat layer can be formed by coating by a known method, followed by drying. The coating amount (solid content) of the undercoat layer after drying is preferably 0.1 to 100 mg/$m^2$, and more preferably 1 to 30 mg/$m^2$.

[Protective layer]

The protective layer has a function of suppressing the reaction inhibiting image formation by blocking oxygen, a function of preventing the damage of the image-recording layer, and a function of preventing ablation during exposure to high-illuminance lasers.

The protective layer having such characteristics is described, for example, in US3458311A and JP1980-49729B (JP-S55-49729B). As polymers with low oxygen permeability that are used in the protective layer, any of water-soluble polymers and water-insoluble polymers can be appropriately selected and used. If necessary, two or more such polymers can be used by being mixed together. Specific examples thereof include a polyvinyl alcohol resin (including polyvinyl alcohol and modified polyvinyl alcohol), polyvinylpyrrolidone, a water-soluble cellulose derivative, poly (meth)acrylonitrile, and the like.

As the polyvinyl alcohol, a polyvinyl alcohol having a saponification degree of 50% or more is suitable. The saponification degree of the polyvinyl alcohol is preferably 60% or more, more preferably 70% or more, and even more preferably 85% or more. The upper limit of the saponification degree is not particularly limited. The saponification degree may be 100% or less.

The saponification degree can be measured according to the method described in JIS K 6726: 1994.

As the modified polyvinyl alcohol, acid-modified polyvinyl alcohol having a carboxy group or a sulfo group is preferably used. Specific examples thereof include the modified polyvinyl alcohols described in JP2005-250216A and JP2006-259137A.

Among water-soluble polymers, a polyvinyl alcohol resin is preferable.

In order to improve oxygen barrier properties, it is preferable that the protective layer contain an inorganic lamellar compound. The inorganic lamellar compound refers to particles in the form of a thin flat plate, and examples thereof include mica groups such as natural mica and synthetic mica, talc represented by Formula $3MgO \cdot 4SiO \cdot H_2O$, taeniolite, montmorillonite, saponite, hectorite, zirconium phosphate, and the like.

As the inorganic lamellar compound, a mica compound is preferably used. Examples of the mica compound include mica groups such as natural mica and synthetic mica represented by Formula: $A(B, C)_{2-5}D_4O_{10}(OH, F, O)_2$ [here, A represents any of K, Na, and Ca, B and C represent any of Fe (II), Fe (III), Mn, Al, Mg, and V, and D represents Si or Al.].

In the mica groups, examples of natural mica include white mica, soda mica, gold mica, black mica, and lepidolite. Examples of synthetic mica include non-swelling mica such as fluorophlogopite $KMg_3(AlSi_3O_{10})F_2$, potassium tetrasilic mica $KMg_{2.5}(Si_4O_{10})F_2$, and, Na tetrasilylic mica $NaMg_{2.5}(Si_4O_{10})F_2$, swelling mica such as Na or Li taeniolite (Na, Li) $Mg_2Li(Si_4O_{10})F2$, montmorillonite-based Na or Li hectorite $(Na, Li)_{1/8}Mg_{2/5}Li_{1/8}(Si_4O_{10})F_2$, and the like. Furthermore, synthetic smectite is also useful.

Among the mica compounds, fluorine-based swelling mica is particularly useful. That is, swelling synthetic mica has a laminated structure consisting of unit crystal lattice layers having a thickness in a range of approximately 10 to 15Å, and metal atoms in lattices are more actively substituted than in any other clay minerals. As a result, positive charges are deficient in the lattice layers, and positive ions such as $Li^+$, $Na^+$, $Ca^{2+}$, and $Mg^{2+}$ are adsorbed between the layers in order to compensate for the deficiency. Positive ions interposed between the layers are referred to as exchangeable positive ions and are exchangeable with various positive ions. Particularly, in a case where the positive ions between the layers are $Li^+$ and $Na^+$, the ionic radii are small, and thus the bonds between lamellar crystal lattices are weak, and mica is significantly swollen by water. In a case where shear is applied in this state, mica easily cleavages and forms a stable sol in water. Swelling synthetic mica is particularly preferably used because it clearly exhibits such a tendency.

From the viewpoint of diffusion control, regarding the shapes of the mica compounds, the thickness is preferably thin, and the planar size is preferably large as long as the smoothness and actinic ray-transmitting property of coated surfaces are not impaired. Therefore, the aspect ratio is preferably 20 or higher, more preferably 100 or higher, and particularly preferably 200 or higher. The aspect ratio is the ratio of the long diameter to the thickness of a particle and can be measured from, for example, projection views obtained from the microphotograph of the particle. The higher the aspect ratio is, the stronger the obtained effect is.

Regarding the particle diameter of the mica compound, the average long diameter thereof is preferably 0.3 to 20 μm, more preferably 0.5 to 10 μm, and particularly preferably 1 to 5 μm. The average thickness of the particles is preferably 0.1 μm or less, more preferably 0.05 μm or less, and particularly preferably 0.01 μm or less. Specifically, for example, in the case of swelling synthetic mica which is a typical compound, an aspect is preferable in which the compound has a thickness of about 1 to 50 nm and a surface size (long diameter) of about 1 to 20 μm.

The content of the inorganic lamellar compound in the total solid content of the protective layer is preferably 0% to 60% by mass, and more preferably 3% to 50% by mass. Even in a case where two or more inorganic lamellar compounds are used in combination, the total amount of the inorganic lamellar compounds preferable equals the content described above. In a case where the content is within the above range, the oxygen barrier properties are improved, and excellent sensitivity is obtained. In addition, the deterioration of receptivity can be prevented.

The protective layer may contain known additives such as a plasticizer for imparting flexibility, a surfactant for improving coating properties, and inorganic fine particles for controlling surface sliding properties. In addition, the oil sensitizing agent described above regarding the image-recording layer may be incorporated into the protective layer.

The protective layer may contain a specific infrared absorber. In this case, the protective layer corresponds to the specific constitutional layer.

The protective layer can be formed by performing coating by a known method, followed by drying. The coating amount (solid content) of the protective layer after drying is preferably 0.01 to 10 g/$m^2$, more preferably 0.02 to 3 g/$m^2$, and particularly preferably 0.02 to 1 g/$m^2$.

It is preferable that the lithographic printing plate precursor according to an embodiment of the present invention has a shear droop shape at an end part.

Fig. 3 is a schematic view showing a cross-sectional shape of an end part of a lithographic printing plate precursor as one aspect.

In Fig. 3, a lithographic printing plate precursor 1 has a shear droop 2 at an end part thereof. A distance X between the upper edge of an edge surface 1c of the lithographic printing plate precursor 1 (boundary point between the shear droop 2 and the edge surface 1c) and an intersection between an extension line of the edge surface 1c and an extension line of an image-recording layer surface (protective layer surface in a case where a protective layer is formed) 1a is called "shear droop amount X". A distance Y between a point at which the image-recording layer surface 1a of the lithographic printing plate precursor 1 begins to droop and the aforementioned intersection is called "shear droop width Y".

In the shear droop shape of the end part, the shear droop amount X is preferably 25 μm or more, more preferably 35 μm or more, and even more preferably 40 μm or more. From the viewpoint of preventing on-press developability deterioration resulting from the deterioration of surface condition of the end part, the upper limit of the shear droop amount X is preferably 150 μm. In a case where on-press developability deteriorates, ink adheres to the residual image-recording layer, which sometimes leads to the occurrence of edge contamination. In a case where the shear droop amount X is too small, the ink having adhered to the end part is likely to be transferred to a blanket, which sometimes leads to the occurrence of edge contamination. In a case where the shear droop amount X is in a range of 25 to 150 μm, and the shear droop width Y is small, the occurrence of cracks at the end part increases, and the printing ink is accumulated in the cracks, which sometimes leads to edge contamination. In this respect, the shear droop width Y is preferably in a range of 70 to 300 μm, and more preferably in a range of 80 to 250 μm. It should be noted that the ranges of the shear droop amount and shear droop width are not involved in the edge shape of a support surface 1b of the lithographic printing plate precursor 1.

Usually, at the end part of the lithographic printing plate precursor 1, shear droop occurs in a boundary B between the image-recording layer and the support and in the support surface 1b as in the image-recording layer surface 1a.

The end part having the shear droop shape can be formed, for example, by adjusting the cutting conditions of the lithographic printing plate precursor.

Specifically, the end part having the shear droop shape can be formed by adjusting the gap between an upper cutting blade and a lower cutting blade in a slitter device used for cutting the lithographic printing plate precursor, intrusion amounts of the blades, tip angle of the blades, and the like.

Fig. 4 is a conceptual view showing an example of a cutting portion of a slitter device. In the slitter device, a pair of upper and lower cutting blades 10 and 20 are vertically disposed. The cutting blades 10 and 20 consist of round blades on a disk. Upper cutting blades 10a and 10b are coaxially supported by a rotary shaft 11, and lower cutting blades 20a and 20b are coaxially supported by a rotary shaft 21. The upper cutting blades 10a and 10b and the lower cutting blades 20a and 20b rotate in opposite directions. A lithographic printing plate precursor 30 is passed between the upper cutting blades 10a and 10b and the lower cutting blades 20a and 20b and is cut in a predetermined width. By adjusting the gap between the upper cutting blade 10a and the lower cutting blade 20a and the gap between the upper cutting blade 10b and the lower cutting blade 20b of the cutting portion of the slitter device, it is possible to form an end part having a shear droop shape.

It is preferable that an ink repellent is provided on a part or all of two opposing lateral surfaces of the lithographic printing plate precursor. By coating a part or all of the two opposing lateral surfaces of the edge parts having a shear droop shape with an ink repellent, it is possible to inhibit the edge part from undergoing edge contamination with the passage of time. The ink repellent is not particularly limited as long as it can repel ink, and for example, a hydrophilic agent or an oil

desensitizing liquid can be used as the ink repellent. Hereinafter, the material used as the ink repellent will be described.

(Hydrophilic agent)

One of the examples of suitable aspects of the hydrophilic agent is a phosphoric acid compound. The phosphoric acid compound includes a phosphoric acid, a salt thereof, an ester thereof, and the like. Examples thereof include phosphoric acid, metaphosphoric acid, ammonium monophosphate, ammonium diphosphate, sodium dihydrogen phosphate, sodium monohydrogen phosphate, potassium monophosphate, potassium diphosphate, sodium tripolyphosphate, potassium pyrophosphate, and sodium hexametaphosphate. Among these, sodium dihydrogen phosphate, sodium monohydrogen phosphate, or sodium hexametaphosphate is preferable.

As the phosphoric acid compound, a polymer compound is preferable, and a polymer compound having a phosphoric acid ester group is more preferable. Examples of the polymer compound having a phosphoric acid ester group include a polymer consisting of one or more monomers having a phosphoric acid ester group in the molecule, a copolymer of one or more monomers that have a phosphoric acid ester group and one or more monomers that do not have a phosphoric acid ester group, a polymer obtained by introducing a phosphoric acid ester group into a polymer having no phosphoric acid ester group by a polymer reaction, and the like.

Examples of the monomer having a phosphoric acid group or a salt thereof include mono(2-(meth)acryloyloxyethyl) acid phosphate, mono(3-(meth)acryloyloxypropyl) acid phosphate, mono(3-(meth)acryloyloxy-2-hydroxypropyl) acid phosphate, mono(2-(meth)acryloyloxy-3-hydroxypropyl) acid phosphate, mono(3-chloro-2-(meth)acryloyloxypropyl) acid phosphate, mono(3-(meth)acryloxy-3-chloro-2-hydroxypropyl) acid phosphate, mono((meth)acryloyloxypolyethylene glycol) acid phosphate, mono((meth)acryloyloxypolypropylene glycol) acid phosphate, allyl alcohol acid phosphate, allyl alcohol acid phosphate, and salts of these phosphoric acid residues, and the like.

As the monomer having no phosphoric acid ester group in the aforementioned copolymer, a monomer having a hydrophilic group is preferable. Examples of the hydrophilic group include a hydroxy group, an alkylene oxide structure, an amino group, an ammonium group, and an amide group. Among these, a hydroxy group, an alkylene oxide structure, or an amide group is preferable, an alkylene oxide structure having 1 to 20 alkylene oxide units having 2 or 3 carbon atoms is more preferable, and a polyethylene oxide structure having 2 to 10 ethylene oxide units is even more preferable. Examples thereof include 2-hydroxyethyl acrylate, ethoxydiethylene glycol acrylate, methoxytriethylene glycol acrylate, poly(oxyethylene) methacrylate, N-isopropylacrylamide, acrylamide, and the like.

In the polymer compound having a phosphoric acid ester group, the content of the repeating unit having a phosphoric acid ester group with respect to all the repeating units of the polymer compound is preferably 1 to 100 mol%, more preferably 5 to 100 mol%, and even more preferably 10 to 100 mol%. The mass-average molecular weight of the polymer compound having a phosphoric acid ester group is preferably 5,000 to 1,000,000, more preferably 7,000 to 700,000, and even more preferably 10,000 to 500,000.

One of the examples of suitable aspects of the hydrophilic agent is a phosphonic acid compound. The phosphonic acid compound includes a phosphonic acid, a salt thereof, an ester, thereof, and the like. Examples thereof include ethyl phosphonic acid, propyl phosphonic acid, isopropyl phosphonic acid, butyl phosphonic acid, hexyl phosphonic acid, octyl phosphonic acid, dodecyl phosphonic acid, octadecyl phosphonic acid, 2-hydroxyethyl phosphonic acid, sodium or potassium salts thereof, methyl methylphosphonic acid, ethyl methylphosphonic acid, alkyl phosphonic acid monoalkyl ester such as methyl 2-hydroxyethylphosphonate and sodium salts or potassium salts thereof, alkylene diphosphonic acids such as methylene diphosphonic acid and ethylene diphosphonic acid, and polyvinylphosphonic acid.

As the phosphonic acid compound, a polymer compound is preferable. Examples of polymer compounds preferable as the phosphonic acid compound include polymer acid, a polymer consisting of one or more monomers having a phosphonic acid group or a phosphonic acid monoester group in the molecule, and a copolymer of one or more monomers having a phosphonic acid group or a phosphonic acid monoester and one or more monomers having none of a phosphonic acid group and a phosphonic acid monoester.

Examples of the monomer containing a phosphonic acid group or a salt thereof include vinylphosphonic acid, ethylphosphonic acid monovinyl ester, (meth)acryloylaminomethyl phosphonic acid, 3-(meth)acryloyloxypropyl phosphonic acid, and salts of phosphonic acid residues thereof.

As the aforementioned polymer compound, a homopolymer of a monomer having a phosphonic acid ester group or a copolymer of a monomer having a phosphonic acid ester group and a monomer having no phosphonic acid ester group are preferable. As the monomer having no phosphonic acid ester group in the aforementioned copolymer, a monomer having a hydrophilic group is preferable. Examples of the monomer having a hydrophilic group include 2-hydroxyethyl acrylate, ethoxydiethylene glycol acrylate, methoxytriethylene glycol acrylate, poly(oxyethylene) methacrylate, N-isopropylacrylamide, and acrylamide.

In the polymer compound having a phosphonic acid ester group, the content of the repeating unit having a phosphonic acid ester group with respect to all the repeating units of the polymer compound is preferably 1 to 100 mol%, more preferably 3 to 100 mol%, and even more preferably 5 to 100 mol%.

The mass-average molecular weight of the polymer compound having a phosphonic acid ester group is preferably 5,000 to 1,000,000, more preferably 7,000 to 700,000, and even more preferably 10,000 to 500,000.

One of the examples of suitable aspects of the hydrophilic agent is a water-soluble resin. Examples of the water-soluble resin include a water-soluble resin classified as a polysaccharide, polyvinyl alcohol, polyvinylpyrrolidone, polyacrylamide and a copolymer thereof, a vinylmethyl ether/maleic acid anhydride copolymer, a vinyl acetate/maleic acid anhydride copolymer, and a styrene/maleic acid anhydride copolymer. Examples of the polysaccharide include starch derivatives (for example, dextrin, enzymatically decomposed dextrin, hydroxypropylated starch, carboxymethylated starch, phosphate esterified starch, polyoxyalkylene grafted starch, and cyclodextrin), celluloses (for example, carboxymethyl cellulose, carboxyethyl cellulose, methyl cellulose, hydroxypropyl cellulose, and methyl propyl cellulose), carrageenan, alginic acid, guar gum, locust bean gum, xanthan gum, gum Arabic, and soybean polysaccharides. As the water-soluble resin, a starch derivative such as dextrin or polyoxyalkylene grafted starch, gum Arabic, carboxymethyl cellulose, or soybean polysaccharides are preferable.

Examples of one of suitable aspects of the hydrophilic agent include an anionic surfactant and a nonionic surfactant. Examples of the anionic surfactant include those described in paragraph "0022" of JP2014-10463 A As the anionic surfactant, dialkylsulfosuccinates, alkyl sulfuric acid ester salts, polyoxyethylene aryl ether sulfuric acid ester salts, or alkylnaphthalene sulfonates are preferable. As the anionic surfactant, an anionic surfactant represented by General Formula (I-A) or General Formula (I-B) is preferable.

$$(R^1)_p \text{---} Ar^1 \text{---} (SO_3^{\ominus})_q \ M_1^{\oplus} \qquad (I-A)$$

$$(R^2)_m \text{---} Ar^2 \text{---} Y{-}O(R^3O)_n{-}SO_3^{\ominus} \ M_2^{\oplus} \qquad (I-B)$$

In General Formula (I-A), $R^1$ represents a linear or branched alkyl group having 1 to 20 carbon atoms, p represents 0, 1, or 2, $Ar^1$ represents an aryl group having 6 to 10 carbon atoms, q represents 1, 2, or 3, and $M_1^+$ represents $Na^+$, $K^+$, $Li^+$, or $NH_4^+$. In a case where p is 2, a plurality of $R^1$'s may be the same as or different from each other.

In General Formula (I-B), $R^2$ represents a linear or branched alkyl group having 1 to 20 carbon atoms, m represents 0, 1, or 2, $Ar^2$ represents an aryl group having 6 to 10 carbon atoms, Y represents a single bond or an alkylene group having 1 to 10 carbon atoms, $R^3$ represents a linear or branched alkylene group having 1 to 5 carbon atoms, n represents an integer of 1 to 100, and $M_2^+$ represents $Na^+$, $K^+$, $Li^+$, or $NH_4^+$. In a case where m is 2, a plurality of $R^2$'s may be the same as or different from each other. In a case where n is 2 or more, a plurality of $R^3$'s may be the same as or different from each other.

In General Formula (I-A) and General Formula (I-B), $R^1$ and $R^2$ are preferably $CH_3$, $C_2H_5$, $C_3H_7$, or $C_4H_9$. $R^3$ is preferably $-CH_2-$, $-CH_2CH_2-$, $-CH_2CH_2CH_2-$, or $-CH_2CH(CH_3)-$, and more preferably $-CH_2CH_2-$. p and m are preferably 0 or 1, and p is more preferably 0. Y is preferably a single bond. n is preferably an integer of 1 to 20.

Examples of the nonionic surfactant include those described in paragraph "0031" of JP2014-1046312 A. As the nonionic surfactant, polyoxyethylene aryl ethers and polyoxyethylene-polyoxypropylene block copolymers are preferable.

As the nonionic surfactant, a nonionic surfactant represented by General Formula (II-A) is preferable.

$$(R^4)_s - Ar^3 - O(CH_2CH_2O)_t(CH_2CH(CH_3)O)_uH \sim \qquad (II - A)$$

In General Formula (II-A), $R^4$ represents a hydrogen atom or an alkyl group having 1 to 20 carbon atoms, s represents 0, 1, or 2, $Ar^3$ represents an aryl group having 6 to 10 carbon atoms, t and u each represent an integer of 0 to 100, and t and u do not simultaneously represent 0. In a case where s is 2, a plurality of R4's may be the same as or different from each other.

Organic fine resin particles (for example, a microgel) may be used as the hydrophilic agent. The microgel is reactive or non-reactive resin particles dispersed in an aqueous medium. It is preferable that the microgel have a polymerizable group in the particles or on the particle surface.

The coating liquid containing a hydrophilic agent is preferably in the form of an aqueous solution obtained by dissolving or dispersing a hydrophilic agent in a medium mainly consisting of water. The content of the hydrophilic agent in the coating liquid containing a hydrophilic agent is preferably 0.05% to 50% by mass, and more preferably 0.1% to 30% by mass. The viscosity of the coating liquid containing a hydrophilic agent at 25°C is preferably 0.5 to 1,000 mPa·s, and more preferably 1 to 100 mPa·s. The surface tension of the coating liquid containing a hydrophilic agent at 25°C is preferably 25

to 70 mN/m, and more preferably 40 to 65 mN/m.

The coating liquid containing a hydrophilic agent may contain an organic solvent, a plasticizing agent, a preservative, an antifoaming agent, and an inorganic salt such as a nitrate or a sulfate, in addition to the hydrophilic agent.

(Oil desensitizing liquid)

Examples of the oil desensitizing liquid include an aqueous solution containing at least one of a hydrophilic organic polymer compound, hexamethaphosphate and a salt thereof, or phytic acid and a salt thereof. Specific examples of the hydrophilic organic polymer compound include gum Arabic, dextrin, and an alginate such as sodium alginate, water-soluble cellulose such as carboxymethyl cellulose, hydroxyethyl cellulose, or hydroxypropylmethyl cellulose, polyvinyl alcohol, polyvinylpyrrolidone, polyacrylamide, a water-soluble copolymer having an acrylamide unit, a polyacrylic acid, a copolymer having an acrylic acid unit, a polymethacrylic acid, a copolymer having a methacrylic acid unit, a copolymer of vinylmethyl ether and maleic acid anhydride, a copolymer of vinyl acetate and maleic acid anhydride, a phosphoric acid-modified starch, and the like. Among these, gum Arabic is preferable because this substance has a strong oil desensitizing action. As necessary, two or more hydrophilic polymer compounds described above can be used in combination. The compounds are used at a concentration of about 1% to 40% by weight, and more preferably used at a concentration of about 3% to 30% by weight.

Specific examples of the hexametaphosphate include a hexametaphosphate alkali metal salt or an ammonium salt. Examples of the hexametaphosphate alkali metal salt or ammonium salt include sodium hexametaphosphate, potassium hexamethaphosphate, ammonium hexamethaphosphate, and the like. Specific examples of phytic acid or a salt thereof include alkali metal salts such as a sodium salt, a potassium salt, and a lithium salt, an ammonium salt, an amine salt, and the like. Examples of the amine salt include salts of diethylamine, triethylamine, n-propylamine, di-n-propylamine, tri-n-propylamine, n-butylamine, n-amylamine, n-hexylamine, laurylamine, ethylenediamine, trimethylenediamine, tetramethylenediamine, pentamethylenediamine, hexamethylenediamine, ethanolamine, diethanolamine, triethanolamine, allylamine, aniline, and the like. The phytic acid salt may be any of a normal salt in which all the hydrogens of 12 acids are substituted or a hydrogen salt (acidic salt) in which some of the hydrogens of the acids are substituted. It is possible to use both a phytic acid salt in the form of a simple salt consisting of a salt of one base and a phytic acid salt in the form of a double salt containing two or more bases as components. Each of these compounds can be used alone, or two or more of these compounds can be used in combination.

It is preferable to additionally incorporate a metal salt of a strong acid into the oil desensitizing liquid used in the present embodiment. In a case where such a metal salt is incorporated into the oil desensitizing liquid, oil desensitizing action can be enhanced. Specific examples of the metal salt of a strong acid include a sodium salt, a potassium salt, a magnesium salt, a calcium salt, and a zinc salt of nitric acid, a sodium salt, a potassium salt, a magnesium salt, a calcium salt, and a zinc salt of sulfuric acid, a sodium salt, a potassium salt, a magnesium salt, a calcium salt, and a zinc salt of chromic acid, sodium fluoride, potassium fluoride, and the like. Two or more of these metal salts of a strong acid can be used in combination, and the amount thereof is preferably about 0.01% to 5% by weight based on the total weight of the oil desensitizing liquid. The pH of the oil desensitizing liquid used in the present invention is adjusted to fall in an acidic range. The pH is more preferably adjusted to 1 to 5, and most preferably adjusted to 1.5 to 4.5. Therefore, in a case where the pH of a water phase is not acidic, an acid is further added to the water phase. Examples of the acid added as a pH adjuster include mineral acids such as phosphoric acid, sulfuric acid, and nitric acid. Examples thereof include organic acids such as citric acid, tannic acid, malic acid, glacial acetic acid, lactic acid, oxalic acid, p-toluenesulfonic acid, and organic phosphonic acid. Among these, phosphoric acid is particularly excellent because it functions not only as a pH adjuster but also as an oil desensitizing action enhancer. It is preferable to incorporate the phosphoric acid into the oil desensitizing liquid such that the amount thereof with respect to the total weight of the oil desensitizing liquid is in a range of 0.01% to 20% by weight, and most preferably in a range of 0.1% to 10% by weight.

It is preferable to incorporate a wetting agent and/or a surfactant into the oil desensitizing liquid used in the present embodiment. In a case where either or both of a wetting agent and a surfactant are incorporated into the oil desensitizing liquid, the coating properties of the oil desensitizing liquid can be improved. Specifically, a lower polyhydric alcohol is preferable as the wetting agent. Examples thereof include ethylene glycol, diethylene glycol, triethylene glycol, propylene glycol, butylene glycol, pentanediol, hexylene glycol, tetraethylene glycol, polyethylene glycol, dipropylene glycol, tripropylene glycol, glycerin, sorbitol, pentaerythritol, and the like. Among these, glycerin is particularly preferable. As the surfactant, for example, it is possible to use a nonionic surfactant such as polyoxyethylene alkylphenyl ether or a polyoxyethylene/polyoxypropylene block copolymer, an anionic surfactant such as fatty acid salts, alkyl sulfuric acid ester salts, alkylbenzene sulfonates, alkylnaphthalene sulfonates, dialkylsulfosuccinic acid ester salts, alkyl phosphoric acid ester salts, and a naphthalene sulfonic acid formalin condensate, and an amphoteric surfactant betaine-type, glycine-type, alanine-type, or sulfobetaine-type amphoteric surfactant. The amount of these wetting agents and/or surfactants contained in the oil desensitizing liquid with respect to the total weight of the oil desensitizing liquid is in a range of about 0.5% to 10% by weight, and more preferably in a range of about 1% to 5% by weight. The oil desensitizing liquid used in the

present invention can further contain a filler such as silicon dioxide, talc, or clay in an amount of up to 2% by weight, and can further contain a dye, a pigment, or the like in an amount of up to 1% by weight.

The oil desensitizing liquid used in the present embodiment consists of a hydrophilic aqueous solution as described above. For example, it is also possible to use the emulsified oil desensitizing liquids described in specifications of US4253999A, US4268613A, US4348954A, and the like in consideration of the fact that sometimes the aforementioned oil desensitizing liquid negatively affects the image-recording layer.

As the ink repellent, for example, HN-G5 (manufactured by FUJIFILM Corporation) can be used.

(Ink repellent coating method)

The coating method of performing coating with an ink repellent is not particularly limited. Fig. 7 is a view illustrating a coating method of performing coating with an ink repellent. As shown in Fig. 7, coating with a coating liquid containing an ink repellent can be performed using a wire bar 138. In Fig. 7, in order to explain a method of performing coating with an ink repellent, a lithographic printing plate precursor 100a having an outermost layer surface 122 on the side of the specific constitutional layer with reference to the support is illustrated simply, and the shear droop shape of the end part is not illustrated. For performing coating with an ink repellent by using the wire bar 138, first, the wire bar 138 is coated with a coating liquid containing an ink repellent. The wire bar 138 coated with the coating liquid is moved along an edge surface 120 (the surface on the aluminum support side) of the lithographic printing plate precursor 100a. The wire bar 138 can be moved, for example, at a moving speed of 20 mm/s. After coating, the coating liquid is dried. The drying can be performed, for example, under drying conditions where the coating liquid is exposed to air at 80°C for 30 seconds at a wind speed of 6 m/s.

The size of the wire bar can be appropriately changed depending on the thickness of the aluminum support of the lithographic printing plate precursor 100a. For example, in a case where the thickness of the aluminum support is 0.3 mm, a #10 wire bar can be used.

During the coating with the coating liquid, as shown in Fig. 7, the wire bar 138 may be applied to the edge surface 120 of the lithographic printing plate precursor 100a by being tilted at an angle $\theta$ for coating.

As a method of coating a part of all of two opposing lateral surfaces of the lithographic printing plate precursor with the ink repellent, the method described in JP6628949B can be suitably used.

[Method of preparing negative tone lithographic printing plate]

The method of preparing a negative tone lithographic printing plate (hereinafter, also called "lithographic printing plate") according to an embodiment of the present invention will be described using the laminate according to an embodiment of the present invention.

The method of preparing a lithographic printing plate is not particularly limited, and preferably includes a step of taking out a lithographic printing plate precursor from the laminate (plate feeding step), a step of performing image exposure on the lithographic printing plate precursor (exposure step), and a step of supplying at least a printing ink or dampening water to remove a non-exposed portion of the image-recording layer in the lithographic printing plate precursor (on-press development step).

[Plate feeding step]

The plate feeding step is a step of taking out a lithographic printing plate precursor from the laminate. Usually, the plate feeding step is preferably performed in a setter.

[Exposure Step]

The image exposure is preferably performed by a method of scanning and exposing digital data with an infrared laser or the like.

The wavelength of an exposure light source to be used is preferably 750 to 1,400 nm. As the light source having a wavelength of 750 to 1,400 nm, a solid-state laser or a semiconductor laser that radiates infrared is suitable. The exposure mechanism may be any of an in-plane drum method, an external surface drum method, a flat head method, and the like.

The exposure step can be performed by a known method using a platesetter or the like. In addition, a printer comprising an exposure device may be used, the lithographic printing plate precursor may be mounted on the printer, and then image exposure may be performed on the printer.

[On-press development step]

The method of preparing a lithographic printing plate according to an embodiment of the present invention preferably includes an on-press development step of supplying at least one of a printing ink or dampening water to remove a non-exposed portion of the image-recording layer in the lithographic printing plate precursor.
In addition, the method of preparing a lithographic printing plate according to an embodiment of the present invention may be performed by a method of performing development with a developer (developer treatment method).
Hereinafter, the on-press development method will be described.

-On-press development method-

In the on-press development method, in a case where printing begins by supplying of a printing ink and dampening water on a printer without performing any development treatment on the lithographic printing plate precursor after image exposure, the non-exposed portion of the lithographic printing plate precursor is removed at the initial stage during printing. As a result, the surface of the hydrophilic support is exposed, and a non-image area is formed. As the printing ink and the dampening water, known printing ink and dampening water for lithographic printing are used. What is supplied first to the surface of the printing plate precursor may be any of the printing ink or dampening water. In view of preventing the plate from being contaminated by the components of the image-recording layer from which the dampening water is removed, it is preferable that the printing ink be supplied first.
In the manner described above, the lithographic printing plate precursor is subjected to on-press development on an offset printer and used as it is for printing a number of sheets.
The method of preparing a lithographic printing plate according to an embodiment of the present invention may include other known steps, in addition to the above steps. Examples of those other steps include a plate inspection step of checking the position and orientation of the lithographic printing plate precursor before each step, a checking step of checking a printed image after the on-press development step, and the like.

Examples

Hereinafter, the present invention will be specifically described based on examples, but the present invention is not limited thereto. In examples, unless otherwise specified, "%" and "part" mean "% by mass" and "part by mass" respectively. Unless otherwise described, the molecular weight of a polymer compound is a mass-average molecular weight (Mw), and the ratio of repeating constitutional units of a polymer compound is expressed as molar percentage. The mass-average molecular weight (Mw) is a polystyrene-equivalent molecular weight measured by gel permeation chromatography (GPC).

[Examples 1 to 36 and Comparative Examples 1 and 2]

<Preparation of support 1>

The following treatments (F-a) to (F-g) were performed on an aluminum plate (aluminum alloy plate) made of a material 1S having a thickness of 0.3 mm, thereby preparing a support 1. A rinsing treatment was performed between all the treatment steps. After the rinsing treatment, water was drained using a nip roller.

(F-a) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The amount of dissolved aluminum within the surface to be subjected to the electrochemical roughening treatment later was 5 $g/m^2$.

(F-b) Desmutting treatment using aqueous acidic solution

As an aqueous acidic solution, an aqueous solution at a liquid temperature of 30°C having a sulfuric acid concentration of 150 g/L was sprayed on an aluminum plate for 3 seconds, thereby performing a desmutting treatment.

(F-c) Electrochemical roughening treatment

An electrochemical roughening treatment was performed using alternating current and an electrolytic solution

having a hydrochloric acid concentration of 14 g/L, an aluminum ion concentration of 13 g/L, and a sulfuric acid concentration of 3 g/L. The liquid temperature of the electrolytic solution was 30°C. Aluminum chloride was added to adjust the aluminum ion concentration.

The waveform of the alternating current was a sine wave in which positive and negative waveforms are symmetrical, the frequency was 50 Hz, the ratio of the anodic reaction time and the cathodic reaction time in one cycle of the alternating current was 1: 1, and the current density was 75 A/$dm^2$ in terms of the peak current value of the alternating current waveform. In addition, the quantity of electricity was 450 C/$dm^2$ which was the total quantity of electricity used for the aluminum plate to have an anodic reaction, and the electrolysis treatment was performed 4 times by conducting electricity of 112.5 C/$dm^2$ for 4 seconds at each treatment session. A carbon electrode was used as the counter electrode of the aluminum plate.

(F-d) Alkaline etching treatment

An aqueous solution of caustic soda having a caustic soda concentration of 5% by mass and an aluminum ion concentration of 0.5% by mass was sprayed onto the aluminum plate at a temperature of 45°C, thereby performing an etching treatment. The amount of dissolved aluminum within the surface having undergone the electrochemical roughening treatment was 0.2 g/$m^2$.

(F-e) Desmutting treatment using aqueous acidic solution

As an aqueous acidic solution, an aqueous solution at a liquid temperature of 35°C having a sulfuric acid concentration of 170 g/L and an aluminum ion concentration of 5 g/L was sprayed on an aluminum plate for 3 seconds, thereby performing a desmutting treatment.

(F-f) First-stage anodization treatment

By using the anodization device for direct current electrolysis having the structure shown in Fig. 6, a first-stage anodization treatment was performed. By using a 150 g/L aqueous phosphoric acid solution as an electrolytic solution, an anodization treatment was performed under the conditions of a liquid temperature of 35°C and a current density of 4.5 A/$dm^2$, thereby forming an anodic oxide film having a film amount of 1 g/$m^2$.

(F-g) Second-stage anodization treatment

By using the anodization device for direct current electrolysis having the structure shown in Fig. 6, a second-stage anodization treatment was performed. By using a 170 g/L aqueous sulfuric acid solution as an electrolytic solution, an anodization treatment was performed under the conditions of a liquid temperature of 50°C and a current density of 13 A/$dm^2$, thereby forming an anodic oxide film having a film amount of 2.1 g/$m^2$. Then, rinsing was performed by means of spraying. The average diameter of the micropores in the support 1 was 40 nm.

The value of the brightness L* of the surface of the anodic oxide film of the support 1 was 83.7 in the L*a*b* color system.

The average diameter of the large diameter portions within the surface of the anodic oxide film was 26 nm, and the depth of the large diameter portions from the surface of the anodic oxide film was 160 nm.

The average diameter of the small diameter portions at the communicate position was 10 nm, and the depth of the small diameter portions from the communicate position was 800 nm.

<Preparation of support 2>

-Alkaline etching treatment-

An aqueous solution of caustic soda having a caustic soda concentration of 26% by mass and an aluminum ion concentration of 6.5% by mass was sprayed onto the aluminum plate at a temperature of 55°C, thereby performing an etching treatment. Then, rinsing was performed by means of spraying. The amount of dissolved aluminum within the surface to be subjected to the electrochemical roughening treatment later was 3 g/$m^2$.

-Desmutting treatment using aqueous acidic solution (first desmutting treatment)-

Next, a desmutting treatment was performed using an aqueous acidic solution. In the desmutting treatment, a 170 g/L aqueous sulfuric acid solution was used as the aqueous acidic solution. The liquid temperature was 30°C. The

desmutting treatment was performed for 3 seconds by spraying the aqueous acidic solution onto the aluminum plate. Then, a rinsing treatment was performed.

-Electrochemical roughening treatment-

Next, an electrochemical roughening treatment was performed using an electrolytic solution at a hydrochloric acid concentration and alternating current. The liquid temperature of the electrolytic solution was 40°C. The waveform of the alternating current was a sine wave in which the positive and negative waveforms are symmetrical, and the frequency was 50 Hz. The quantity of electricity was 300 $C/dm^2$, which is the total quantity of electricity that the aluminum plate stores during the anodic reaction. A carbon electrode was used as the counter electrode of the aluminum plate. Then, a rinsing treatment was performed.

-Alkaline etching treatment-

An aqueous solution of caustic soda having a caustic soda concentration of 5% by mass and an aluminum ion concentration of 0.5% by mass was sprayed onto the aluminum plate having undergone the electrochemical roughening treatment at a temperature of 35°C such that the etching amount was 0.1 $g/m^2$ or less, thereby performing an etching treatment. Then, a rinsing treatment was performed.

-Desmutting treatment using aqueous acidic solution-

Next, a desmutting treatment was performed using an aqueous acidic solution. In the desmutting treatment, a 170 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

-Anodization treatment-

An anodization treatment was performed using 170 g/L of a sulfuric acid solution and direct current at a liquid temperature of 40°C such that the amount of the anodic oxide film was 3 $g/m^2$.

The average diameter of the micropores in the support 2 was 15 nm.

The value of the brightness L* of the surface of the anodic oxide film of the support 2 was 78.5 in the L*a*b* color system.

<Preparation of support 3>

The following treatments (J-a) to (J-m) were performed on an aluminum plate (aluminum alloy plate) made of a material 1S having a thickness of 0.3 mm, thereby manufacturing a support 3. A rinsing treatment was performed between all the treatment steps. After the rinsing treatment, water was drained using a nip roller.

(J-a) Mechanical roughening treatment (brush graining method)

By using the device shown in Fig. 5, a pumice suspension (specific gravity: 1.1 $g/cm^3$) as an abrasive slurry was supplied to the surface of an aluminum plate, and in this state, a mechanical roughening treatment is performed using a rotating bundled brush. In Fig. 5, 31 represents an aluminum plate, 32 and 34 represent roller-shaped brushes (bundled brushes in the present example), 33 represents an abrasive slurry, and 35, 36, 37, and 38 represent support rollers.

In the mechanical roughening treatment, an abrasive having a median diameter ($\mu$m) of 30 $\mu$m and 4 brushes were used, and the rotation speed (rpm) of the brushes was set to 250 rpm. The bundled brush was made of 6-10 nylon and consisted of bristles having a diameter of 0.3 mm and a length of 50 mm. The brush was prepared by making holes in a $\varphi$ 300 mm stainless steel cylinder and densely implanting bristles therein. The distance between two support rollers ($\varphi$ 200 mm) under the bundled brush was 300 mm. The bundled brush was pressed until the load of the drive motor for rotating the brush was 10 kW higher than the load applied before the bundled brush was pressed on the aluminum plate. The rotation direction of the brush was the same as the moving direction of the aluminum plate.

(J-b) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an

etching treatment. The amount of dissolved aluminum within the surface to be subjected to the electrochemical roughening treatment later was 10 g/$m^2$.

(J-c) Desmutting treatment using aqueous acidic solution

As an aqueous acidic solution, the waste liquid of nitric acid used in the following step, an electrochemical roughening treatment, at a liquid temperature of 35°C was sprayed on the aluminum plate for 3 seconds. In this way, a desmutting treatment was performed.

(J-d) Electrochemical roughening treatment using aqueous nitric acid solution

An electrochemical roughening treatment was continuously performed using alternating current voltage of 60 Hz. An electrolytic solution at a liquid temperature of 35°C was used which was prepared by adding aluminum nitrate to 10.4 g/L aqueous nitric acid solution such that the aluminum ion concentration was adjusted to 4.5 g/L. By using an alternating current power source having the waveform shown in Fig. 1, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 2 was used. The peak current density was 30 A/$dm^2$, and 5% of the current coming from the power source was allowed to flow into the auxiliary anode. The quantity of electricity (C/$dm^2$) was 185 C/$dm^2$, which is the total quantity of electricity used during the anodization of the aluminum plate.

(J-e) Alkaline etching treatment

An aqueous solution of caustic soda having a caustic soda concentration of 27% by mass and an aluminum ion concentration of 2.5% by mass was sprayed onto the aluminum plate at a temperature of 50°C, thereby performing an etching treatment. The amount of dissolved aluminum was 3.5 g/$m^2$.

(J-f) Desmutting treatment using aqueous acidic solution

As an aqueous acidic solution, an aqueous solution at a liquid temperature of 30°C having a sulfuric acid concentration of 170 g/L and an aluminum ion concentration of 5 g/L was sprayed on an aluminum plate for 3 seconds, thereby performing a desmutting treatment.

(J-g) Electrochemical roughening treatment using aqueous hydrochloric acid solution

An electrochemical roughening treatment was continuously performed using alternating current voltage of 60 Hz. An electrolytic solution at a liquid temperature of 35°C was used which was prepared by adding aluminum chloride to 6.2 g/L aqueous hydrochloric acid solution such that the aluminum ion concentration was adjusted to 4.5 g/L. By using an alternating current power source having the waveform shown in Fig. 1, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 2 was used. The peak current density was 25 A/$dm^2$, and the quantity of electricity (C/$dm^2$) during the hydrochloric acid electrolysis was 63 C/$dm^2$ which is the total quantity of electricity used during the anodization of the aluminum plate.

(J-h) Alkaline etching treatment

An aqueous solution of caustic soda having a caustic soda concentration of 5% by mass and an aluminum ion concentration of 0.5% by mass was sprayed onto the aluminum plate at a temperature of 60°C, thereby performing an etching treatment. The amount of dissolved aluminum was 0.2 g/$m^2$.

(J-i) Desmutting treatment using aqueous acidic solution

As an aqueous acidic solution, an aqueous solution at a liquid temperature of 35°C (sulfuric acid concentration 170 g/L and aluminum ion concentration 5 g/L) which was a waste liquid generated in the anodization treatment step was sprayed on an aluminum plate for 4 seconds, thereby performing a desmutting treatment.

(J-j) First-stage anodization treatment

By using the anodization device for direct current electrolysis having the structure shown in Fig. 6, a first-stage anodization treatment was performed. By using a 170 g/L aqueous sulfuric acid solution as an electrolytic solution, an anodization treatment was performed under the conditions of a liquid temperature of 50°C and a current density of 30 A/$dm^2$, thereby forming an anodic oxide film having a film amount of 0.3 g/$m^2$.

(J-k) Pore widening treatment

The aluminum plate having undergone the anodization treatment was immersed in an aqueous solution of caustic soda having a caustic soda concentration of 5% by mass and an aluminum ion concentration of 0.5% by mass for 3 seconds at 40°C, thereby performing a pore widening treatment.

(J-1) Second-stage anodization treatment

By using the anodization device for direct current electrolysis having the structure shown in Fig. 6, a second-stage anodization treatment was performed. By using a 170 g/L aqueous sulfuric acid solution as an electrolytic solution, an anodization treatment was performed under the conditions of a liquid temperature of 50°C and a current density of 13 A/$dm^2$, thereby forming an anodic oxide film having a film amount of 2.1 g/$m^2$.

In an anodization treatment device 410 shown in Fig. 6, an aluminum plate 416 is transported as indicated by the arrow in Fig. 6. In a power supply tank 412 containing an electrolytic solution 418, the aluminum plate 416 is positively (+) charged by a power supply electrode 420. Then, the aluminum plate 416 is transported upwards by a roller 422 in the power supply tank 412, makes a turn downwards by a nip roller 424, then transported toward an electrolytic treatment tank 414 containing an electrolytic solution 426, and makes a turn by a roller 428 to move in the horizontal direction. Subsequently, the aluminum plate 416 is negatively (-) charged by an electrolysis electrode 430. As a result, an anodic oxide film is formed on the surface of the aluminum plate 416. The aluminum plate 416 exits from the electrolytic treatment tank 414 and is then transported for the next step. In the anodization treatment device 410, the roller 422, the nip roller 424, and the roller 428 constitute a direction change unit. Furthermore, in the inter-tank portion between the power supply tank 412 and the electrolytic treatment tank 414, the aluminum plate 416 is transported in a ridge shape and an inverted U shape by the rollers 422, 424, and 428. The power supply electrode 420 and the electrolysis electrode 430 are connected to a direct current power source 434.

(J-m) Hydrophilic treatment

In order to ensure the hydrophilicity of the non-image area, the aluminum plate was immersed in a 2.5% by mass No. 3 aqueous sodium silicate solution at 50°C for 7 seconds, thereby performing a silicate treatment. The amount of Si adhered was 8.5 mg/$m^2$. The average diameter of the micropores was 30 nm.

The value of the brightness L* of the surface of the anodic oxide film of the support 3 was 72.3 in the L*a*b* color system.

The average diameter of the large diameter portions within the surface of the anodic oxide film was 26 nm, and the depth of the large diameter portions from the surface of the anodic oxide film was 100 nm.

The average diameter of the small diameter portions at the communicate position was 10 nm, and the depth of the small diameter portions from the communicate position was 1,300 nm.

<Formation of undercoat layer 1>

The support was coated with the coating liquid (1) for an undercoat layer having the following composition such that the dry coating amount was 0.03 g/$m^2$. In this way, an undercoat layer 1 was formed.

(Coating liquid (1) for undercoat layer)

Aqueous polyacrylic acid solution (40% by mass) (Jurymer AC-10S, manufactured by TOAGOSEI CO., LTD.) 3.0 parts
Water 27.0 parts

<Formation of undercoat layer 2>

The support was coated with a coating liquid (2) for an undercoat layer having the following composition such that

the dry coating amount was 26 mg/m$^2$. In this way, an undercoat layer 2 was formed.

(Coating liquid (2) for undercoat layer)

· Compound (2) for undercoat layer (the following structure): 0.013 parts · Hydroxyethyl iminodiacetic acid: 0.005 parts · Tetrasodium ethylenediaminetetraacetate: 0.005 parts · Polyoxyethylene lauryl ether: 0.0003 parts · Water: 3.15 parts

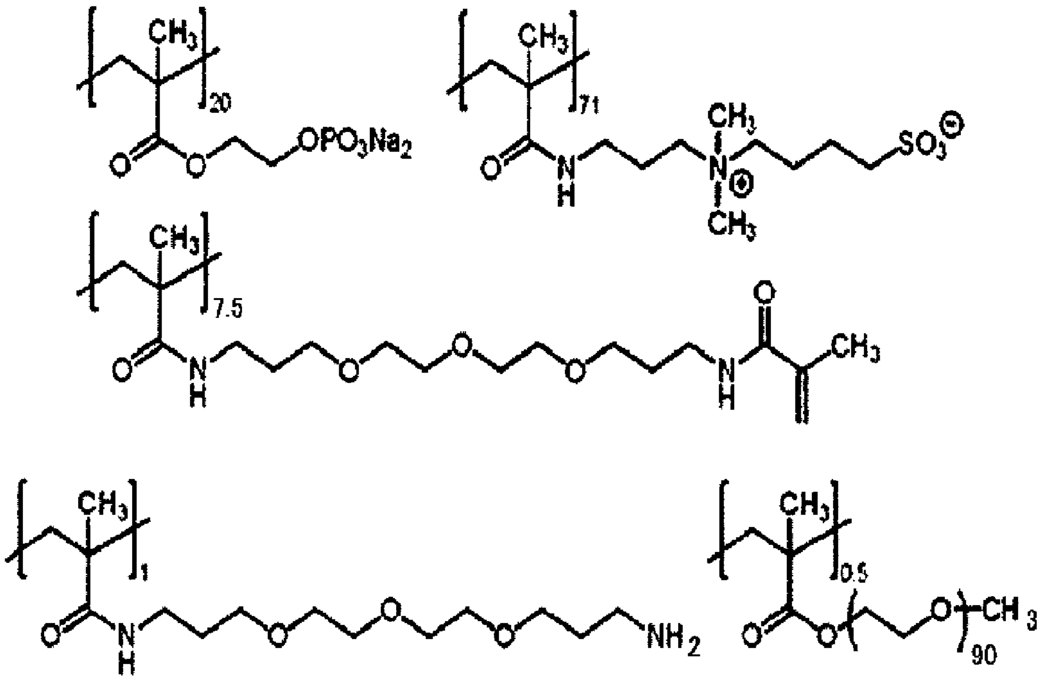

Compound (2) for undercoat layer Mw 100,000

The numerical value at the right lower side of the parentheses of each constitutional unit in the compound (2) for an undercoat layer represents a mass ratio, and the numerical value at the right lower side of the parentheses of the ethyleneoxy unit represents the number of repeating units.

<Formation of image-recording layer 1>

The undercoat layer was bar-coated with a coating liquid (1) for an image-recording layer having the following composition, followed by drying in an oven at 110°C for 40 seconds, thereby forming an image-recording layer 1 having a dry weight of 0.9 g/m$^2$.

(Coating liquid (1) for image-recording layer)

· 1-Propanol: 39.75 parts
·2-Butanone: 39.85 parts
·γ-Butyrolactone: 0.88 parts
·Polymer emulsion A[*1]: 6.95 parts
·KLUCEL E[*2]: 0.25 parts
· Urethane acrylate[*3]: 1.65 parts
· Sartomer SR399[*4]: 0.77 parts
· Iodonium salt A[*5]: 0.15 parts
· Iodonium salt B[*6]: 0.15 parts
· 3-Mercapto 1,2,4-triazole: 0.05 parts
· Black-XV[*7]: 0.15 parts

· BYK 336*8: 0.18 parts

*1: The polymer emulsion A is polymer particles of a graft copolymer of poly(ethylene glycol) methyl ether methacrylate/styrene/acrylonitrile = 10:9:81, which is in the form of a dispersion composed of a solvent of n-propanol/water at a mass ratio 80/20 containing 24% by mass of the polymer particles. The volume average particle diameter thereof is 193 nm.
*2: Klucel E means hydroxypropyl cellulose available from Hercules Incorporated.
*3: A polymerizable compound having a concentration of 80% by mass in a 2-butanone solution, which is obtained by reacting DESMODUR (registered trademark) N100, hydroxyethyl acrylate, and pentatritol acrylate at a molar ratio of 1:1.5:1.5.
*4: Dipentaerythritol pentaacrylate ester (Sartomer Company Inc.)
*5: A compound represented by Formula 1
*6: A compound represented by Formula 2

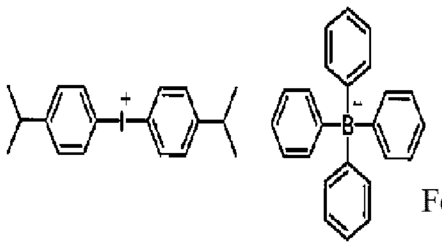
Formula 1

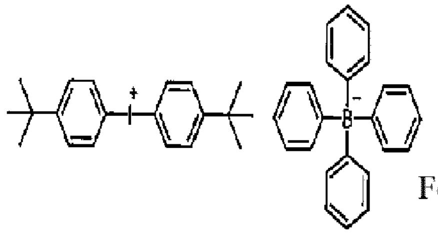
Formula 2

Iodonium:borate= 1 : 1

*7: Black-XV (the following compound, manufactured by Yamamoto Chamicals Inc.)
*8: A xylene/methoxypropyl acetate solution containing a modified polydimethylsiloxane copolymer at a concentration of 25% by mass (manufactured by BYK-Chemie GmbH)

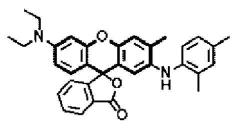
Black-XV

<Formation of image-recording layer 2>

The undercoat layer was bar-coated with a coating liquid (2) for an image-recording layer having the following composition, followed by drying in an oven at 120°C for 40 seconds, thereby forming an image-recording layer 2 having a dry weight of 1.0 g/$m^2$.

(Coating liquid (2) for image-recording layer)

The coating liquid (2) for an image-recording layer contains following components and was prepared by adjusting the solid content to 6% by mass by using a mixed solvent of 1-methoxy-2-propanol (MFG):methyl ethyl ketone (MEK):methanol = 4:4:1 (mass ratio).

·Electron-accepting polymerization initiator Int-1 (the following structure): 0.06 parts
·Electron-donating polymerization initiator B-1 (the following structure): 0.050 parts
·Polymerizable compound M-1 (the following structure): 0.25 parts
·Polymerizable compound M-2 (the following structure): 0.25 parts
·Binder polymer P-2*1: 0.15 parts
·Acid color developing agent S-3 (the following structure): 0.03 parts
·Hydrophilic compound T-2 (the following structure): 0.01 parts

*1: Binder polymer P-2: polyvinyl acetal, S-LEC BL10 manufactured by SEKISUI CHEMICAL CO., LTD.

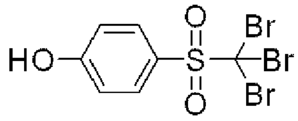

Int-1

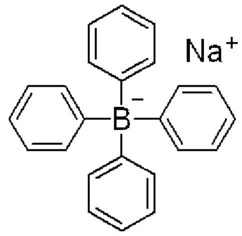

B - 1

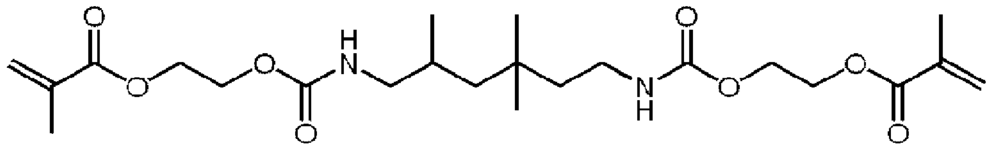

M - 1

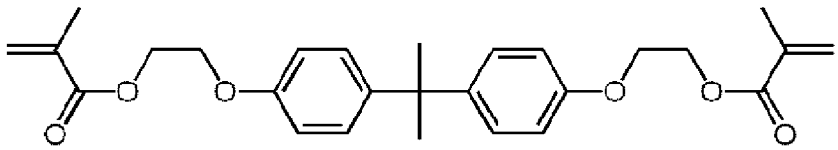

M - 2

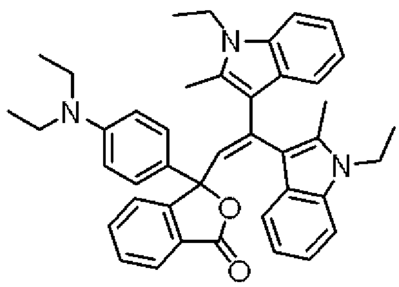

S - 3

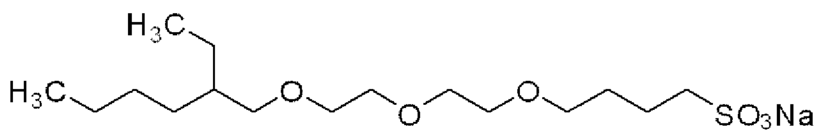

T - 2

<Formation of image-recording layer 3>

The undercoat layer was bar-coated with a coating liquid (3) for an image-recording layer having the following composition and dried in an oven at 100°C for 60 seconds, thereby forming an image-recording layer 3 having a thickness of 1.2 μm.

The coating liquid (3) for an image-recording layer was obtained by mixing and stirring together the following photosensitive solution (1) and microgel solution (1) immediately before coating.

(Photosensitive solution (1))

·Binder polymer (6) 23% by mass 1-methoxy-2-propanol solution (the following structure): 0.2891 parts
·Binder polymer (7) 23% by mass 1-methoxy-2-propanol solution (the following structure): 0.4574 parts
·Borate compound (1) (sodium tetraphenylborate): 0.015 parts
·Polymerization initiator (1) (the following structure): 0.2348 parts
·Polymerizable compound (1) (tris(acryloyloxyethyl)isocyanurate, NK ESTER A-9300 40% 2-butanone solution, manufactured by SHIN-NAKAMURA CHEMICAL CO, LTD.): 0.2875 parts
·Low-molecular-weight hydrophilic compound (1) (tris(2-hydroxyethyl) isocyanurate: 0.0287 parts
·Low-molecular-weight hydrophilic compound (2) (trimethylglycine): 0.0147 parts
·Anionic surfactant 1: 30% by mass aqueous solution (the following structure): 0.25 parts
·Ultraviolet absorber (1) (TINUVIN405, manufactured by BASF SE) (the following structure): 0.04 parts
·Fluorine-based surfactant (1) (the following structure): 0.004 parts
·Phosphonium compound (1) (the following structure): 0.020 parts
·2-Butanone: 5.346 parts
· 1-Methoxy-2-propanol: 3.128 parts
·Methanol: 0.964 parts
·Pure water: 0.036 parts

(Microgel solution (1))

· Microgel (1) (concentration of solid contents 21.8% by mass): 2.243 parts · 1-Methoxy-2-propanol: 0.600 parts

(Preparation of microgel (1))

A microgel (1) used in the aforementioned microgel solution was prepared by the following method.

<Preparation of polyvalent isocyanate compound (1)>

A polyvalent isocyanate compound (1) was prepared in the same manner as in <Preparation of polyvalent isocyanate compound (1)> in paragraphs "0517" and "0518" of WO2019/045084A.

<Preparation of microgel (1)>

A microgel (1) was prepared in the same manner as in <Preparation of microgel (4)> in paragraphs "0519" to "0521" of WO2019/045084A.

<Synthesis of binder polymer (6)>

A binder polymer (6) was synthesized in the same manner as in <Synthesis of binder polymer (6)> in paragraphs "0522" and "0523" of WO2019/045084A.

<Synthesis of binder polymer (7)>

A binder polymer (7) was synthesized in the same manner as in <Synthesis of binder polymer (7)> in paragraphs "0524" and "0525" of WO2019/045084A.

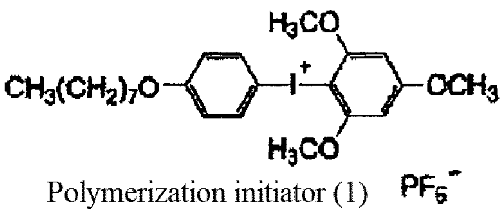

Polymerization initiator (1)

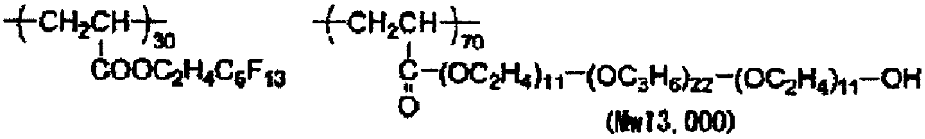

Fluorine-based surfactant (1)

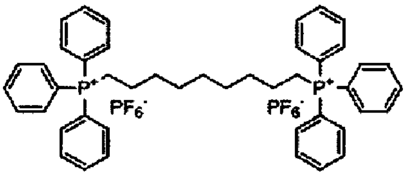

Phosphonium compound (1)

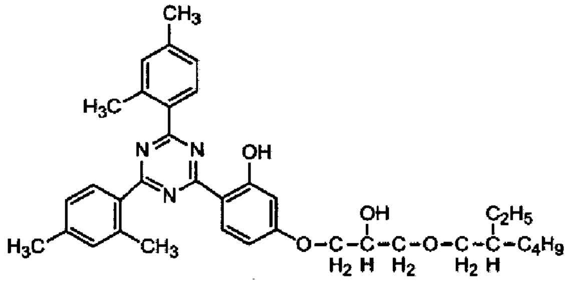

Ultraviolet absorber (1)

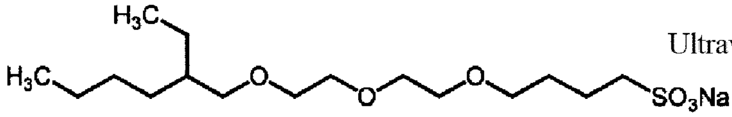

Anionic surfactant 1

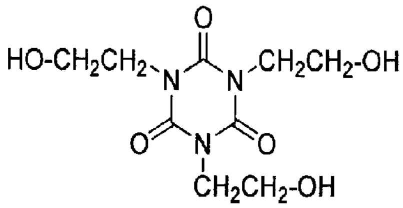

Low-molecular-weight hydrophilic compound (1)

$(CH_3)_3N^+CH_2COO^-$

Low-molecular-weight hydrophilic compound (2)

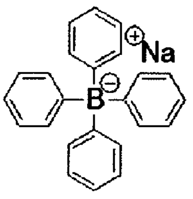

Borate compound (1)

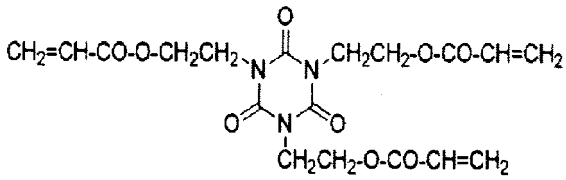

Polymerizable compound (1)

<Formation of protective layer 1>

The image-recording layer was bar-coated with a coating liquid (1) for a protective layer having the following composition and dried in an oven at 120°C for 60 seconds, thereby forming a protective layer having a dry coating amount of 0.15 g/m$^2$.

(Coating liquid (1) for protective layer)

- ·Inorganic lamellar compound dispersion (1) (described below): 1.5 parts
- ·Hydrophilic polymer (1) (the following structure, Mw: 30,000) (solid content): 0.03 parts
- ·6% by mass aqueous solution of polyvinyl alcohol (manufactured by NIHON GOSEI KAKO Co.,Ltd., CKS50, modified with sulfonic acid, saponification degree: 99 mol% or higher, degree of polymerization: 300): 0.10 parts
- ·6% by mass aqueous solution of polyvinyl alcohol (manufactured by KURARAY CO., LTD., PVA-405, saponification degree: 81.5 mol%, degree of polymerization: 500): 0.03 parts by mass

·Surfactant (EMALEX 710, manufactured by NIHON EMULSION Co., Ltd., the following structure, 1% by mass aqueous solution): 0.86 parts
·Deionized water: 6.0 parts

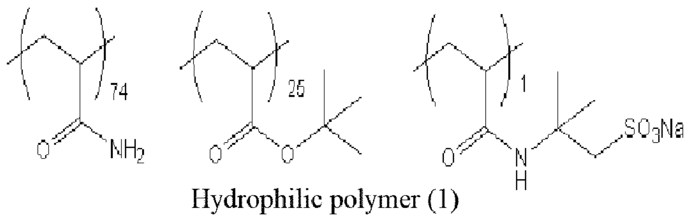

Hydrophilic polymer (1)

$C_{12}H_{25}$-$(OCH_2CH_2)_{10}$-OH EMALEX 710

(Preparation of inorganic lamellar compound dispersion (1))

Synthetic mica SOMASIF ME-100 manufactured by Co-op Chemical Co., Ltd., 6.4 parts) was added to 193.6 parts of deionized water and was dispersed using a homogenizer until the volume average particle diameter (the laser scattering method) reached 3 μm. The aspect ratio of the obtained dispersed particles was 100 or higher.

<Formation of protective layer 2>

The image-recording layer was bar-coated with a coating liquid (2) for a protective layer having the following composition and dried in an oven at 120°C for 60 seconds, thereby forming a protective layer having a dry coating amount of 0.10 g/m$^2$.

(Coating liquid (2) for protective layer)

·METOLOSE SM04*1: 0.050 parts
·FINE SPHERE FS-102*2: 0.265 parts
·RAPISOL A-80*3: 0.265 parts
·Pure water: 0.882 parts

*1: Methyl cellulose (methoxy substitution degree 1.8), METOLOSE (registered trademark) SM04 manufactured by Shin-Etsu Chemical Co., Ltd.
*2: An aqueous dispersion of styrene-acrylic resin particles having the following structure, glass transition temperature Tg 103°C, softening point 225°C, FINE SPHERE (registered trademark) FS-102 (21 % by mass) manufactured by Nipponpaint Industrial Coatings Co., LTD.
*3: Sodium di-2-ethylhexylsulfosuccinate, RAPISOL A-80 (80% by mass) manufactured by NOF CORPORATION

<Formation of Protective Layer 3>

The image-recording layer was bar-coated with a coating liquid (3) for a protective layer having the following composition and dried in an oven at 120°C for 60 seconds, thereby forming a protective layer 3 having a dry weight of 0.15 g/m$^2$.

(Coating liquid (3) for protective layer)

The coating liquid (3) for a protective layer contains the following components, and is prepared by adjusting the solid content to 6% by mass by using deionized water.

·Hydrophilic polymer WP-1*1: 0.70 parts

·Hydrophilic polymer WP-2*2: 0.20 parts
·Hydrophilic polymer WP-3*3: 0.20 parts
·Surfactant: (anionic surfactant, RAPISOL A-80, manufactured by NOF CORPORATION): 0.002 parts

*1: WP-1: polyvinyl alcohol, manufactured by Sigma-Aldrich Co. LLC., Mowiol 4-88

*2: WP-2: polyvinyl alcohol, manufactured by Sigma-Aldrich Co. LLC., Mowiol 8-88

*3: WP-3: the following resin (Mw 52,000)

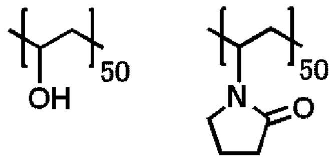

WP - 3

[Preparation of lithographic printing plate precursor]

The support, the undercoat layer, the image-recording layer, and the protective layer were combined as described in Table 1, thereby preparing lithographic printing plate precursors of Examples 1 to 36 and lithographic printing plate precursors of Comparative Examples 1 and 2.
The lithographic printing plate precursors of Examples 25, 26, and 32 to 36 were prepared by combining the support, the undercoat layer, the image-recording layer, and the protective layer as described in Table 1 and additionally forming the following backcoat layer 1.

<Formation of backcoat layer 1>

The side of the support opposite to the side of the specific constitutional layer was bar-coated with a coating liquid (1) for a backcoat layer having the following composition, followed by drying at 100°C for 30 seconds, thereby forming the backcoat layer 1 having a thickness of 1.2 μm.

(Coating liquid (1) for backcoat layer)

·Acrylic resin (BR-73, manufactured by Mitsubishi Chemical Corporation.): 11.072 parts
·Organically modified smectite (SUMECTON-SEN (flat plate particles), manufactured by KUNIMINE INDUSTRIES CO., LTD.): 0.500 parts
·Surfactant (RHEODOL TW-S106V (polyoxyethylene (6) sorbitan monostearate), manufactured by Kao Corporation.): 0.250 parts
·2-Butanone: 74.123 parts
·1-Methoxy-2-propanol: 8.720 parts
·Methanol: 4.360 parts

Table 1 also shows the arithmetic mean height Sa of the outermost layer surface (surface A) on the side of the at least one layer containing an infrared absorber with reference to the support and the arithmetic mean height Sa of the outermost layer surface (surface B) on the side opposite to the side of the at least one layer containing an infrared absorber with reference to the support. The arithmetic mean height Sa was evaluated as follows.

<Measurement of arithmetic mean height Sa>

The arithmetic mean height Sa was measured according to the method described in ISO 25178. That is, the heights of three or more sites selected in the same sample were measured using a MICROMAP MM3200-M100

manufactured by Mitsubishi Chemical Systems. Inc., and the average thereof was adopted as the arithmetic mean height Sa. Regarding the measurement range, a range of 1 cm × 1 cm randomly selected from the sample surface was measured.

In addition, the average particle diameter of the particles was a volume average particle diameter and measured as described above.

Table 1 also shows the HOMO of the specific infrared absorber. The HOMO was measured as described above.

[Table 1]

Table 1

| Example | Formulation | | | | | | Specific infrared absorber | | | | | | | | particles | | | | | | Shear droop amount | |
|---|---|---|---|---|---|---|---|---|---|---|---|---|---|---|---|---|---|---|---|---|---|---|
| | Support | Undercoat layer | Image-recording layer | Protective layer | Backcoat layer | Edge coating layer | Image-recording layer | | | | Protective layer | | | | Added layer | particles | | | Sa | | Shear droop amount X | Shear droop width Y |
| | | | | | | | Compound name | | | HOMO | Compound name | | | HOMO | | | | | Surface A | Surfaces B | | |
| | | | | | | | Type of mother nuclear structure | Counteranion Za | Content [parts by mass] | | Type of mother nuclear structure | Counteranion Za | Content [parts by mass] | | | Compound name | Content [parts by mass] | Average particle diameter [μm] | [μm] | [μm] | [μm] | [μm] |
| 1 | 1 | 1 | 1 | N/A | N/A | 1 | IR-01 | A-1 | 0.15 | -5.46 | N/A | N/A | - | - | Image-recording layer | TECHPOLYMER SSX-105 | 0.470 | 5.0 | 0.8 | 0.1 | 50 | 180 |
| 2 | 1 | 1 | 1 | N/A | N/A | 1 | IR-02 | A-1 | 0.15 | -5.48 | N/A | N/A | - | - | Image-recording layer | TECHPOLYMER SSX-105 | 0.470 | 5.0 | 0.8 | 0.1 | 50 | 180 |
| 3 | 1 | 1 | 1 | N/A | N/A | 1 | IR-03 | A-1 | 0.15 | -5.46 | N/A | N/A | - | - | Image-recording layer | TECHPOLYMER SSX-105 | 0.470 | 5.0 | 0.8 | 0.1 | 50 | 180 |
| 4 | 1 | 1 | 1 | N/A | N/A | 1 | IR-04 | A-1 | 0.15 | -5.44 | N/A | N/A | - | - | Image-recording layer | TECHPOLYMER SSX-105 | 0.470 | 5.0 | 0.8 | 0.1 | 50 | 180 |
| 5 | 1 | 1 | 1 | N/A | N/A | 1 | IR-05 | A-1 | 0.15 | -5.43 | N/A | N/A | - | - | Image-recording layer | TECHPOLYMER SSX-105 | 0.470 | 5.0 | 0.8 | 0.1 | 50 | 180 |
| 6 | 1 | 1 | 1 | N/A | N/A | 1 | IF-06 | A-1 | 0.15 | -5.46 | N/A | N/A | - | - | Image-recording layer | TECHPOLYMER SSX-105 | 0.470 | 5.0 | 0.8 | 0.1 | 50 | 180 |
| 7 | 1 | 1 | 1 | N/A | N/A | 1 | IR-07 | A-1 | 0.15 | -5.50 | N/A | N/A | - | - | Image-recording layer | TECHPOLYMER SSX-105 | 0.470 | 5.0 | 0.8 | 0.1 | 50 | 180 |
| 8 | 1 | 1 | 1 | N/A | N/A | 1 | IR-08 | A-1 | 0.15 | -5.50 | N/A | N/A | - | - | Image-recording layer | TECHPOLYMER SSX-105 | 0.470 | 5.0 | 0.8 | 0.1 | 50 | 180 |
| 9 | 1 | 1 | 1 | N/A | N/A | 1 | IR-09 | A-1 | 0.15 | -5.45 | N/A | N/A | - | - | Image-recording layer | TECHPOLYMER SSX-105 | 0.470 | 5.0 | 0.8 | 0.1 | 50 | 180 |
| 10 | 1 | 1 | 1 | N/A | N/A | 1 | IR-10 | A-1 | 0.15 | -5.45 | N/A | N/A | - | - | Image-recording layer | TECHPOLYMER SSX-105 | 0.470 | 5.0 | 0.8 | 0.1 | 50 | 180 |
| 11 | 1 | 1 | 1 | N/A | N/A | 1 | IR-11 | A-1 | 0.15 | -5.50 | N/A | N/A | - | - | Image-recording layer | TECHPOLYMER SSX-105 | 0.470 | 5.0 | 0.8 | 0.1 | 50 | 180 |
| 12 | 1 | 1 | 1 | N/A | N/A | 1 | IR-12 | A-1 | 0.15 | -5.46 | N/A | N/A | - | - | Image-recording layer | TECHPOLYMER SSX-105 | 0.470 | 5.0 | 0.8 | 0.1 | 50 | 180 |
| 13 | 1 | 1 | 1 | N/A | N/A | 1 | IR-13 | A-1 | 0.15 | -5.47 | N/A | N/A | - | - | Image-recording layer | TECHPOLYMER SSX-105 | 0.470 | 5.0 | 0.8 | 0.1 | 50 | 180 |
| 14 | 1 | 1 | 1 | N/A | N/A | 1 | IR-14 | A-1 | 0.15 | -5.45 | N/A | N/A | - | - | Image-recording layer | TECHPOLYMER SSX-105 | 0.470 | 5.0 | 0.8 | 0.1 | 50 | 180 |
| 15 | 1 | 1 | 1 | N/A | N/A | 1 | IR-15 | A-1 | 0.15 | -5.45 | N/A | N/A | - | - | Image-recording layer | TECHPOLYMER SSX-105 | 0.470 | 5.0 | 0.8 | 0.1 | 50 | 180 |
| 16 | 1 | 1 | 1 | N/A | N/A | 1 | IR-16 | - | 0.15 | -5.45 | N/A | N/A | - | - | Image-recording layer | TECHPOLYMER SSX-105 | 0.470 | 5.0 | 0.8 | 0.1 | 50 | 180 |
| 17 | 1 | 1 | 1 | N/A | N/A | 1 | IR-07 | A-2 | 0.15 | -5.50 | N/A | N/A | - | - | Image-recording layer | TECHPOLYMER SSX-105 | 0.470 | 5.0 | 0.8 | 0.1 | 50 | 180 |
| 18 | 1 | 1 | 1 | N/A | N/A | 1 | IR-07 | A-3 | 0.15 | -5.50 | N/A | N/A | - | - | Image-recording layer | TECHPOLYMER SSX-105 | 0.470 | 5.0 | 0.8 | 0.1 | 50 | 180 |
| 19 | 1 | 1 | 1 | N/A | N/A | 1 | IR-07 | A-4 | 0.15 | -5.50 | N/A | N/A | - | - | Image-recording layer | TECHPOLYMER SSX-105 | 0.470 | 5.0 | 0.8 | 0.1 | 50 | 180 |
| 20 | 1 | 1 | 1 | 1 | N/A | 1 | IR-07 | A-1 | 0.15 | -5.50 | N/A | N/A | - | - | Image-recording layer | TECHPOLYMER SSX-105 | 0.470 | 5.0 | 0.8 | 0.1 | 50 | 180 |

[Table 2]

Table 1 (continued)

| Example | Printing durability | | | Decomposition rate after passage of time | | Plate feeding properties in setter | Edge contamination |
|---|---|---|---|---|---|---|---|
| | Relative printing durability | | Δ printing durability reduction | Decomposition rate of specific infrared absorber [%] | | | |
| | No aging | After aging | | Image-recording layer | Protective layer | | |
| 1 | 100 | 89 | 11 | 24 | - | 5 | 5 |

(continued)

| Table 1 (continued) | | | | | | | |
|---|---|---|---|---|---|---|---|
| Example | Printing durability | | | Decomposition rate after passage of time | | Plate feeding properties in setter | Edge contamination |
| | Relative printing durability | | Δ printing durability reduction | Decomposition rate of specific infrared absorber [%] | | | |
| | No aging | After aging | | Image-recording layer | Protective layer | | |
| 2 | 100 | 93 | 7 | 15 | - | 5 | 5 |
| 3 | 100 | 91 | 9 | 20 | - | 5 | 5 |
| 4 | 100 | 87 | 13 | 29 | - | 5 | 5 |
| 5 | 100 | 85 | 15 | 33 | - | 5 | 4 |
| 6 | 100 | 91 | 9 | 20 | - | 5 | 5 |
| 7 | 100 | 95 | 5 | 11 | - | 5 | 5 |
| 8 | 100 | 96 | 4 | 9 | - | 5 | 5 |
| 9 | 100 | 88 | 12 | 26 | - | 5 | 5 |
| 10 | 100 | 86.0 | 14 | 31 | - | 5 | 4 |
| 11 | 100 | 94 | 6 | 13 | - | 5 | 5 |
| 12 | 100 | 90 | 10 | 22 | - | 5 | 5 |
| 13 | 100 | 92 | 8 | 18 | - | 5 | 5 |
| 14 | 100 | 89 | 11 | 24 | - | 5 | 5 |
| 15 | 100 | 86 | 14 | 31 | - | 5 | 4 |
| 16 | 100 | 85 | 15 | 33 | - | 5 | 4 |
| 17 | 100 | 94 | 6 | 13 | - | 5 | 5 |
| 18 | 100 | 95 | 5 | 11 | - | 5 | 5 |
| 19 | 100 | 94 | 6 | 13 | - | 5 | 5 |
| 20 | 100 | 100 | 0 | 0 | - | 5 | 5 |

[Table 3]

Table 1 (continued)

| Example | Formulation | | | | | | Specific infrared absorber | | | | | | | | particles | | | | | | Shear droop amount | |
|---|---|---|---|---|---|---|---|---|---|---|---|---|---|---|---|---|---|---|---|---|---|---|
| | Support | Undercoat layer | Image-recording layer | Protective layer | Backcoat layer | Edge coating layer | Image-recording layer | | | | Protective layer | | | | Added layer | Particles | | | Sa | | Shear droop amount X | Shear droop width Y |
| | | | | | | | Compound name | | | HOMO | Compound name | | | HOMO | | | | | Surface A | Surfaces B | | |
| | | | | | | | Type of mother nuclear structure | Counteranion Za | Content [parts by mass] | | Type of mother nuclear structure | Counteranion Za | Content [parts by mass] | | | Compound name | Content [parts by mass] | Average particle diameter [µm] | [µm] | [µm] | [µm] | [µm] |
| 21 | 1 | 1 | 1 | 2 | N/A | 1 | IR-07 | A-1 | 0.15 | -5.50 | N/A | N/A | - | - | Image-recording layer | TECHPOLYMER SSX-105 | 0.470 | 5.0 | 0.8 | 0.1 | 50 | 180 |
| 22 | 1 | 1 | 1 | N/A | N/A | 1 | IR-07 | A-1 | 0.15 | -5.50 | N/A | N/A | - | - | Image-recording layer | TECHPOLYMER SSX-104 | 0.470 | 4.0 | 0.7 | 0.1 | 50 | 180 |
| 23 | 1 | 1 | 1 | N/A | N/A | 1 | IR-07 | A-1 | 0.15 | -5.50 | N/A | N/A | - | - | Image-recording layer | TECHPOLYMER SSX-102 | 0.470 | 2.0 | 0.5 | 0.1 | 50 | 180 |
| 24 | 1 | 1 | 1 | N/A | N/A | 1 | IR-07 | A-1 | 0.15 | -5.50 | N/A | N/A | - | - | Image-recording layer | TECHPOLYMER SSX-101 | 0.470 | 1.0 | 0.3 | 0.1 | 50 | 180 |
| 25 | 1 | 1 | 1 | N/A | 1 | 1 | IR-07 | A-1 | 0.15 | -5.50 | N/A | N/A | - | - | Backcoat layer | TECHPOLYMER SSX-105 | 0.975 | 5.0 | 0.2 | 0.8 | 50 | 180 |
| 26 | 1 | 1 | 1 | N/A | 1 | 1 | IR-07 | A-1 | 0.15 | -5.50 | N/A | N/A | - | - | Backcoat layer | ART PERAL J-6PE | 0.975 | 4.2 | 0.2 | 0.7 | 50 | 180 |
| 27 | 1 | 1 | 1 | N/A | N/A | 1 | IR-07 | A-1 | 0.15 | -5.50 | N/A | N/A | - | - | Image-recording layer | TECHPOLYMER SSX-105 | 0.470 | 5.0 | 0.8 | 0.1 | 30 | 80 |
| 28 | 1 | 1 | 1 | N/A | N/A | 1 | IR-07 | A-1 | 0.15 | -5.50 | N/A | N/A | - | - | Image-recording layer | TECHPOLYMER SSX-105 | 0.470 | 5.0 | 0.1 | 0.1 | 145 | 280 |
| 29 | 2 | | 2 | 3 | N/A | 1 | IR-13 | A-1 | 0.15 | -5.47 | IR-17 | N/A | 0.02 | -5.56 | Image-recording layer | TECHPOLYMER SSX-105 | 0.470 | 5.0 | 0.7 | 0.1 | 50 | 180 |
| 30 | 2 | | 2 | 3 | N/A | 1 | IR-1C | A-1 | 0.15 | -5.31 | IR-17 | N/A | 0.02 | -5.56 | Image-recording layer | TECHPOLYMER SSX-105 | 0.470 | 5.0 | 0.7 | 0.1 | 50 | 180 |
| 31 | 2 | | 2 | 3 | N/A | 1 | IR-13 | A-1 | 0.15 | -5.47 | IR-17 | N/A | 0.02 | -5.56 | Protective layer | ART PERAL J-6PE | 0.470 | 6.2 | 1.1 | 0.1 | 50 | 180 |
| 32 | 3 | 2 | 3 | 1 | 1 | 2 | IR-13 | A-1 | 0.15 | -5.47 | N/A | N/A | - | - | Backcoat layer | ART PERAL J-6PE | 0.975 | 4.2 | 0.2 | 0.7 | 50 | 180 |
| 33 | 3 | 2 | 3 | 1 | 1 | 2 | IR-13 | A-2 | 0.15 | -5.47 | N/A | N/A | - | - | Backcoat layer | ART PERAL J-6PE | 0.975 | 4.2 | 0.2 | 0.7 | 50 | 180 |
| 34 | 3 | 2 | 3 | 1 | 1 | 2 | IR-13 | A-3 | 0.15 | -5.47 | N/A | N/A | - | - | Backcoat layer | ART PERAL J-6PE | 0.975 | 4.2 | 0.2 | 0.7 | 50 | 180 |
| 35 | 3 | 2 | 3 | 1 | 1 | 2 | IR-13 | A-4 | 0.15 | -5.47 | N/A | N/A | - | - | Backcoat layer | ART PERAL J-6PE | 0.975 | 4.2 | 02 | 0.7 | 50 | 180 |
| 36 | 1 | 1 | 1 | | 1 | 1 | IR-07 | A-1 | 0.15 | -5.50 | N/A | N/A | - | - | Image-recording layer/backcoat layer | TECHPOLYMER SSX-105/ART PEARL J-6PE | 0.470/0.975 | 5.0/4.2 | 0.8 | 0.7 | 50 | 180 |
| Comparative Example 1 | 1 | 1 | 1 | N/A | N/A | 1 | IR-2C | A-1 | 0.15 | -5.42 | N/A | N/A | - | - | Image-recording layer | TECHPOLYMER SSX-105 | 0.470 | 5.0 | 0.8 | 0.1 | - | - |
| Comparative Example 2 | 3 | 2 | 3 | 1 | N/A | 2 | IR-14 | A-2 | 0.15 | -5.45 | N/A | N/A | - | - | N/A | N/A | | - | 02 | 0.2 | - | - |

[Table 4]

Table 1 (continued)

| Example | Printing durability | | | Decomposition rate after passage of time | | Plate feeding properties in setter | Edge contamination |
|---|---|---|---|---|---|---|---|
| | Relative printing durability | | Δ printing durability reduction | Decomposition rate of specific infrared absorber [%] | | | |
| | No aging | After aging | | Image-recording layer | Protective layer | | |
| 21 | 100 | 97 | 3 | 7 | - | 5 | 5 |
| 22 | 100 | 95 | 5 | 11 | - | 5 | 5 |
| 23 | 100 | 94 | 6 | 13 | - | 4 | 5 |
| 24 | 100 | 95 | 5 | 11 | - | 3 | 5 |
| 25 | 100 | 95 | 5 | 11 | - | 5 | 5 |
| 26 | 100 | 95 | 5 | 11 | - | 5 | 5 |
| 27 | 100 | 95 | 5 | 11 | - | 5 | 5 |

(continued)

Table 1 (continued)

| Example | Printing durability | | | Decomposition rate after passage of time | | Plate feeding properties in setter | Edge contamination |
|---|---|---|---|---|---|---|---|
| | Relative printing durability | | Δ printing durability reduction | Decomposition rate of specific infrared absorber [%] | | | |
| | No aging | After aging | | Image-recording layer | Protective layer | | |
| 28 | 100 | 95 | 5 | 11 | - | 5 | 4 |
| 29 | 100 | 97 | 3 | 7 | 12 | 5 | 5 |
| 30 | 100 | 87 | 13 | 29 | 13 | 5 | 5 |
| 31 | 100 | 97 | 3 | 7 | 11 | 5 | 5 |
| 32 | 100 | 97 | 3 | 7 | - | 5 | 5 |
| 33 | 100 | 96 | 4 | 9 | - | 5 | 5 |
| 34 | 100 | 95 | 5 | 11 | - | 5 | 5 |
| 35 | 100 | 94 | 6 | 13 | - | 5 | 5 |
| 36 | 100 | 95 | 5 | 11 | - | 5 | 5 |
| Comparative Example 1 | 100 | 80 | 20 | 44 | - | 5 | - |
| Comparative Example 2 | 100 | 94 | 6 | 13 | - | 1 | - |

In Table 1, the layer to which the specific infrared absorber or particles are added represents a constitutional layer (an image-recording layer, a protective layer, or a backcoat layer) of the lithographic printing plate precursor containing the specific infrared absorber or particles. The constitutional layer can be formed by adding the specific infrared absorber or particles to a coating liquid for the corresponding constitutional layer to prepare a coating liquid, and performing coating with the coating liquid.

Regarding the specific infrared absorber, table 1 shows whether or not the image-recording layer or the protective layer contains the specific infrared absorber.

The mother nucleus structure constituting the specific infrared absorber shown in Table 1 and the counteranion Za will be described below.

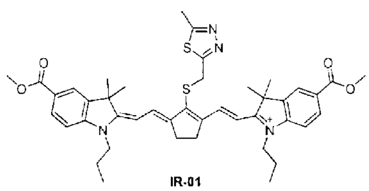

IR-01

HOMO=-5.46eV

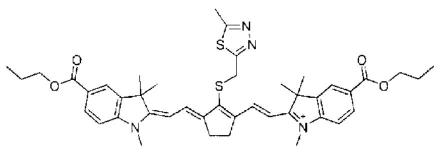

IR-02

HOMO=-5.48eV

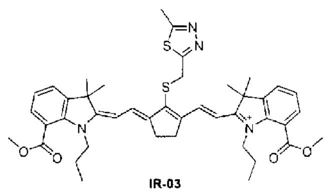

IR-03

HOMO=-5.46eV

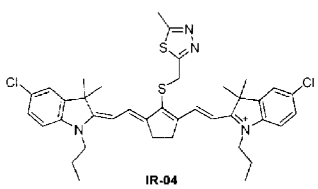

IR-04

HOMO=-5.44eV

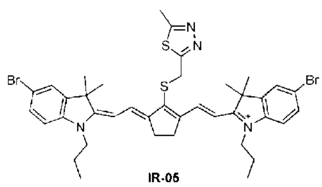

IR-05

HOMO=-5.43eV

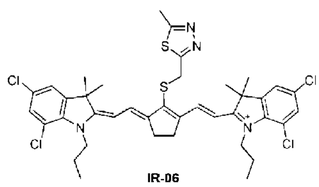

IR-06

HOMO=-5.46eV

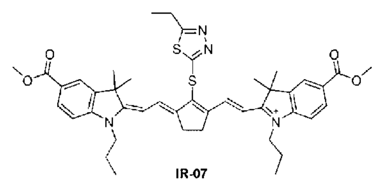

IR-07
HOMO=-5.50eV

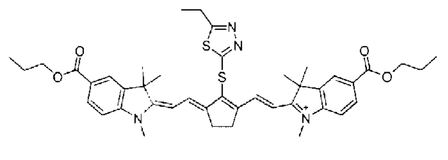

IR-08
HOMO=-5.50eV

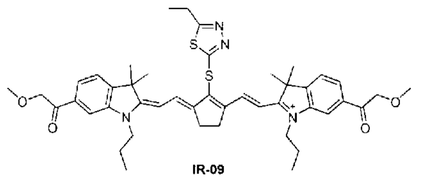

IR-09
HOMO=-5.45eV

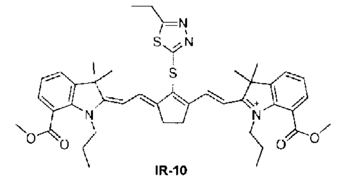

IR-10
HOMO=-5.45eV

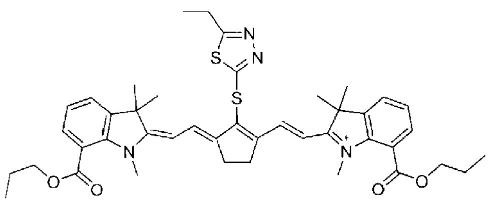

IR-11
HOMO=-5.50eV

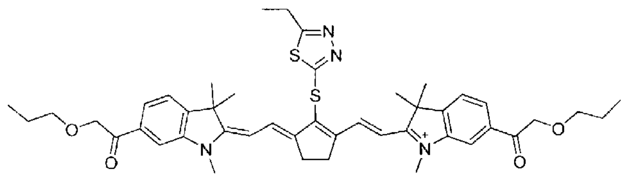

IR-12
HOMO=-5.46eV

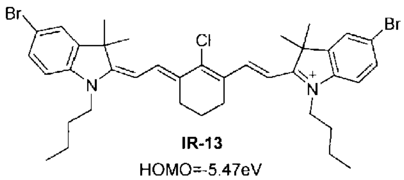

IR-13
HOMO=-5.47eV

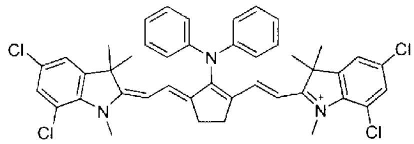

IR-14
HOMO=-5.45eV

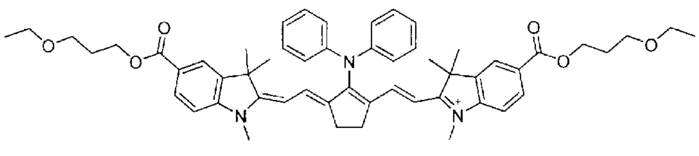

IR-15
HOMO=-5.45eV

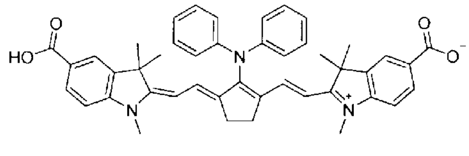

IR-16
HOMO=-5.45eV

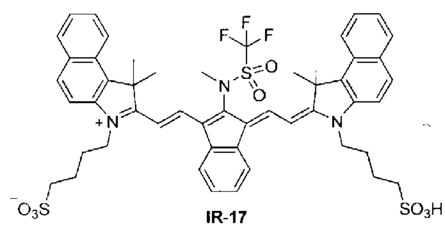

IR-17
HOMO=-5.56eV

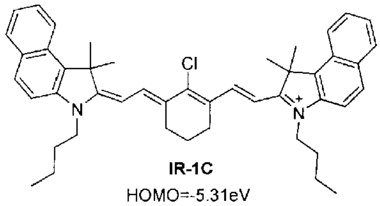

IR-1C

HOMO=-5.31eV

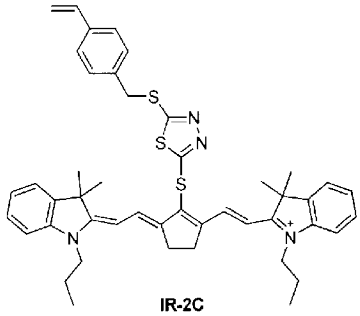

IR-2C

HOMO=-5.42eV

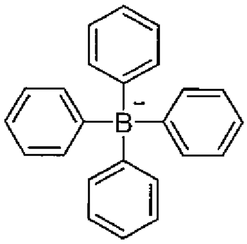

A-1

$PF_6^-$

A-2

$BF_4^-$

A-3

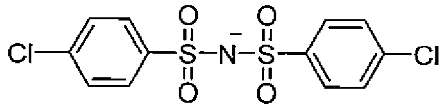

A-4

Note that IR-1C and IR-2C are not included in the mother nucleus structure of the specific infrared absorber, but are described as the specific infrared absorber for convenience.

The particles listed in Table 1 are described below.

- ·TECHPOLYMER SSX-105: manufactured by Sekisui Kasei Co., Ltd.
- ·TECHPOLYMER SSX-104: manufactured by Sekisui Kasei Co., Ltd.
- ·TECHPOLYMER SSX-102: manufactured by Sekisui Kasei Co., Ltd.
- ·TECHPOLYMER SSX-101: manufactured by Sekisui Kasei Co., Ltd.
- ·ART PEARL J-6PE: manufactured by Negami Chemical Industrial Co., Ltd.
- ·ART PEARL J-7PS: manufactured by Negami Chemical Industrial Co., Ltd.

<Forced aging conditions>

In order to evaluate the temporal stability in a printing plate storage environment, aged samples were created under the following forced conditions and used for each evaluation. In an environment of a temperature of 27°C, a relative humidity of 70%, and an ozone concentration of 75 ppb, the lithographic printing plate precursor was left to stand for 4 hours in a state where the side of the layer containing the specific infrared absorber was exposed to the air (corresponding to a case where the precursor is left in a normal environment (a temperature 25°C and a relative humidity 50%) for 12 months.).

<Printing durability evaluation>

In Luxel PLATESETTER T-6000III manufactured by FUJIFILM Corporation that was equipped with an infrared semiconductor laser, the lithographic printing plate precursors of Examples 1 to 36 and Comparative Examples 1 and 2 were exposed under the conditions of an outer drum rotation speed of 1,000 rpm, a laser output of 70%, and resolution of 2,400 dpi. As the exposure image, a chart including a solid image, 50% halftone dots, and a non-image area was used.

The lithographic printing plate precursor having undergone image exposure was mounted on an offset rotary printer manufactured by TOKYO KIKAI SEISAKUSHO, LTD., and printing was performed on newsprints at a speed of 100,000 sheets/hour by using SOYBI KKST-S (red) manufactured by Inktech Corporation as a printing ink for newspaper and ALKY manufactured by TOYO INK CO., LTD. as dampening water. As the number of printed sheets increased, the image-recording layer gradually worn out, and thus the ink density on the printed matter decreased.

The number of sheets printed until the value obtained by measuring a halftone dot area ratio of the FM screen 50% halftone dots in the printed matter was 5% lower than the measured value of the 100th printed sheet was measured. The number of sheets printed until the 50% halftone dot area is reduced by 5% was determined as a printing end point, the number of printed sheets at the printing end point obtained using the unaged sample A was denoted by (a), the number of

printed sheets at the printing end point obtained using the aged sample B was denoted by (b), and the relative printing durability of the aged sample was determined by the following formula. At this time, the relative printing durability of the sample A is 100.

$$\text{Relative printing durability} = (b)/(a) \times 100$$

In addition, a value obtained by subtracting the relative printing durability of the aged sample B from the relative printing durability of the sample A is described as a Δ printing durability reduction. In a case where the Δ printing durability reduction is 15 or less, the printing durability is excellent.

The obtained results are shown in Table 1.

<Decomposition rate of specific infrared absorber after passage of time>

The decomposition rate of the infrared absorber is measured by the following method.

The unaged lithographic printing plate precursor A and the aged sample B were cut in a size of 60 $cm^2$, and subjected to extraction with 5 mL of acetonitrile in an ultrasonic bath for 30 minutes. The obtained extracts A and B were subjected to HPLC analysis through a 0.20 mm filter. Peak areas of the specific infrared absorbers of the extracts A and B obtained by the HPLC analysis (a peak area (A) of the unaged specific infrared absorber and a peak area (B) of the aged specific infrared absorber) are plugged into the following Formula 1 to determine a decomposition rate (C) of the specific infrared absorber.

$$\text{Formula 1: } (C) = 100-[(B)/(A) \times 100]$$

The HPLC analysis is performed under the following conditions.

·Device: Alliance 2695, Waters Corporation
·Column: Mightysil RP-18GP 250 mm × φ4.6 mm (5 μm), KANTO CHEMICAL CO., INC.
·Column temperature: 40°C
·Eluent: <A> MeOH (containing 0.1% by mass acetic acid + 0.1% by mass triethylamine), <B> $H_2O$ (containing 0.1% by mass acetic acid + 0.1% by mass triethylamine)
·Gradient: <A/B> = 30/70 (0 min) -100/0 (28 min) - 100/0 (40 min) - 30/70 (40.1 min) equilibration
·Flow rate: 1.0 mL/min
·Injection amount: 10 mL
·UV detector: PDA 2998, Waters Corporation

The obtained results are shown in Table 1.

<Plate feeding properties in setter (plate feeding properties)>

A laminate obtained by stacking 100 lithographic printing plate precursors in the same direction without using interleaving paper was set in a CTP platesetter "AMZIsetter" manufactured by NEC Engineering, Ltd., and an operation of taking out the precursors one by one from the uppermost portion of the laminate was performed 100 times in succession. Based on the following standard, the plate-handling properties imparted during this operation was evaluated. The evaluation was performed by sensory evaluation on a scale of 1 to 5, where 3 to 5 were regarded as practical levels, and 2 and 1 were regarded as non-practical levels.

5: None of the plates are lifted together with the next plate when raised.

4: The proportion of plates that are lifted together with the next plate when raised and are not immediately detached is equal to or less than 1% of all the plates.

3: The proportion of plates that are lifted together with the next plate when raised and are not peeled off by the first handling operation is equal to or less than 1% of all the plates.

2: The proportion of plates that are lifted together with the next plate when raised and are not peeled off by the first handling operation is more than 1% and equal to or less than 5% of all the plates.

1: The proportion of plates that are lifted together with the next plate when raised and are not peeled off by the first handling operation is more than 5% of all the plates.

The obtained results are shown in Table 1.

In addition, the edge contamination preventiveness of the lithographic printing plate precursor was also evaluated as follows.

<Cutting of lithographic printing plate precursor>

The lithographic printing plate precursors of Examples 1 to 36 were cut using the rotary blades shown in Fig. 4 with adjusting the gap between the upper cutting blade and the lower cutting blade, the intrusion amounts of the blades, and the tip angle of the blades.

Table 1 shows a shear droop amount X and a shear droop width Y of the shear droop shape.

<Formation of edge layer 1>

Coating was performed using a composition 1 under the following coating condition 1, thereby forming an edge layer 1.

(Coating condition 1)

Coating was performed by the coating method shown in Fig. 7. The wire bar was installed such that it was perpendicular to the lithographic printing plate precursor ($\theta = 0°$), and coating was performed. The coating was carried out by the following procedure.

[1] HN-GV (manufactured by FUJIFILM Global Graphic Systems Co. Ltd.) was uniformly added dropwise to an area of 1 $cm^3$ of the #10 wire bar.
[2] The wire bar was moved at 20 mm/s along the lateral surface of the lithographic printing plate precursor. At this time, the wire bar was installed such that it was perpendicular to the lithographic printing plate precursor ($\theta = 0°$).
[3] The lithographic printing plate precursor was dried by being exposed to air of 80°C at 6 m/s for 30 seconds.
[4] Only the lateral surface of the lithographic printing plate precursor could be coated. At this time, the coating amount of the composition 1 was 120 $mg/m^2$.
[5] A variation Z in the coating width from the end part of the lithographic printing plate precursor was Z = 0.1 mm.

The composition 1 contains the following components.

·Deionized water: 75.00 parts
·Penon JE66*1: 12.95 parts
·NISSAN ANON BDF-SF*2: 9.50 parts
·Sodium hexametaphosphate: 2.50 parts
·Bioden ZNS*3: 0.05 parts

*1: Etherified starch (Nippon Starch Chemical Co., Ltd.)
*2: Cocamidopropyl betaine (NOF Corporation)
*3: Disinfectant or biobactericide (Daiwa Chemical Industries Corporation)

The variation Z is obtained based on "0186" and "0187" of JP6628949B.

<Formation of edge layer 2>

An edge layer 2 was formed in the same manner as the edge layer 1, except that an ink repellent (1) was used instead of the composition 1 in the coating condition 1.

·Ink repellent (1) HN-G5 (manufactured by FUJIFILM Corporation)

The lithographic printing plate precursor with an end part having a shear droop shape and the edge layer were combined as shown in Table 1, thereby preparing a lithographic printing plate precursor for measuring edge contamination preventiveness after the passage of time.

<Edge contamination preventiveness, after passage of time>

The obtained lithographic printing plate precursor was aged, thereby obtaining a sample B. In Luxel PLATESETTER T-6000III manufactured by FUJIFILM Corporation that was equipped with an infrared semiconductor laser, the

sample B was exposed under the conditions of an outer drum rotation speed of 1,000 rpm, a laser output of 70%, and resolution of 2,400 dpi. As the exposure image, a chart including a solid image, 50% halftone dots, and a non-image area was used.

The lithographic printing plate precursor having undergone image exposure was mounted on an offset rotary printer manufactured by TOKYO KIKAI SEISAKUSHO, LTD., and printing was performed on news prints at a speed of 100,000 sheets/hour by using SOYBI KKST-S (red) manufactured by Inktech Corporation as a printing ink for newspaper and ALKY manufactured by TOYO INK CO., LTD. as dampening water. The 1,000th printed matter was sampled with a water level gauge 1.1 times the water level gauge for removing scumming, and the degree of linear contamination caused by the end part of the lithographic printing plate precursor was evaluated based on the following standard. The results are shown in Table 1 as an edge contamination preventiveness, no aging.

5: No contamination
4: Intermediate level between 5 and 3
3: Slight contamination has occurred but is at an acceptable level.
2: Intermediate level between 3 and 1 (acceptable level)
1: Marked contamination which is at an unacceptable level

The obtained results are shown in Table 1.

From the results described in Table 1, it has been confirmed that the lithographic printing plate precursor which constitutes the laminate according to an embodiment of the present invention and has at least one layer containing the specific infrared absorber exhibits excellent printing durability after the passage of time, and is excellently fed from the laminate in a setter.

In addition, it has been confirmed that the suppression of the decomposition rate of the specific infrared absorber after the passage of time results in the excellent printing durability of the lithographic printing plate precursor.

On the other hand, the lithographic printing plate precursor of Comparative Example 1 containing an infrared absorber other than the specific infrared absorber exhibits poor printing durability after the passage of time. In addition, it has been confirmed that from the laminate of Comparative Example 2 in which the arithmetic mean height Sa of the outermost layer surface of the lithographic printing plate precursor is outside the range of the present invention, plates are poorly fed in a setter.

It has been confirmed that using the lithographic printing plate precursor having a predetermined shear droop shape results in excellent edge contamination properties after the passage of time.

According to an embodiment of the present invention, it is possible to provide a laminate that allows a negative tone lithographic printing plate precursor to exhibit excellent printing durability after the passage of time and allows the precursor to be excellently fed in a setter, and to provide a method of preparing a negative tone lithographic printing plate.

## Explanation of References

[0431] 1: lithographic printing plate precursor
1a: image-recording layer surface
1b: support surface
1c: edge surface
2: shear droop
10: cutting blade
10a: upper cutting blade
10b: upper cutting blade
11: rotary shaft
20: cutting blade
20a: lower cutting blade
20b: lower cutting blade
21: rotary shaft
30: lithographic printing plate precursor
31: aluminum plate
32, 34: roller-shaped brush
33: abrasive slurry
35, 36, 37, 38: support roller
50: main electrolytic cell

51: alternating current power source
52: radial drum roller
53a, 53b: main pole
54: electrolytic solution supply port
55: electrolytic solution
56: slit
57: electrolytic solution path
58: auxiliary anode
60: auxiliary anode tank
410: anodization treatment device
412: power supply tank
414: electrolytic treatment tank
416: aluminum plate
418, 426: electrolytic solution
420: power supply electrode
422, 428: roller
424: nip roller
430: electrolysis electrode
432: cell wall
434: direct current power source
B: boundary between image-recording layer surface and support
W: aluminum plate
X: shear droop amount
Y: shear droop width
100a: lithographic printing plate precursor
120: edge surface
122: outermost layer surface on specific constitutional layer side with reference to support
138: wire bar
θ: angle

## Claims

1. A laminate of negative tone lithographic printing plate precursors each having at least one layer containing an infrared absorber with a HOMO of -5.47 eV or less on a hydrophilic support,
wherein in each of the negative tone lithographic printing plate precursors, at least one of an outermost layer surface on a side of the at least one layer containing an infrared absorber with reference to the support or an outermost layer surface on a side opposite to the side of the at least one layer containing an infrared absorber has an arithmetic mean height Sa of 0.3 μm or more and 20 μm or less.

2. The laminate according to claim 1,

wherein the infrared absorber is a compound represented by the following Formula (1),

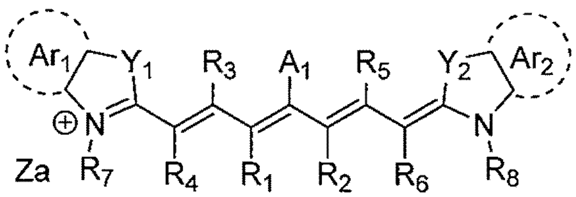

(1)

wherein $R_1$ and $R_2$ each independently represent a hydrogen atom or an alkyl group, $R_1$ and $R_2$ may be linked to each other to form a ring, $R_3$ to $R_6$ each independently represent a hydrogen atom or an alkyl group, $R_7$ and $R_8$ each independently represent an alkyl group or an aryl group, $Y_1$ and $Y_2$ each independently represent an oxygen atom, a sulfur atom, $-NR_0-$, or a dialkyl methylene group, $R_0$ represents a hydrogen atom, an alkyl group, or an aryl group, $Ar_1$ and $Ar_2$ each independently represent a group forming a benzene ring or a naphthalene ring that may have a group represented by the following Formula 2, $A_1$ represents $-NR_9R_{10}$, $-X_1-X_{11}-L_1$, or a group represented by the following Formula 2,

$R_9$ and $R_{10}$ each independently represent an alkyl group, an aryl group, an alkoxycarbonyl group, an arylsulfonyl group, or a trihaloalkylsulfonyl group, $X_1$ represents an oxygen atom or a sulfur atom, $X_{11}$ represents a single bond or an alkylene group, $L_1$ represents a hydrocarbon group, a heteroaryl group, or a group that undergoes bond cleavage from $X_1$ by heat or exposure to infrared, Za represents a counterion that neutralizes charge,

-X        Formula 2

X represents a halogen atom, $-C(=O)-X_2-R_{11}$, $-C(=O)-NR_{12}R_{13}$, $-O-C(=O)-R_{14}$, -CN,$-SO_2NR_{15}R_{16}$, or a perfluoroalkyl group, $X_2$ represents a single bond or an oxygen atom, $R_{11}$ represents a hydrogen atom, an alkyl group, or an aryl group, $R_{14}$ represents an alkyl group or an aryl group, and $R_{12}$, $R_{13}$, $R_{15}$, and $R_{16}$ each independently represent a hydrogen atom, an alkyl group, or an aryl group.

**3.** The laminate according to claim 2,

wherein in the Formula (1), $A_1$ is $-NR_{17}R_{18}$ or $-S-X_{12}-R_{19}$,
$R_{17}$ and $R_{18}$ each independently represent an aryl group,
$R_{19}$ represents a hydrocarbon group or a heteroaryl group, and
$X_{12}$ represents a single bond or an alkylene group.

**4.** The laminate according to claim 2 or 3,

wherein X in the Formula 2 is a fluorine atom, a chlorine atom, a bromine atom, or - $C(=O)OR_{20}$, and
$R_{20}$ represents a hydrogen atom, an alkyl group, or an aryl group.

**5.** The laminate according to any one of claims 1 to 4,

wherein each of the lithographic printing plate precursors has an image-recording layer,
the at least one layer containing an infrared absorber is the image-recording layer, and
the image-recording layer contains a polymerization initiator, a polymerizable compound, and a polymer compound.

**6.** The laminate according to claim 5,
wherein the polymer compound is a polymer compound containing at least one of a constitutional unit derived from a styrene compound or a constitutional unit derived from an acrylonitrile compound.

**7.** The laminate according to claim 5 or 6,
wherein the image-recording layer contains at least one kind of particles having an average particle diameter of 0.5 μm or more and 20 μm or less.

**8.** The laminate according to any one of claims 5 to 7,
wherein each of the lithographic printing plate precursors has a protective layer on the image-recording layer.

**9.** The laminate according to claim 8,
wherein the protective layer contains at least one kind of particles having an average particle diameter of 0.5 μm or more and 20 μm or less.

**10.** The laminate according to any one of claims 5 to 9,
wherein the outermost layer on the side opposite to the side of the at least one layer containing an infrared absorber with reference to the support contains at least one kind of particles having an average particle diameter of 0.5 μm or more and 20 μm or less.

**11.** The laminate according to any one of claims 5 to 10,

wherein the support is an aluminum support having an anodic oxide film,
micropores in the anodic oxide film of the support are each composed of a large diameter portion that extends to a position at a depth of 10 nm to 1,000 nm from a surface of the anodic oxide film and a small diameter portion that is in communication with a bottom portion of the large diameter portion and extends to a position at a depth of 20 nm to 2,000 nm from a communicate position,

an average diameter of the large diameter portion within the surface of the anodic oxide film is 15 nm to 100 nm, and
an average diameter of the small diameter portion at the communicate position is 13 nm or less.

**12.** The laminate according to any one of claims 5 to 10,

wherein the support is an aluminum support having an anodic oxide film,
micropores in the anodic oxide film of the support are each composed of a small diameter portion that extends to a position at a depth of 10 nm to 1,000 nm from a surface of the anodic oxide film and a large diameter portion that is in communication with a bottom portion of the small diameter portion and extends to a position at a depth of 20 nm to 2,000 nm from a communicate position,
an average diameter of the small diameter portion within the surface of the anodic oxide film is 35 nm or less, and
an average diameter of the large diameter portion is 40 to 300 nm.

**13.** The laminate according to any one of claims 5 to 12,
wherein the laminate is composed of a plurality of the lithographic printing plate precursors directly stacked without intervention of interleaving paper.

**14.** A method of preparing a negative tone lithographic printing plate, comprising:

a step of taking out the lithographic printing plate precursor from the laminate according to any one of claims 5 to 13;
a step of performing image exposure on the lithographic printing plate precursor; and
a step of supplying at least one of a printing ink or dampening water to remove a non-exposed portion of the image-recording layer in the lithographic printing plate precursor.

**Patentansprüche**

**1.** Laminat aus Negativton-lithographischen Druckplattenvorläufern, die jeweils mindestens eine Schicht auf einem hydrophilen Träger aufweisen, die einen Infrarotabsorber mit einem HOMO von -5,47 eV oder weniger enthält, wobei bei jedem der Negativton-lithographischen Druckplattenvorläufer mindestens eine von einer äußersten Schichtoberfläche auf einer Seite der mindestens einen Schicht, die einen Infrarotabsorber enthält, in Bezug auf den Träger und einer äußersten Schichtoberfläche auf einer Seite, die der Seite der mindestens einen Schicht, die einen Infrarotabsorber enthält, gegenüberliegt, eine arithmetische Mittelhöhe Sa von 0,3 μm oder mehr und 20 μm oder weniger aufweist.

**2.** Laminat nach Anspruch 1,

wobei der Infrarotabsorber eine Verbindung ist, die durch die folgende Formel (1) dargestellt wird,

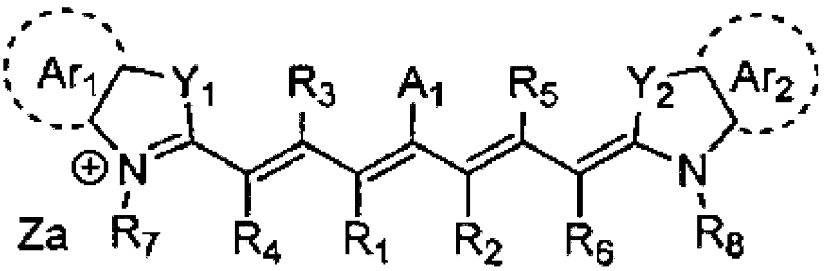

(1)

wobei $R_1$ und $R_2$ jeweils unabhängig voneinander ein Wasserstoffatom oder eine Alkylgruppe darstellen, $R_1$ und $R_2$ miteinander verbunden sein können, um einen Ring zu bilden, $R_3$ bis $R_6$ jeweils unabhängig voneinander ein Wasserstoffatom oder eine Alkylgruppe darstellen, $R_7$ und $R_8$ jeweils unabhängig voneinander eine Alkylgruppe oder eine Arylgruppe darstellen, $Y_1$ und $Y_2$ jeweils unabhängig voneinander ein Sauerstoffatom, ein Schwefelatom, $-NR_0-$ oder eine Dialkylmethylen-Gruppe darstellen, $R_0$ ein Wasserstoffatom, eine Alkylgruppe oder eine Arylgruppe darstellt, $Ar_1$ und $Ar_2$ jeweils unabhängig voneinander eine Gruppe, die einen Benzolring oder einen Naphthalinring bildet, der eine durch die folgende Formel 2 dargestellte Gruppe aufweisen kann, darstellen, $A_1$

$-NR_9R_{10}$, $-X_1-X_{11}-L_1$ oder eine Gruppe, die durch die folgende Formel 2 dargestellt wird, darstellt, $R_9$ und $R_{10}$ jeweils unabhängig voneinander eine Alkylgruppe, eine Arylgruppe, eine Alkoxycarbonylgruppe, eine Arylsulfonylgruppe oder eine Trihaloalkylsulfonylgruppe darstellen, $X_1$ ein Sauerstoffatom oder ein Schwefelatom darstellt, $X_{11}$ eine Einfachbindung oder eine Alkylengruppe darstellt, $L_1$ eine Kohlenwasserstoffgruppe, eine Heteroarylgruppe oder eine Gruppe darstellt, die eine Bindungsspaltung von $X_1$ durch Wärme oder Einwirkung von Infrarot eingeht, Za ein Gegenion, das Ladung neutralisiert, darstellt,

-X Formel 2

X ein Halogenatom, $-C(=O)-X_2-R_{11}$, $-C(=O)-NR_{12}R_{13}$, $-O-C(=O)-R_{14}$, -CN, $-SO_2NR_{15}R_{16}$ oder eine Perfluoralkylgruppe darstellt, $X_2$ eine Einfachbindung oder ein Sauerstoffatom darstellt, $R_{11}$ ein Wasserstoffatom, eine Alkylgruppe oder eine Arylgruppe darstellt, $R_{14}$ eine Alkylgruppe oder eine Arylgruppe darstellt und $R_{12}$, $R_{13}$, $R_{15}$ und $R_{16}$ jeweils unabhängig voneinander ein Wasserstoffatom, eine Alkylgruppe oder eine Arylgruppe darstellen.

**3.** Laminat nach Anspruch 2,

wobei in der Formel (1) $A_1$ $-NR_{17}R_{18}$ oder $-S-X_{12}-R_{19}$ ist,
$R_{17}$ und $R_{18}$ jeweils unabhängig voneinander eine Arylgruppe darstellen,
$R_{19}$ eine Kohlenwasserstoffgruppe oder eine Heteroarylgruppe darstellt, und
$X_{12}$ eine Einfachbindung oder eine Alkylengruppe darstellt.

**4.** Laminat nach Anspruch 2 oder 3,

wobei X in der Formel 2 ein Fluoratom, ein Chloratom, ein Bromatom oder $-C(=O)OR_{20}$ ist, und
$R_{20}$ ein Wasserstoffatom, eine Alkylgruppe oder eine Arylgruppe darstellt.

**5.** Laminat nach einem der Ansprüche 1 bis 4,

wobei jeder der lithographischen Druckplattenvorläufer eine Bildaufzeichnungsschicht aufweist,
die mindestens eine Schicht, die einen Infrarotabsorber enthält, die Bildaufzeichnungsschicht ist, und
die Bildaufzeichnungsschicht einen Polymerisationsinitiator, eine polymerisierbare Verbindung und eine Polymerverbindung enthält.

**6.** Laminat nach Anspruch 5,
wobei die Polymerverbindung eine Polymerverbindung ist, die mindestens eine von einer Konstitutionseinheit, die von einer Styrolverbindung abgeleitet ist, und einer Konstitutionseinheit, die von einer Acrylnitrilverbindung abgeleitet ist, enthält.

**7.** Laminat nach Anspruch 5 oder 6,
wobei die Bildaufzeichnungsschicht mindestens eine Art von Partikeln mit einem durchschnittlichen Partikeldurchmesser von 0,5 μm oder mehr und 20 μm oder weniger enthält.

**8.** Laminat nach einem der Ansprüche 5 bis 7,
wobei jeder der lithographischen Druckplattenvorläufer eine Schutzschicht auf der Bildaufzeichnungsschicht aufweist.

**9.** Laminat nach Anspruch 8,
wobei die Schutzschicht mindestens eine Art von Partikeln mit einem durchschnittlichen Partikeldurchmesser von 0,5 μm oder mehr und 20 μm oder weniger enthält.

**10.** Laminat nach einem der Ansprüche 5 bis 9,
wobei die äußerste Schicht auf der Seite, die der Seite der mindestens einen Schicht, die einen Infrarotabsorber enthält, gegenüberliegt, in Bezug auf den Träger mindestens eine Art von Partikeln mit einem durchschnittlichen Partikeldurchmesser von 0,5 μm oder mehr und 20 μm oder weniger enthält.

**11.** Laminat nach einem der Ansprüche 5 bis 10,

wobei der Träger ein Aluminiumträger mit einem anodischen Oxidfilm ist,
Mikroporen in dem anodischen Oxidfilm des Trägers jeweils aus einem Abschnitt mit großem Durchmesser, der sich zu einer Position in einer Tiefe von 10 nm bis 1.000 nm von einer Oberfläche des anodischen Oxidfilms erstreckt, und einem Abschnitt mit kleinem Durchmesser, der mit einem Bodenabschnitt des Abschnitts mit großem Durchmesser in Kommunikation steht und sich zu einer Position in einer Tiefe von 20 nm bis 2.000 nm von einer Kommunikationsposition erstreckt, aufgebaut sind,
ein durchschnittlicher Durchmesser des Abschnitts mit großem Durchmesser innerhalb der Oberfläche des anodischen Oxidfilms 15 nm bis 100 nm beträgt, und
ein durchschnittlicher Durchmesser des Abschnitts mit kleinem Durchmesser an der Kommunikationsposition 13 nm oder weniger beträgt.

**12.** Laminat nach einem der Ansprüche 5 bis 10,

wobei der Träger ein Aluminiumträger mit einem anodischen Oxidfilm ist,
Mikroporen in dem anodischen Oxidfilm des Trägers jeweils aus einem Abschnitt mit kleinem Durchmesser, der sich zu einer Position in einer Tiefe von 10 nm bis 1.000 nm von einer Oberfläche des anodischen Oxidfilms erstreckt, und einem Abschnitt mit großem Durchmesser, der mit einem Bodenabschnitt des Abschnitts mit kleinem Durchmesser in Kommunikation steht und sich zu einer Position in einer Tiefe von 20 nm bis 2.000 nm von einer Kommunikationsposition erstreckt, aufgebaut sind,
ein durchschnittlicher Durchmesser des Abschnitts mit kleinem Durchmesser innerhalb der Oberfläche des anodischen Oxidfilms 35 nm oder weniger beträgt, und
ein durchschnittlicher Durchmesser des Abschnitts mit großem Durchmesser 40 bis 300 nm beträgt.

**13.** Laminat nach einem der Ansprüche 5 bis 12,
wobei das Laminat aus mehreren der lithographischen Druckplattenvorläufer aufgebaut ist, die ohne Eingreifen von Zwischenpapier direkt gestapelt sind.

**14.** Verfahren des Herstellens einer Negativton-lithographischen Druckplatte, umfassend:

einen Schritt des Entnehmens des lithographischen Druckplattenvorläufers aus dem Laminat nach einem der Ansprüche 5 bis 13;
einen Schritt des Durchführens von Bildbelichtung auf dem lithographischen Druckplattenvorläufer; und
einen Schritt des Zuführens mindestens eines von einer Druckfarbe und Feuchtwasser,
um einen nicht belichteten Abschnitt der Bildaufzeichnungsschicht in dem lithographischen Druckplattenvorläufer zu entfernen.

## Revendications

**1.** Stratifié de précurseurs de plaques d'impression lithographiques à ton négatif, chacun comportant au moins une couche contenant un absorbeur infrarouge avec un HOMO de -5,47 eV ou moins sur un support hydrophile,
dans lequel dans chacun des précurseurs de plaques d'impression lithographiques à ton négatif, au moins l'une d'une surface de couche la plus externe sur un côté de l'au moins une couche contenant un absorbeur infrarouge par rapport au support ou d'une surface de couche la plus externe sur un côté opposé au côté de l'au moins une couche contenant un absorbeur infrarouge a une hauteur moyenne arithmétique Sa de 0,3 $\mu$m ou plus et 20 $\mu$m ou moins.

**2.** Stratifié selon la revendication 1,

dans lequel l'absorbeur infrarouge est un composé représenté par la Formule (1) suivante,

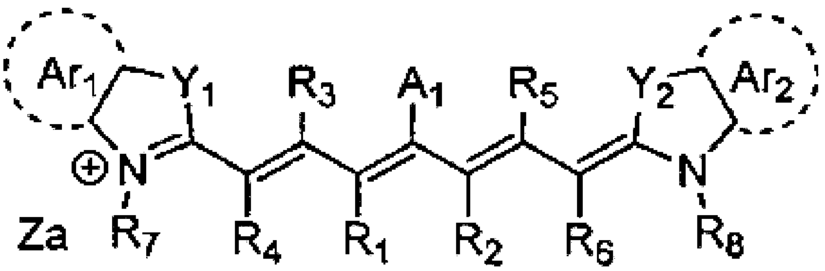

(1)

dans lequel $R_1$ et $R_2$ représentent chacun indépendamment un atome d'hydrogène ou un groupe alkyle, $R_1$ et $R_2$ peuvent être liés l'un à l'autre pour former un cycle, $R_3$ à $R_6$ représentent chacun indépendamment un atome d'hydrogène ou un groupe alkyle, $R_7$ et $R_8$ représentent chacun indépendamment un groupe alkyle ou un groupe aryle, $Y_1$ et $Y_2$ représentent chacun indépendamment un atome d'oxygène, un atome de soufre, $-NR_0-$ ou un groupe méthylène dialkyle, $R_0$ représente un atome d'hydrogène, un groupe alkyle ou un groupe aryle, $Ar_1$ et $Ar_2$ représentent chacun indépendamment un groupe formant un cycle benzénique ou un cycle naphtalène qui peut avoir un groupe représenté par la Formule 2 suivante, $A_1$ représente $-NR_9R_{10}$, $-X_1-X_{11}-L_1$ ou un groupe représenté par la Formule 2 suivante,

$R_9$ et $R_{10}$ représentent chacun indépendamment un groupe alkyle, un groupe aryle, un groupe alcoxycarbonyle, un groupe arylsulfonyle ou un groupe trihaloalkylsulfonyle, $X_1$ représente un atome d'oxygène ou un atome de soufre, $X_{11}$ représente une liaison simple ou un groupe alkylène, $L_1$ représente un groupe hydrocarboné, un groupe hétéroaryle ou un groupe qui subit une rupture de liaison à partir de $X_1$ par la chaleur ou l'exposition à l'infrarouge, Za représente un contre-ion qui neutralise la charge,

$-X$ Formule 2

X représente un atome d'halogène, $-C(=O)-X_2-R_{11}$, $-C(=O)-NR_{12}R_{13}$, $-O-C(=O)-R_{14}$,-CN, $-SO_2NR_{15}R_{16}$ ou un groupe perfluoroalkyle, $X_2$ représente une liaison simple ou un atome d'oxygène, $R_{11}$ représente un atome d'hydrogène, un groupe alkyle ou un groupe aryle, $R_{14}$ représente un groupe alkyle ou un groupe aryle, et $R_{12}$, $R_{13}$, $R_{15}$ et $R_{16}$ représentent chacun indépendamment un atome d'hydrogène, un groupe alkyle ou un groupe aryle.

**3.** Stratifié selon la revendication 2,

dans lequel dans Formule (1), $A_1$ est $-NR_{17}R_{18}$ ou $-S-X_{12}-R_{19}$,
$R_{17}$ et $R_{18}$ représentent chacun indépendamment un groupe aryle,
$R_{19}$ représente un groupe hydrocarboné ou un groupe hétéroaryle, et
$X_{12}$ représente une liaison simple ou un groupe alkylène.

**4.** Stratifié selon la revendication 2 ou la revendication 3,

dans lequel X dans Formule 2 est un atome de fluor, un atome de chlore, un atome de brome ou $-C(=O)OR_{20}$, et $R_{20}$ représente un atome d'hydrogène, un groupe alkyle ou un groupe aryle.

**5.** Stratifié selon l'une quelconque des revendications 1 à 4,

dans lequel chacun des précurseurs de plaques d'impression lithographiques comporte une couche d'enregistrement d'images,
l'au moins une couche contenant un absorbeur infrarouge est la couche d'enregistrement d'images, et
la couche d'enregistrement d'images contient un initiateur de polymérisation, un composé polymérisable et un composé polymère.

**6.** Stratifié selon la revendication 5,
dans lequel le composé polymère est un composé polymère contenant au moins l'une d'une unité constitutionnelle dérivée d'un composé de styrène ou d'une unité constitutionnelle dérivée d'un composé d'acrylonitrile.

**7.** Stratifié selon la revendication 5 ou la revendication 6,
dans lequel la couche d'enregistrement d'images contient au moins un type de particules ayant un diamètre moyen de

particules de 0,5 µm ou plus et 20 µm ou moins.

**8.** Stratifié selon l'une quelconque des revendications 5 à 7,
dans lequel chacun des précurseurs de plaques d'impression lithographiques comporte une couche protectrice sur la couche d'enregistrement d'images.

**9.** Stratifié selon la revendication 8,
dans lequel la couche protectrice contient au moins un type de particules ayant un diamètre moyen de particules de 0,5 µm ou plus et 20 µm ou moins.

**10.** Stratifié selon l'une quelconque des revendications 5 à 9,
dans lequel la couche la plus externe sur le côté opposé au côté de l'au moins une couche contenant un absorbeur infrarouge par rapport au support contient au moins un type de particules ayant un diamètre moyen de particules de 0,5 µm ou plus et 20 µm ou moins.

**11.** Stratifié selon l'une quelconque des revendications 5 à 10,

dans lequel le support est un support en aluminium comportant un film d'oxyde anodique,
des micropores dans le film d'oxyde anodique sont chacun composés d'une partie de grand diamètre qui s'étend jusqu'à une position à une profondeur de 10 nm à 1 000 nm à partir d'une surface du film d'oxyde anodique et d'une partie de petit diamètre qui est en communication avec une partie inférieure de la partie de grand diamètre et s'étend jusqu'à une position à une profondeur de 20 nm à 2 000 nm à partir d'une position de communication,
un diamètre moyen de la partie de grand diamètre à la surface du film d'oxyde anodique est de 15 nm à 100 nm, et
un diamètre moyen de la partie de petit diamètre à la position de communication est de 13 nm ou moins.

**12.** Stratifié selon l'une quelconque des revendications 5 à 10,

dans lequel le support est un support en aluminium comportant un film d'oxyde anodique,
des micropores dans le film d'oxyde anodique sont chacun composés d'une partie de petit diamètre qui s'étend jusqu'à une position à une profondeur de 10 nm à 1 000 nm à partir d'une surface du film d'oxyde anodique et d'une partie de grand diamètre qui est en communication avec une partie inférieure de la partie de petit diamètre et s'étend jusqu'à une position à une profondeur de 20 nm à 2 000 nm à partir d'une position de communication,
un diamètre moyen de la partie de petit diamètre à la surface du film d'oxyde anodique est de 35 nm ou moins, et
un diamètre moyen de la partie de grand diamètre est de 40 à 300 nm.

**13.** Stratifié selon l'une quelconque des revendications 5 à 12,
dans lequel le stratifié est composé d'une pluralité des précurseurs de plaques d'impression lithographiques empilés directement sans intervention de papier intercalaire.

**14.** Procédé de préparation d'une plaque d'impression lithographique à ton négatif, comprenant :

une étape consistant à retirer le précurseur de plaque d'impression lithographique du stratifié selon l'une quelconque des revendications 5 à 13 ;
une étape consistant à effectuer une exposition d'images sur le précurseur de plaque d'impression lithographique ; et
une étape consistant à fournir au moins l'une d'une encre d'impression ou de l'eau de mouillage pour éliminer une partie non exposée de la couche d'enregistrement d'images dans le précurseur de plaque d'impression lithographique.

FIG. 1

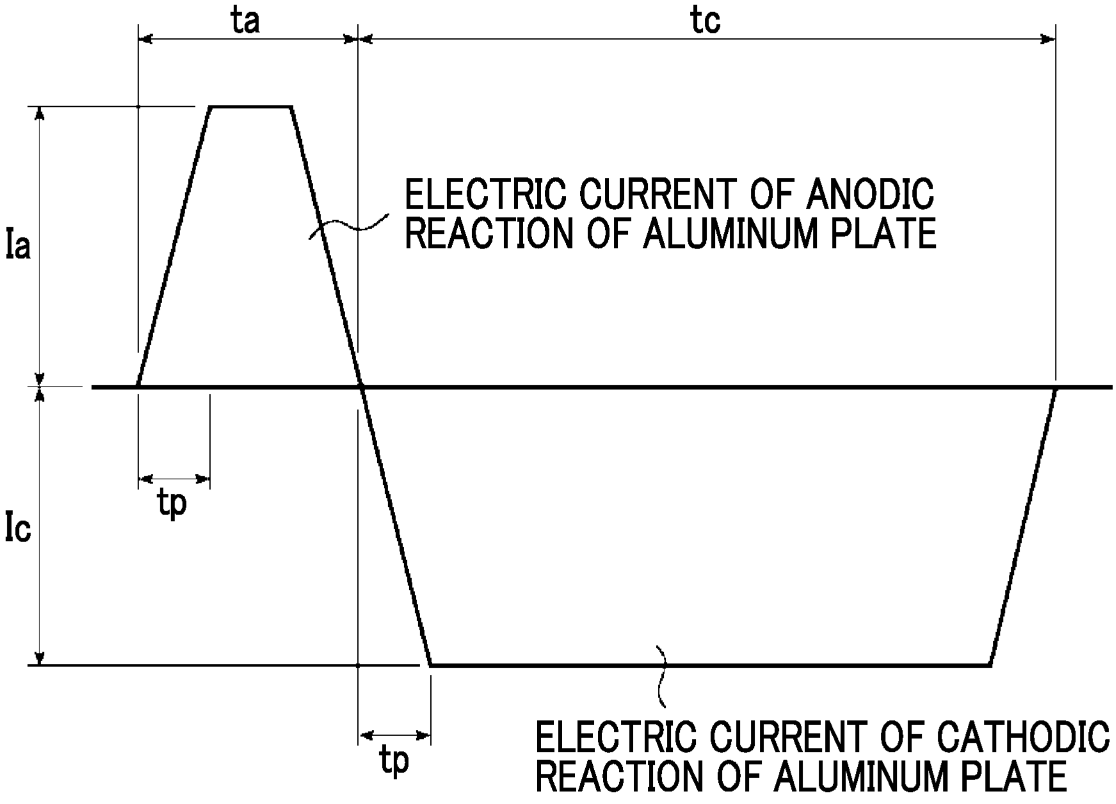
ta
tc
Ia
Ic
tp
tp
ELECTRIC CURRENT OF ANODIC REACTION OF ALUMINUM PLATE
ELECTRIC CURRENT OF CATHODIC REACTION OF ALUMINUM PLATE

FIG. 2

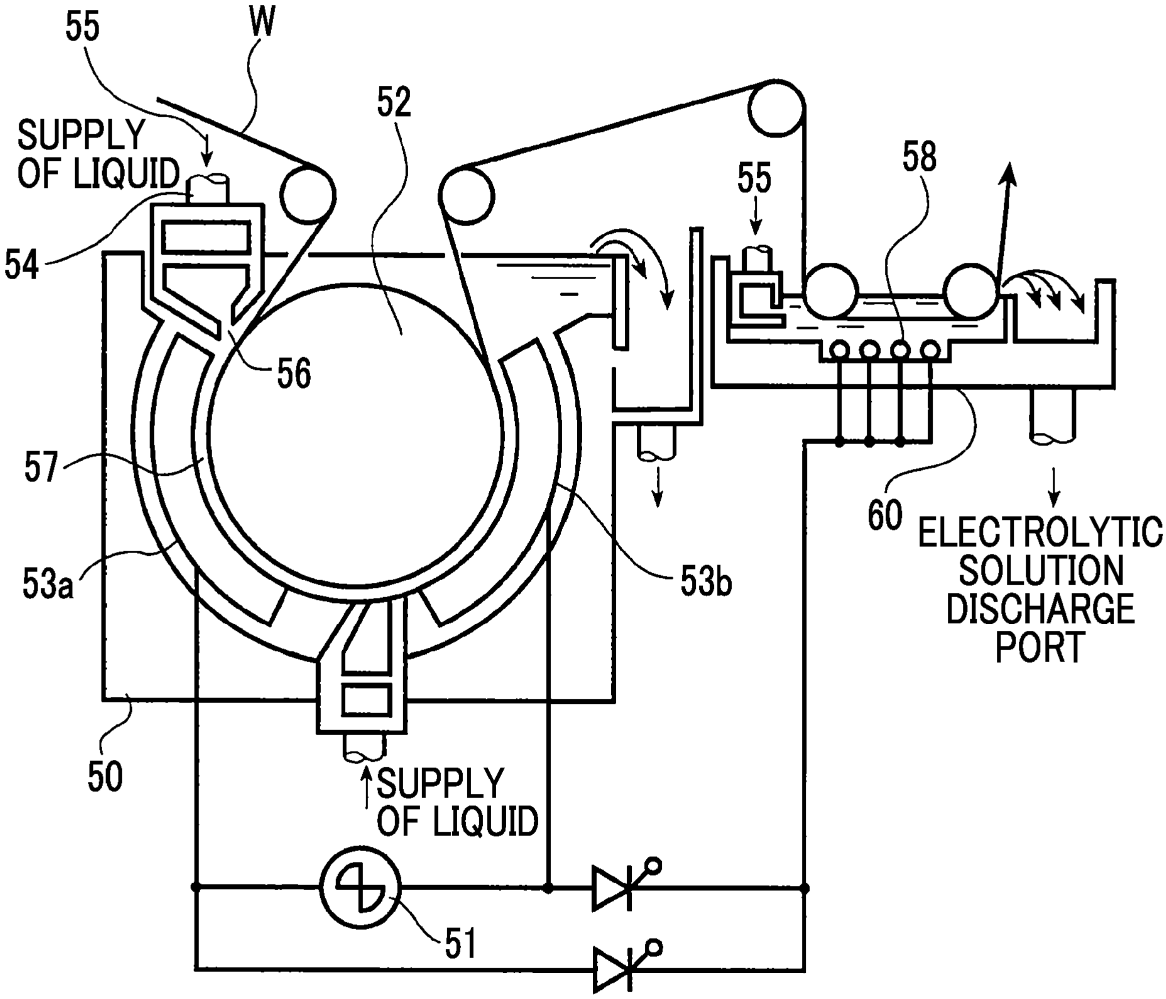
55
W
52
SUPPLY OF LIQUID
54
56
57
53a
53b
55
58
60
ELECTROLYTIC SOLUTION DISCHARGE PORT
50
SUPPLY OF LIQUID
51

FIG. 3

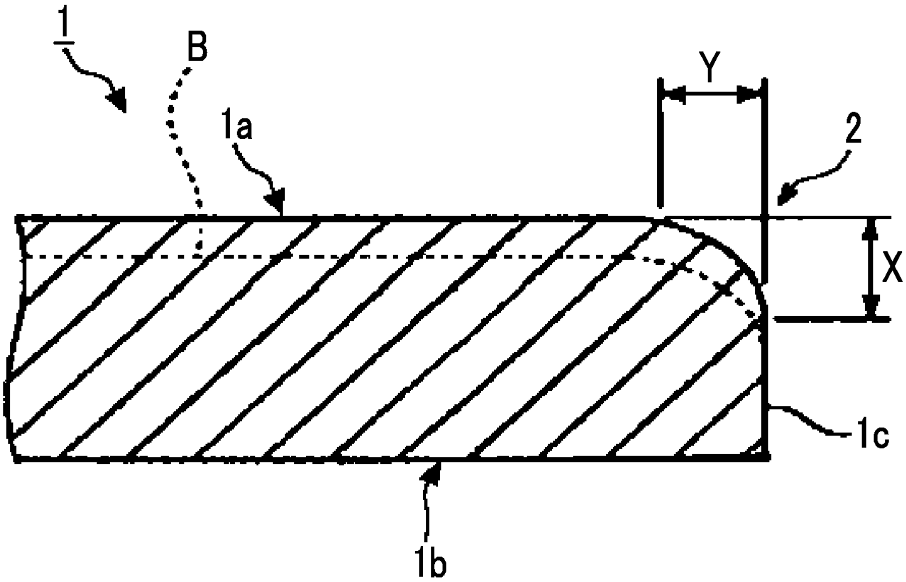
1
B
1a
Y
2
X
1c
1b

FIG. 4

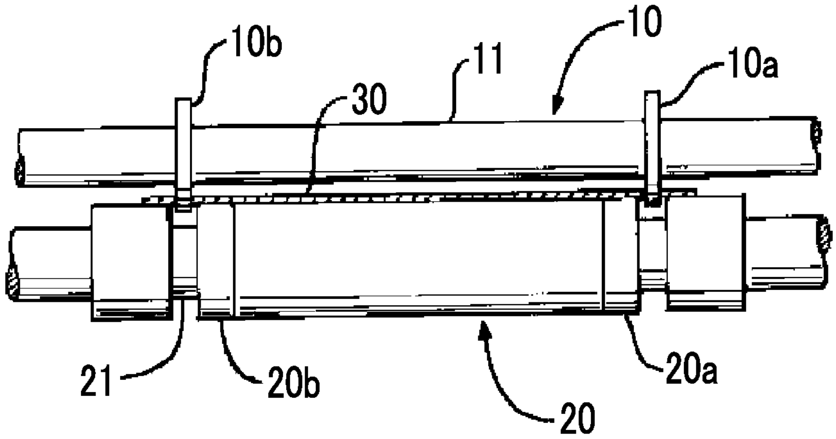


FIG. 5

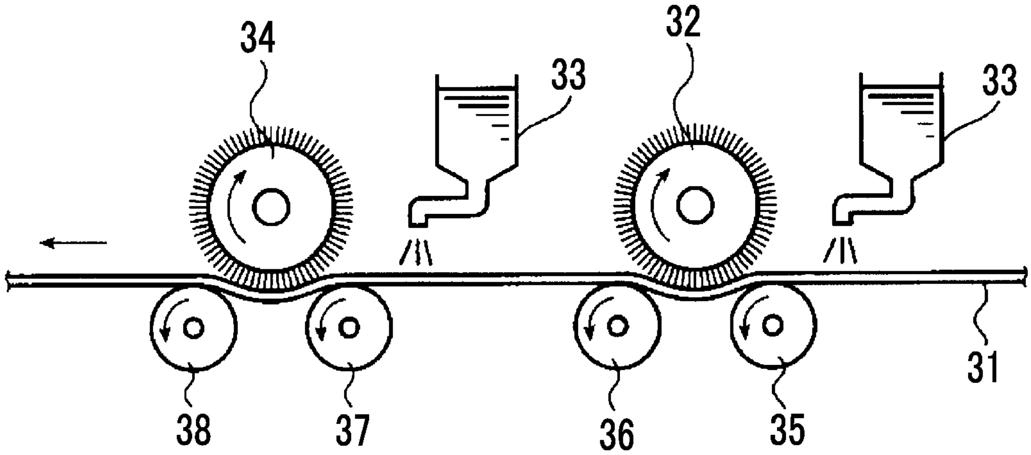

FIG. 6

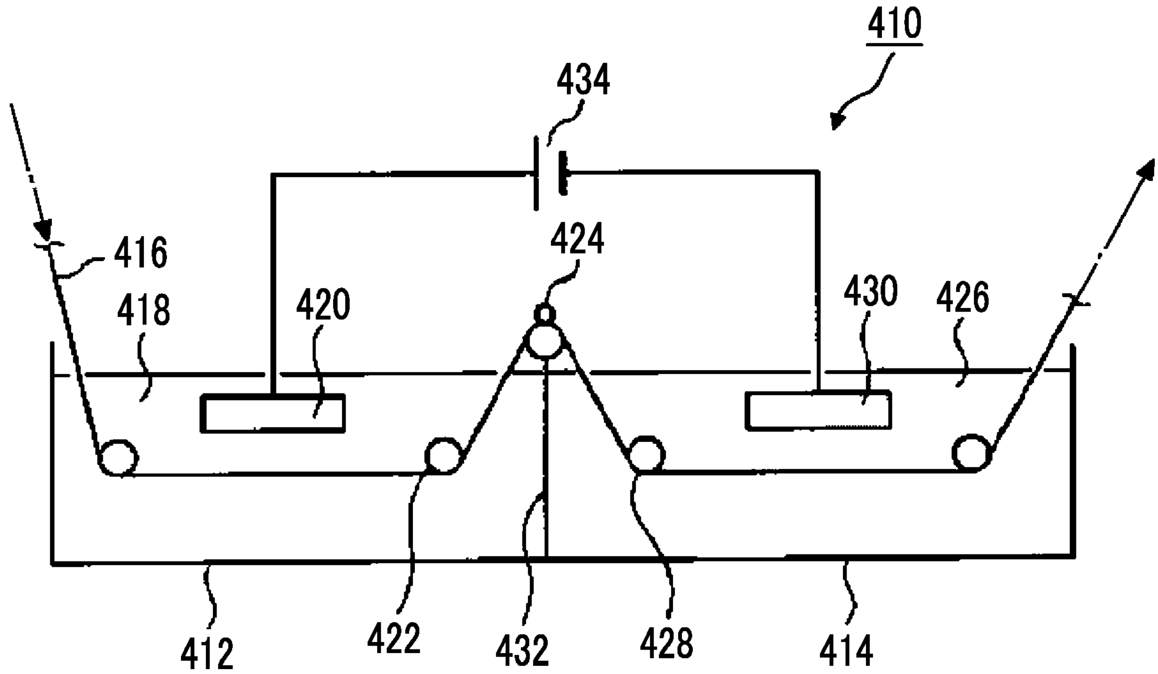
410
434
424
416
418
420
430
426
412
422
432
428
414

FIG. 7

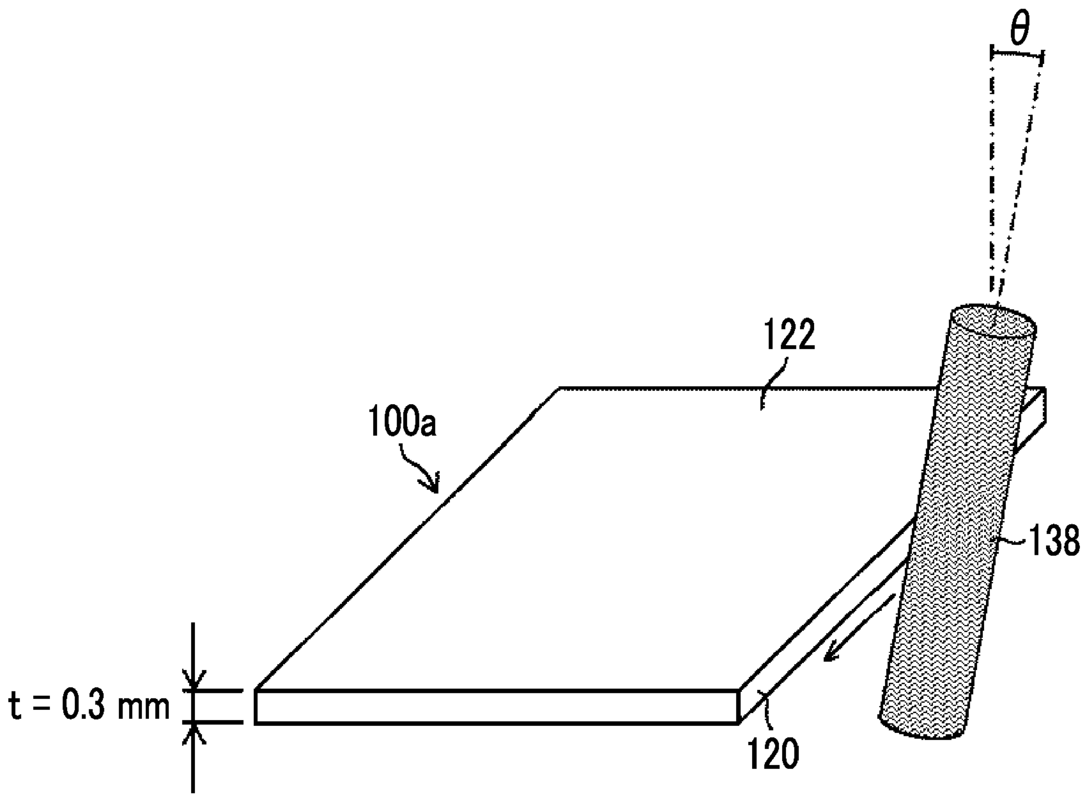
θ
122
100a
138
t = 0.3 mm
120

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2019013268 A
- WO 2018181406 A
- WO 2018181993 A
- JP 5045885 A
- JP H545885 A
- JP 6035174 A
- JP H635174 A
- JP 50040047 B
- GB 1412768 A
- JP 2005254638 A
- US 2714066 A
- US 3181461 A
- WO 2016027886 A
- JP 2002327036 A
- JP 2002173410 A
- JP 2004307837 A
- JP 2006038246 A
- JP 2005250216 A
- JP 2006259137 A
- JP 2008195018 A
- JP 8108621 A
- JP H08108621 A
- JP 61166544 A
- JP 2002328465 A
- JP 2006508380 A
- JP 2002287344 A
- JP 2008256850 A
- JP 2001342222 A
- JP 9179296 A
- JP H09179296 A
- JP 9179297 A
- JP H09179297 A
- JP 9179298 A
- JP H09179298 A
- JP 2004294935 A
- JP 2006243493 A
- JP 2002275129 A
- JP 2003064130 A
- JP 2003280187 A
- JP 10333321 A
- JP H10333321 A
- JP 48041708 B
- JP 51037193 A
- JP 2032293 B
- JP H0232293 B
- JP 2016765 B
- JP H0216765 B
- JP 2003344997 A
- JP 2006065210 A
- JP 58049860 B
- JP 56017654 B
- JP 62039417 B
- JP 62039418 B
- JP 2000250211 A
- JP 2007094138 A
- US 7153632 B
- JP 8505958 A
- JP H08505958 A
- JP 2007293221 A
- JP 2007293223 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2001133969 A
- JP 2002023360 A
- JP 2002040638 A
- JP 2002278057 A
- JP 2007090850 A
- JP 5005005 A
- JP H055005 A
- JP 2001222101 A
- JP 2007276454 A
- JP 2009154525 A
- JP 2006297907 A
- JP 2007050660 A
- JP 2008284858 A
- JP 2009090645 A
- JP 2009208458 A
- JP 2008284817 A
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- US 3458311 A

- JP 55049729 B
- JP 2014010463 A
- JP 20141046312 A
- US 4253999 A
- US 4268613 A
- US 4348954 A
- JP 6628949 B
- WO 2019045084 A

**Non-patent literature cited in the description**

- *Dye Handbooks*, 1970
- *Ultrafine particles and materials*, 1993
- **HARUMA KAWAGUCHI**. Preparation and application of fine particles/powders. CMC Publishing CO., 2005
- *Research Disclosure*, January 1992 (33303)